# EUROPEAN PATENT SPECIFICATION

(11) **EP 4 509 513 B1**
(45) Date of publication and mention of the grant of the patent: **18.03.2026**
(21) Application number: 24187448.6
(22) Date of filing: 09.07.2024
(51) Int. Cl.: C07F 5/02, C09K 11/06, C07B 59/00, H10K 85/60, H10K 85/30

(54) **LIGHT-EMITTING ELEMENT, POLYCYCLIC COMPOUND FOR THE SAME, AND DISPLAY DEVICE INCLUDING THE LIGHT-EMITTING ELEMENT**
LICHTEMITTIERENDES ELEMENT, POLYCYCLISCHE VERBINDUNG DAFÜR UND ANZEIGEVORRICHTUNG MIT DEM LICHTEMITTIERENDEN ELEMENT
ÉLÉMENT ÉLECTROLUMINESCENT, COMPOSÉ POLYCYCLIQUE POUR CELUI-CI ET DISPOSITIF D'AFFICHAGE COMPRENANT L'ÉLÉMENT ÉLECTROLUMINESCENT

(30) Priority: 19.07.2023 KR 20230093700
(43) Date of publication of application: 19.02.2025
(73) Proprietor: Samsung Display Co., Ltd, Yongin-si, Gyeonggi-do (KR)
(72) Inventor: PAK, Sun Young, Yongin-si (KR); MIYASHITA, Hirokazu, Yongin-si (KR); KIM, Taeil, Yongin-si (KR); SUNG, MinJae, Yongin-si (KR); SIM, Mun-Ki, Yongin-si (KR); JUNG, Minjung, Yongin-si (KR); HUR, Seonhyoung, Yongin-si (KR)
(74) Representative: Marks & Clerk LLP

(56) References cited:
- EP-A1- 4 152 912

## Description

### BACKGROUND

### 1. Field

The present disclosure herein relates to a light-emitting element, a polycyclic compound utilized for the same, and a display device including the light-emitting element.

### 2. Description of the Related Art

Recently, the development of an organic electroluminescence display device, as an image display device, is being actively conducted. The organic electroluminescence display device and/or the like is a display device including a so-called "self-luminescent" type or kind of light-emitting element, in which, holes and electrons, respectively, injected from a first electrode and a second electrode, are combined in an emission layer of the display device. Subsequently, a light-emitting material of the emission layer (e.g., light emitting layer) emits light to achieve (e.g., implement) display (e.g., of an image).

Implementation of a light-emitting element to a display device requires, (or there is a desire for), improvements in luminous efficiency, lifespan, and/or the like. Therefore, the need or desire exists for the development of materials for the light-emitting element capable of stably achieving such characteristics or desires, and such development is being continuously pursued.

Two example areas of research being conducted or pursued to achieve a highly efficient light-emitting element include the development of phosphorescent luminescence, utilizing triplet state energy, and delayed fluorescent luminescence, utilizing triplet-triplet annihilation (TTA) (e.g., where a singlet exciton is generated due to triplet exciton collision). Another example area of research is the development of materials for thermally activated delayed fluorescence (TADF) utilizing a delayed fluorescence phenomenon. EP 4152912 A1 relates to an organic electroluminescence device and fused polycyclic compounds therefor.

### SUMMARY

One or more aspects of embodiments of the present disclosure are directed toward a light-emitting element with improved luminous efficiency and/or improved lifespan.

One or more aspects of embodiments of the present disclosure are directed toward a polycyclic compound with improved material lifespan.

One or more aspects of embodiments of the present disclosure are directed toward a display device with excellent or suitable display quality and that includes the light-emitting element having improved luminous efficiency and/or lifespan. Additional aspects will be set forth in part in the description which follows and, in part, will be apparent from the description, or may be learned by practice of the presented embodiments of the disclosure.

One or more embodiments of the present disclosure provides a polycyclic compound represented by Formula 1.

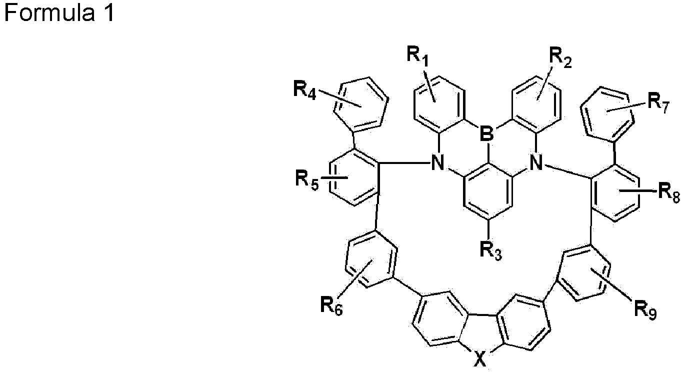

In Formula 1, X is O, S, Se, NRₐ, or CR_{b}R_{c}, and R₁ to R₉ are each independently a hydrogen atom, a deuterium atom, a halogen atom, a cyano group, a substituted or unsubstituted alkyl group having 1 to 10 carbon atoms, a substituted or unsubstituted alkenyl group having 2 to 10 carbon atoms, a substituted or unsubstituted oxy group, a substituted or unsubstituted thio group, a substituted or unsubstituted aryl group having 6 to 30 ring-forming carbon atoms, or a substituted or unsubstituted heteroaryl group having 3 to 30 ring-forming carbon atoms, and/or bonded to an adjacent group to form a ring. Rₐ to R_{c} are each independently a hydrogen atom, a deuterium atom, a halogen atom, a substituted or unsubstituted alkyl group having 1 to 10 carbon atoms, a substituted or unsubstituted alkenyl group having 2 to 10 carbon atoms, a substituted or unsubstituted oxy group, a substituted or unsubstituted thio group, a substituted or unsubstituted aryl group having 6 to 30 ring-forming carbon atoms, or a substituted or unsubstituted heteroaryl group having 3 to 30 ring-forming carbon atoms.

In one or more embodiments, at least one of R₁ or R₂ in Formula 1 may be a substituted or unsubstituted aryl group having 6 to 30 ring-forming carbon atoms, or a substituted or unsubstituted heteroaryl group having 3 to 30 ring-forming carbon atoms.

In one or more embodiments, R₁ and R₂ in Formula 1 may each independently be a substituted or unsubstituted aryl group having 6 to 20 ring-forming carbon atoms, or a substituted or unsubstituted heteroaryl group having 6 to 30 ring-forming carbon atoms.

In one or more embodiments, at least one among the hydrogen atoms of the polycyclic compound, represented by Formula 1, may be substituted with a deuterium atom.

In one or more embodiments, R₃ in Formula 1 may be a hydrogen atom, a substituted or unsubstituted alkyl group having 1 to 10 carbon atoms, a substituted or unsubstituted aryl group having 6 to 20 ring-forming carbon atoms, or a substituted or unsubstituted heteroaryl group having 6 to 30 ring-forming carbon atoms.

In one or more embodiments, Formula 1 may be represented by any one selected from among Formula 1-1 to Formula 1-4.

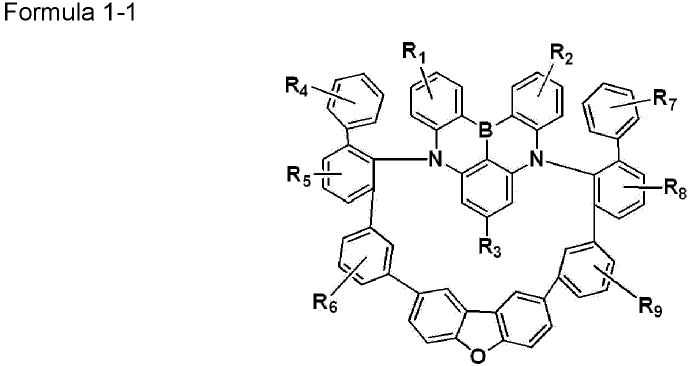

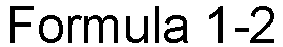

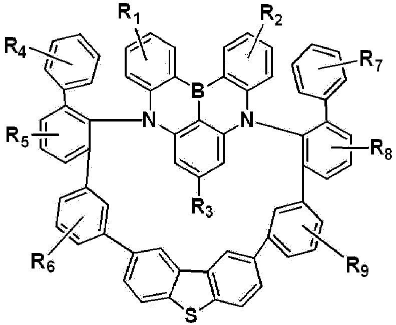

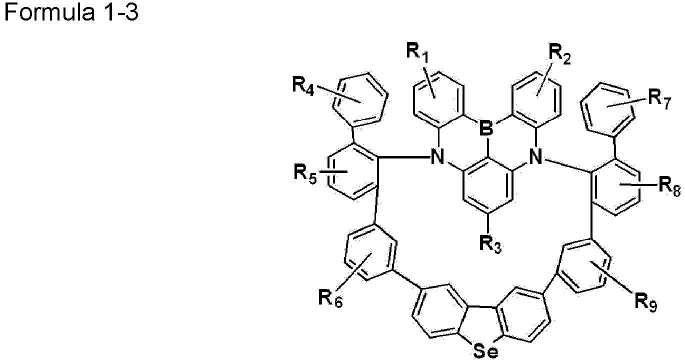

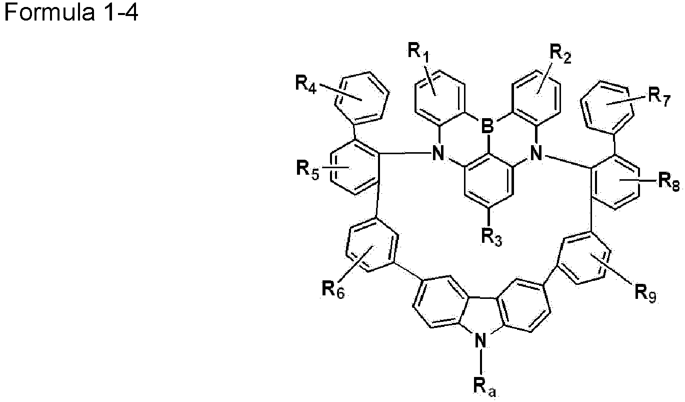

In Formula 1-1 to Formula 1-4, R₁ to R₉, and Rₐ are as defined in Formula 1.

In one or more embodiments, the polycyclic compound represented by Formula 1 may be a delayed fluorescent dopant.

In one or more embodiments of the present disclosure, a light-emitting element includes a first electrode, a second electrode provided on the first electrode, and an emission layer provided between the first electrode and the second electrode, and including (e.g., containing) the aforementioned polycyclic compound according to one or more embodiments.

In one or more embodiments, the emission layer may further include at least one selected from among a second compound represented by Formula HT-1, or a third compound represented by Formula ET-1.

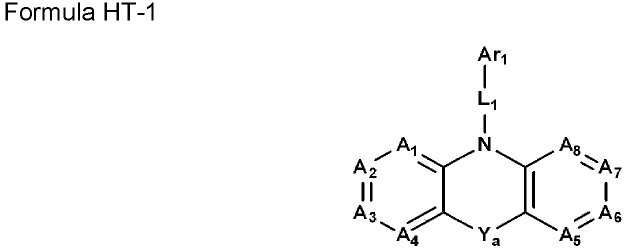

In Formula HT-1, A₁ to A₈ are each independently N or CR₅₁, and L₁ is a direct linkage, a substituted or unsubstituted arylene group having 6 to 30 ring-forming carbon atoms, or a substituted or unsubstituted heteroarylene group having 2 to 30 ring-forming carbon atoms, and Yₐ is a direct linkage, CR₅₂R₅₃, or SiR₅₄R₅₅. Ar₁ is a substituted or unsubstituted aryl group having 6 to 30 ring-forming carbon atoms, or substituted or unsubstituted heteroaryl group having 2 to 30 ring-forming carbon atoms, and R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, or bonded to an adjacent group to form a ring.

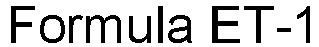

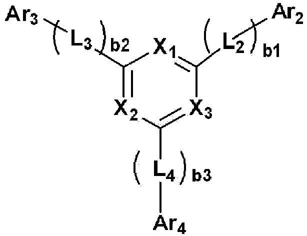

In Formula ET-1, X₁ to X₃ are each independently N or CR₅₆, and at least one selected from among X₁ to X₃ is N, (e.g., at least one selected from among X₁ to X₃ is N, and the rest (i.e., any remaining X₁ to X₃) are CR₅₆). R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, and b1 to b3 are each independently an integer of 0 to 10. Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms.

In one or more embodiments, the emission layer may further include a fourth compound represented by Formula D-1.

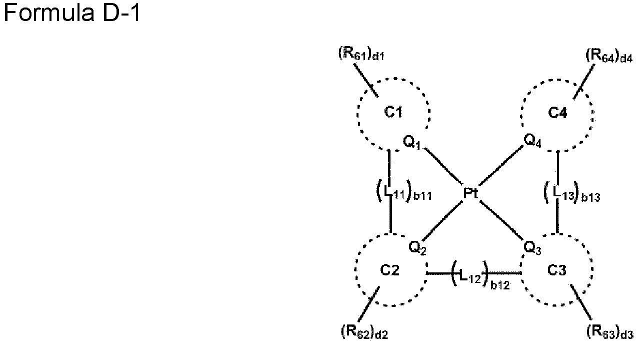

In Formula D-1, Q₁ to Q₄ are each independently C or N, C1 to C4 are each independently a substituted or unsubstituted hydrocarbon ring having 5 to 30 ring-forming carbon atoms, or a substituted or unsubstituted hetero ring having 2 to 30 ring-forming carbon atoms, and L₁₁ to L₁₃ are each independently a direct linkage, 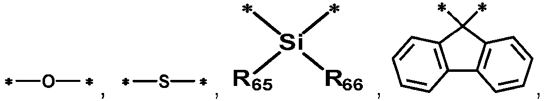 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. b11 to b13 are each independently 0 or 1, R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, and d1 to d4 are each independently an integer of 0 to 4.

In one or more embodiments, the emission layer may include the polycyclic compound(i.e.,the first compound), the second compound, the third compound, and the fourth compound.

In one or more embodiments, the emission layer may be to emit (e.g., configured to emit) delayed fluorescence.

In one or more embodiments, the emission layer may be to emit (e.g., configured to emit) blue color light.

In one or more embodiments of the present disclosure, a display device includes a base layer, a circuit layer provided on the base layer, and a display element layer provided on the circuit layer and including a light emitting element. In one or more embodiments, the light-emitting element includes a first electrode, a second electrode facing the first electrode, and an emission layer provided between the first electrode and the second electrode, and including (e.g., having) the aforementioned polycyclic compound according to one or more embodiments.

In one or more embodiments, the light-emitting element may be to emit (e.g., configured to emit) blue color light.

In one or more embodiments, the display device may further include a light control layer having a quantum dot.

At least some of the above and other features of the invention are set out in the claims.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1 is a plan view of a display device according to one or more embodiments;
FIG. 2 is a cross-sectional view illustrating a portion taken along line I-I' of FIG. 1;
FIG. 3 is a cross-sectional view schematically illustrating a light-emitting element according to one or more embodiments of the present disclosure;
FIG. 4 is a cross-sectional view schematically illustrating a light-emitting element according to one or more embodiments of the present disclosure;
FIG. 5 is a cross-sectional view schematically illustrating a light-emitting element according to one or more embodiments of the present disclosure;
FIG. 6 is a cross-sectional view schematically illustrating a light-emitting element according to one or more embodiments of the present disclosure;
FIG. 7 is a cross-sectional view schematically illustrating a light-emitting element according to one or more embodiments of the present disclosure;
FIGS. 8A and 8B are each an image showing a 3D structure of a polycyclic compound according to one or more embodiments of the present disclosure;
FIG. 9 is a cross-sectional view of a display device according to one or more embodiments of the present disclosure;
FIG. 10 is a cross-sectional view of a display device according to one or more embodiments of the present disclosure;
FIG. 11 is a cross-sectional view of a display device according to one or more embodiments of the present disclosure;
FIG. 12 is a cross-sectional view of a display device according to one or more embodiments of the present disclosure; and
FIG. 13 is a diagram showing the inside of a vehicle in which a display device, according to one or more embodiments of the present disclosure, is provided.

### DETAILED DESCRIPTION

The present disclosure may be modified in one or more suitable manners and have many forms, and thus specific embodiments will be exemplified in the drawings and described in more detail in the detailed description of the present disclosure. It should be understood, however, that it is not intended to limit the present disclosure to the particular forms disclosed.

When explaining each of the drawings, like reference numbers are utilized for referring to like elements, and duplicative descriptions thereof may not be provided. In the accompanying drawings, the dimensions of each structure are exaggeratingly illustrated for clarity of the present disclosure.

It will be understood that, although the terms "first," "second," and/or the like, may be utilized herein to describe one or more suitable components, these components should not be limited by these terms. These terms are only utilized to distinguish one component from another. For example, a first component could be termed a second component, and, similarly, a second component could be termed a first component, without departing from the scope of example embodiments of the present disclosure. As utilized herein, the singular forms, "a," "an," and "the" are intended to include the plural forms as well, unless the context clearly indicates otherwise.

In the present application, it will be understood that the terms "include," "includes," "including," "comprise," "comprises", "comprising," "has," "having," and/or "have," and/or the like specify the presence of features, numbers, steps, operations, component, parts, or combinations thereof disclosed in the specification, but do not exclude the possibility of presence or addition of one or more other features, numbers, steps, operations, component, parts, or combinations thereof.

As utilized herein, the terms "use," "using," and "used" may be considered synonymous with the terms "utilize," "utilizing," and "utilized," respectively.

As utilized herein, expressions such as "at least one of," "one of," "selected from," and "selected from among," when preceding a list of elements, modify the entire list of elements and do not modify the individual elements of the list. For example, the expressions "at least one of a to c," "at least one of a, b or c," and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof.

The term "and/or" includes all combinations of one or more of the associated listed elements.

In the present application, when a layer, a film, a region, or a plate is referred to as being "on" or "in an upper portion of" another layer, film, region, or plate, it may be not only "directly on" the layer, film, region, or plate, but intervening layers, films, regions, or plates may also be present. On the contrary to this, when a layer, a film, a region, or a plate is referred to as being "in a lower portion of" another layer, film, region, or plate, it can be not only directly under the layer, film, region, or plate, but intervening layers, films, regions, or plates may also be present. In some embodiments, it will be understood that when a part is referred to as being "on" another part, it can be provided above the other part, or provided under the other part as well.

The terms, such as "lower", "above", "upper" and/or the like, are utilized herein for ease of description to describe one element's relation to another element(s) as illustrated in the drawings. The terms are relative concepts and are described based on the directions indicated in the drawings. It will be understood that the terms have a relative concept and are described on the basis of the orientation depicted in the drawings. It will be understood that the spatially relative terms are intended to encompass different orientations of the device in use or operation in addition to the orientation depicted in the drawings. For example, if the device in the drawings is turned over, elements described as "beneath" other elements or features would then be oriented "above" or "over" the other elements or features. Thus, the term "beneath" may encompass both an orientation of above and below. The device may be otherwise oriented (rotated 90 degrees or at other orientations), and the spatially relative descriptors used herein should be interpreted accordingly.

As utilized herein, the term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

Unless otherwise defined, all terms (including chemical, technical and scientific terms) utilized herein have the same meaning as commonly understood by one of ordinary skill in the art to which this present disclosure belongs. It will be further understood that terms, such as those defined in commonly utilized dictionaries, should be interpreted as having a meaning that is consistent with their meaning in the context of the relevant art and will not be interpreted in an idealized or overly formal sense unless expressly so defined herein.

As utilized herein, the phrase "consisting essentially of" means that any additional components will not materially affect the chemical, physical, optical, or electrical properties of the semiconductor film.

As utilized herein, the phrase "on a plane," or "plan view," refers to viewing a target portion from the top, and the phrase "on a cross-section" means viewing a cross-section formed by vertically cutting a target portion from the side.

In present disclosure, "not include a or any 'component'" "exclude a or any 'component'", "'component'-free", and/or the like refers to that the "component" not being added, selected or utilized as a component in the composition/structure, but the "component" of less than a suitable amount may still be included due to other impurities and/or external factor.

### Definitions

In the specification, the term "substituted or unsubstituted" may refer to substituted or unsubstituted with at least one substituent selected from the group consisting of a deuterium atom, a halogen atom, a cyano group, a nitro group, an amino group(an amine group), a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In some embodiments, each of the substituents exemplified herein may be substituted or unsubstituted. For example, a biphenyl group may be interpreted as an aryl group or a phenyl group substituted with a phenyl group.

In the specification, the phrase "bonded to an adjacent group to form a ring" may refer to that a group is bonded to an adjacent group to form a substituted or unsubstituted hydrocarbon ring, or a substituted or unsubstituted heterocycle. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be monocyclic or polycyclic. In some embodiments, the rings formed by being bonded to each other may be connected to another ring to form a spiro structure.

In the specification, the term "adjacent group" may refer to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as "adjacent groups" to each other and two ethyl groups in 1,1-diethylcyclopentane may be interpreted as "adjacent groups" to each other. In some embodiments, two methyl groups in 4,5-dimethylphenanthrene may be interpreted as "adjacent groups" to each other.

In the specification, examples of the halogen atom may include a fluorine atom, a chlorine atom, a bromine atom, or an iodine atom.

In the specification, the alkyl group may be linear or branched. The number of carbons in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, and/or the like.

In the specification, a cycloalkyl group may refer to a cyclic alkyl group. The number of carbons in the cycloalkyl group may be 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, and/or the like.

In the specification, an alkenyl group refers to a hydrocarbon group including at least one carbon double bond in the middle or terminal of an alkyl group having 2 or more carbon atoms. The alkenyl group may be linear or branched. The number of carbon atoms in the alkenyl group is not specifically limited, but may be 2 to 30, 2 to 20, or 2 to 10. Examples of the alkenyl group include a vinyl group, a 1-butenyl group, a 1-pentenyl group, a 1,3-butadienyl group, a styrenyl group, a styryl vinyl group, and/or the like.

In the specification, an alkynyl group refers to a hydrocarbon group including at least one carbon triple bond in the middle or terminal of an alkyl group having 2 or more carbon atoms. The alkynyl group may be linear or branched. Although the number of carbon atoms is not specifically limited, it may be 2 to 30, 2 to 20, or 2 to 10. Specific examples of the alkynyl group may include an ethynyl group, a propynyl group, and/or the like.

In the specification, the hydrocarbon ring group refers to any functional group or substituent derived from an aliphatic hydrocarbon ring. The hydrocarbon ring group may be a saturated hydrocarbon ring group having 5 to 20 ring-forming carbon atoms.

In the specification, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 36, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like.

In the specification, the fluorenyl group may be substituted, and two substituents may be bonded to each other to form a spiro structure. Examples of the substituted fluorenyl group are as follows.

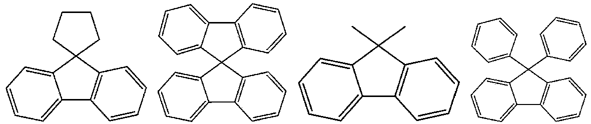

The heterocyclic group herein refers to any functional group or substituent derived from a ring containing at least one of B, O, N, P, Si, or Se as a heteroatom. The heterocyclic group includes an aliphatic heterocyclic group and an aromatic heterocyclic group. The aromatic heterocyclic group may be a heteroaryl group. The aliphatic heterocycle and the aromatic heterocycle may be monocyclic or polycyclic.

In the specification, the heterocyclic group may contain at least one of B, O, N, P, Si or S as a heteroatom. When the heterocyclic group contains two or more heteroatoms, the two or more heteroatoms may be the same as or different from each other. The heterocyclic group may be a monocyclic heterocyclic group or a polycyclic heterocyclic group, and includes a heteroaryl group. The number of ring-forming carbon atoms in the heterocyclic group may be 2 to 30, 2 to 20, or 2 to 10.

In the specification, the aliphatic heterocyclic group may include at least one of B, O, N, P, Si, or S as a heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like.

In the specification, the heteroaryl group may contain at least one of B, O, N, P, Si, or S as a heteroatom. When the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like.

In the specification, the preceding description of the aryl group may be applied to an arylene group except that the arylene group is a divalent group. The preceding description of the heteroaryl group may be applied to a heteroarylene group except that the heteroarylene group is a divalent group.

In the specification, the silyl group includes an alkylsilyl group and an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like.

In the specification, the number of ring-forming carbon atoms in the carbonyl group is not specifically limited, but may be 1 to 40, 1 to 30, or 1 to 20. For example, the carbonyl group may have the following structures.

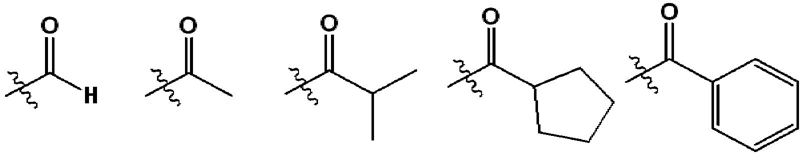

In the specification, the number of carbon atoms in the sulfinyl group and the sulfonyl group is not particularly limited, but may be 1 to 30. The sulfinyl group may include an alkyl sulfinyl group and an aryl sulfinyl group. The sulfonyl group may include an alkyl sulfonyl group and an aryl sulfonyl group.

In the specification, the thio group may include an alkylthio group and an arylthio group. The thio group may refer to that a sulfur atom is bonded to the alkyl group or the aryl group as defined herein. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group.

In the specification, an oxy group may refer to that an oxygen atom is bonded to the alkyl group or the aryl group as defined herein. The oxy group may include an alkoxy group and an aryl oxy group. The alkoxy group may be a linear chain, a branched chain or a ring chain. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, and/or the like.

The boron group herein may refer to that a boron atom is bonded to the alkyl group or the aryl group as defined herein. The boron group includes an alkyl boron group and an aryl boron group. Examples of the boron group may include a dimethylboron group, a trimethylboron group, a t-butyldimethylboron group, a diphenylboron group, a phenylboron group, and/or the like.

In the specification, the number of carbon atoms in an amine group is not specifically limited, but may be 1 to 30. The amine group may include an alkyl amine group and an aryl amine group. Examples of the amine group may include a methylamine group, a dimethylamine group, a phenylamine group, a diphenylamine group, a naphthylamine group, a 9-methyl-anthracenylamine group, and/or the like.

In the specification, the alkyl group among an alkylthio group, an alkylsulfoxy group, an alkylaryl group, an alkylamino group, an alkyl boron group, an alkyl silyl group, and an alkyl amine group is the same as the examples of the alkyl group described herein.

In the specification, the aryl group among an aryloxy group, an arylthio group, an arylsulfoxy group, an arylamino group, an arylboron group, an arylsilyl group, an arylamine group is the same as the examples of the aryl group described herein.

In the specification, the phosphine oxide group may be substituted with, for example, at least one of the alkyl groups or aryl groups described above.

In the specification, the phosphine sulfide group may be substituted with, for example, at least one of the alkyl groups or aryl groups described above.

In the specification, a direct linkage may refer to a single bond.

In some embodiments, in the specification, " 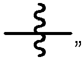 and "-* "refer to a position to be connected.

Hereinafter, embodiments of the present disclosure will be described with reference to the accompanying drawings.

### Display Device

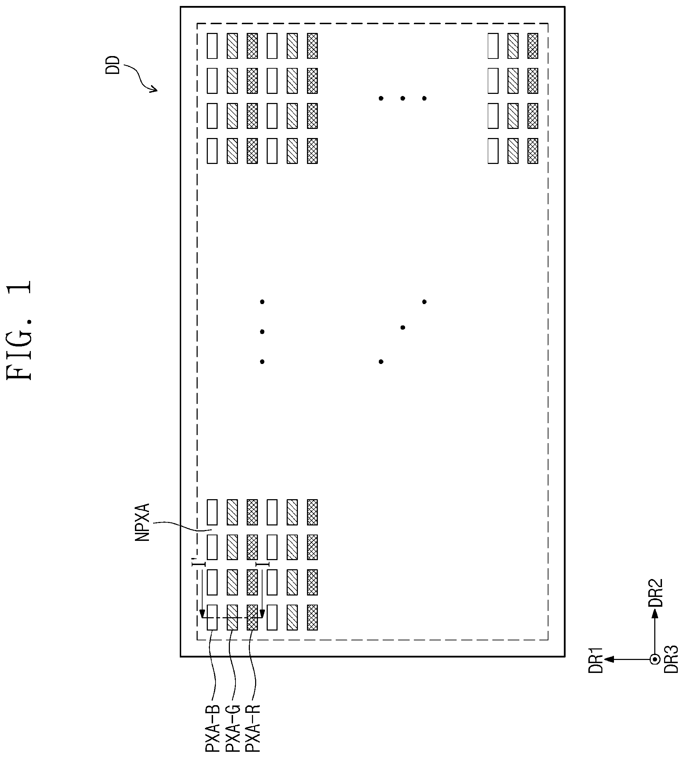

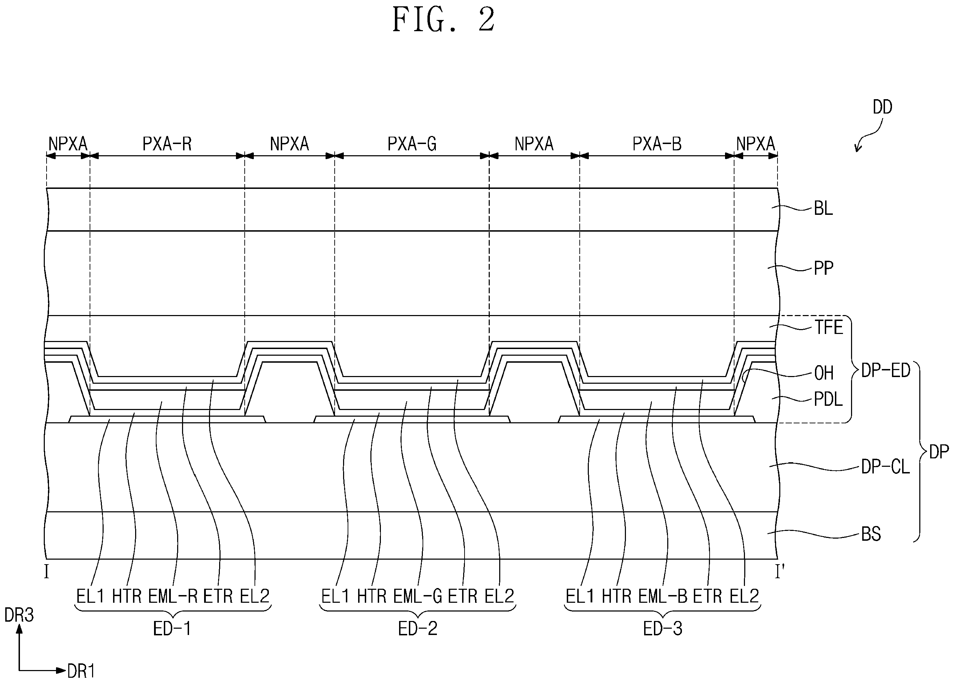

FIG. 1 is a plan view illustrating one or more embodiments of a display device DD. FIG. 2 is a cross-sectional view of the display device DD of the embodiment. FIG. 2 is a cross-sectional view illustrating a part taken along line I-I' of FIG. 1.

The display device DD may include a display panel DP and an optical layer PP provided on the display panel DP. The display panel DP includes light emitting elements ED-1, ED-2, and ED-3. The display device DD may include a plurality of light emitting elements ED-1, ED-2, and ED-3. The optical layer PP may be provided on the display panel DP to control reflected light in the display panel DP due to external light. The optical layer PP may include, for example, a polarization layer or a color filter layer. In some embodiments, unlike the configuration illustrated in the drawing, the optical layer PP may not be provided from the display device DD of one or more embodiments.

A base substrate BL may be provided on the optical layer PP. The base substrate BL may be a member which provides a base surface on which the optical layer PP provided. The base substrate BL may be a glass substrate, a metal substrate, a plastic substrate, and/or the like. The base substrate BL may be an inorganic layer, an organic layer, or a composite material layer. In some embodiments, unlike the configuration illustrated, in one or more embodiments, the base substrate BL may not be provided.

The display device DD according to one or more embodiments may further include a filling layer. The filling layer may be provided between a display element layer DP-ED and the base substrate BL. The filling layer may be an organic material layer. The filling layer may include at least one of an acrylic-based resin, a silicone-based resin, or an epoxy-based resin (e.g., at least one selected from among an acrylic-based resin, a silicone-based resin, and an epoxy-based resin).

The display panel DP may include a base layer BS, a circuit layer DP-CL provided on the base layer BS, and the display element layer DP-ED. The display element layer DP-ED may include a pixel defining layer PDL, the light emitting elements ED-1, ED-2, and ED-3 provided between portions of the pixel defining layer PDL, and an encapsulation layer TFE provided on the light emitting elements ED-1, ED-2, and ED-3.

The base layer BS may be a member which provides a base surface on which the display element layer DP-ED is provided. The base layer BS may be a glass substrate, a metal substrate, a plastic substrate, and/or the like. The base layer BS may be an inorganic layer, an organic layer, or a composite material layer.

In one or more embodiments, the circuit layer DP-CL is provided on the base layer BS, and the circuit layer DP-CL may include a plurality of transistors. Each of the transistors may include a control electrode, an input electrode, and an output electrode. For example, the circuit layer DP-CL may include a switching transistor and a driving transistor for driving the light emitting elements ED-1, ED-2, and ED-3 of the display element layer DP-ED.

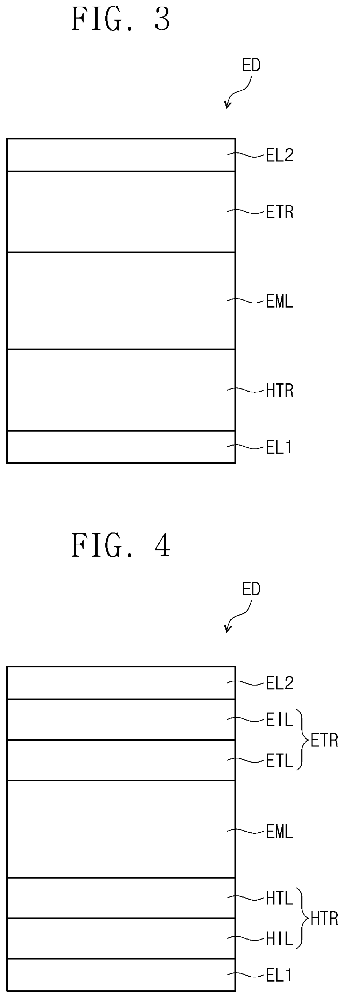

Each of the light emitting elements ED-1, ED-2, and ED-3 may have a structure of each light emitting element ED of embodiments according to FIGS. 3 to 7, as described in more detail elsewhere herein. Each of the light emitting elements ED-1, ED-2, and ED-3 may include a first electrode EL1, a hole transport region HTR, a layer selected from emission layers EML-R, EML-G, and EML-B, an electron transport region ETR, and a second electrode EL2.

FIG. 2 illustrates one or more embodiments in which the emission layers EML-R, EML-G, and EML-B of the light emitting elements ED-1, ED-2, and ED-3 are provided in openings OH defined in the pixel defining layer PDL, and the hole transport region HTR, the electron transport region ETR, and the second electrode EL2 are provided as a common layer in the entire light emitting elements ED-1, ED-2, and ED-3. Unlike the configuration illustrated in FIG. 2, the hole transport region HTR and the electron transport region ETR in one or more embodiments may be provided by being patterned inside the openings OH defined in the pixel defining layer PDL. For example, the hole transport region HTR, the emission layers EML-R, EML-G, and EML-B, and the electron transport region ETR of the light emitting elements ED-1, ED-2, and ED-3 in one or more embodiments may be provided by being patterned in an inkjet printing method.

The encapsulation layer TFE may cover the light emitting elements ED-1, ED-2 and ED-3. The encapsulation layer TFE may seal the display element layer DP-ED. The encapsulation layer TFE may be a thin film encapsulation layer. The encapsulation layer TFE may be formed by laminating one layer or a plurality of layers. The encapsulation layer TFE includes at least one insulation layer. The encapsulation layer TFE according to one or more embodiments may include at least one inorganic film (hereinafter, an encapsulation-inorganic film). The encapsulation layer TFE according to one or more embodiments may also include at least one organic film (hereinafter, an encapsulation-organic film) and at least one encapsulation-inorganic film.

The encapsulation-inorganic film protects the display element layer DP-ED from moisture and/or oxygen, and the encapsulation-organic film protects the display element layer DP-ED from foreign substances such as dust particles. The encapsulation-inorganic film may include silicon nitride, silicon oxynitride, silicon oxide, titanium oxide, aluminium oxide, and/or the like. The encapsulation-organic film may include an acrylic-based compound, an epoxy-based compound, and/or the like. The encapsulation-organic film may include a photopolymerizable organic material.

The encapsulation layer TFE may be provided on the second electrode EL2 and may be provided filling the opening OH.

Referring to FIGS. 1 and 2, the display device DD may include one or more non-light emitting region(s) NPXA and also include light emitting regions PXA-R, PXA-G, and PXA-B. The light emitting regions PXA-R, PXA-G, and PXA-B may be regions in which light generated by the respective light emitting elements ED-1, ED-2, and ED-3 are emitted. The light emitting regions PXA-R, PXA-G, and PXA-B may be spaced and/or apart from each other on a plane (e.g., in a plan view).

Each of the light emitting regions PXA-R, PXA-G, and PXA-B may be a region divided (i.e., defined) by the pixel defining layer PDL. The non-light emitting areas NPXA may be areas between the adjacent light emitting areas PXA-R, PXA-G, and PXA-B, which correspond to the pixel defining layer PDL. In some embodiments, in the specification, the light emitting regions PXA-R, PXA-G, and PXA-B may respectively correspond to pixels. The pixel defining layer PDL may divide the light emitting elements ED-1, ED-2, and ED-3. The emission layers EML-R, EML-G, and EML-B of the light emitting elements ED-1, ED-2, and ED-3 may be provided in openings OH defined in the pixel defining layer PDL and separated from each other.

The light emitting regions PXA-R, PXA-G, and PXA-B may be divided into a plurality of groups according to the color of light generated from the light emitting elements ED-1, ED-2, and ED-3. In the display device DD of one or more embodiments illustrated in FIGS. 1 and 2, three light emitting regions PXA-R, PXA-G, and PXA-B, which emit red light, green light, and blue light, respectively, are exemplarily illustrated. For example, the display device DD of one or more embodiments may include the red light emitting region PXA-R, the green light emitting region PXA-G, and the blue light emitting region PXA-B that are separated from each other.

In the display device DD according to one or more embodiments, the plurality of light emitting elements ED-1, ED-2 and ED-3 may be to emit light beams having wavelengths different from each other. For example, in one or more embodiments, the display device DD may include a first light emitting element ED-1 that emits red light, a second light emitting element ED-2 that emits green light, and a third light emitting element ED-3 that emits blue light. For example, the red light emitting region PXA-R, the green light emitting region PXA-G, and the blue light emitting region PXA-B of the display device DD may correspond to the first light emitting element ED-1, the second light emitting element ED-2, and the third light emitting element ED-3, respectively.

The first to third light emitting elements ED-1, ED-2, and ED-3 may be to emit light beams in substantially the same wavelength range or at least one light emitting element may be to emit a light beam in a wavelength range different from the others. For example, the first to third light emitting elements ED-1, ED-2, and ED-3 may all emit blue light.

The light emitting regions PXA-R, PXA-G, and PXA-B in the display device DD according to one or more embodiments may be arranged in a stripe form. Referring to FIG. 1, the plurality of red light emitting regions PXA-R may be arranged with each other along a second directional axis DR2, the plurality of green light emitting regions PXA-G may be arranged with each other along the second directional axis DR2, and the plurality of blue light emitting regions PXA-B each may be arranged along the second directional axis DR2. In some embodiments, the red light emitting region PXA-R, the green light emitting region PXA-G, and the blue light emitting region PXA-B may be alternately arranged with each other in this order along a first directional axis DR1.

FIGS. 1 and 2 illustrate that all the light emitting regions PXA-R, PXA-G, and PXA-B have similar area. Thus, the light emitting regions PXA-R, PXA-G, and PXA-B may have different areas from each other according to the wavelength range of the emitted light. In this case, the areas of the light emitting regions PXA-R, PXA-G, and PXA-B may refer to areas when viewed on a plane defined by the first directional axis DR1 and the second directional axis DR2.

In some embodiments, an arrangement form of the light emitting regions PXA-R, PXA-G, and PXA-B is not limited to the configuration illustrated in FIG. 1, and the order in which the red light emitting region PXA-R, the green light emitting region PXA-G, and the blue light emitting region PXA-B are arranged may be provided in one or more suitable combinations according to the characteristics of display quality required in the display device DD. For example, the arrangement form of the light emitting regions PXA-R, PXA-G, and PXA-B may be a pentile (PENTILE^{™}) arrangement form or a diamond (Diamond Pixel^{™}) arrangement form, (PENTILE^{™} and Diamond Pixel^{™} are registered trademarks owned by Samsung Display Co., Ltd.).

In some embodiments, the areas of the light emitting regions PXA-R, PXA-G, and PXA-B may be different from each other. For example, in one or more embodiments, the area of the green light emitting region PXA-G may be smaller than that of the blue light emitting region PXA-B.

Hereinafter, FIGS. 3 to 7 are cross-sectional views schematically illustrating light emitting elements according to one or more embodiments. Each of the light emitting elements ED according to one or more embodiments may include a first electrode EL1, a hole transport region HTR, an emission layer EML, an electron transport region ETR, and a second electrode EL2 that are sequentially stacked.

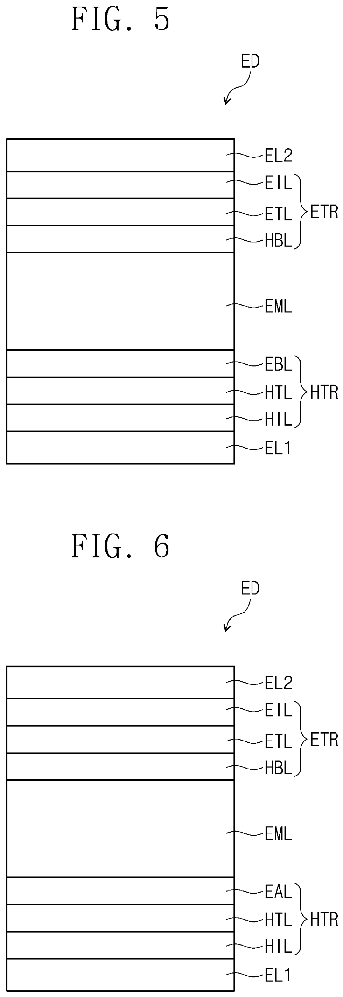

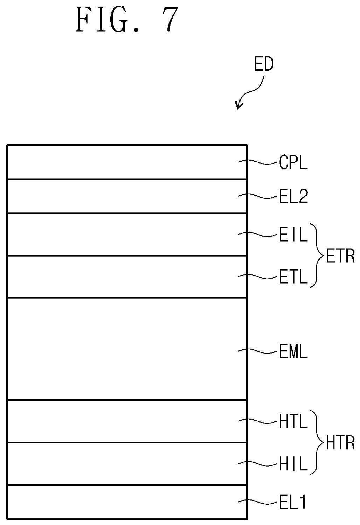

Compared with FIG. 3, FIG. 4 illustrates a cross-sectional view of a light emitting element ED of one or more embodiments, in which a hole transport region HTR includes a hole injection layer HIL and a hole transport layer HTL, and an electron transport region ETR includes an electron injection layer EIL and an electron transport layer ETL. In some embodiments, compared with FIG. 3, FIG. 5 illustrates a cross-sectional view of a light emitting element ED of one or more embodiments, in which a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL. As compared with FIG. 3, FIG. 6 illustrates a cross-sectional view of a light emitting element ED of one or more embodiments, in which a hole transport region HTR includes a hole injection layer HIL, a hole transport layer HTL, and an emission-auxiliary layer EAL, and an electron transport region ETR includes an electron injection layer EIL, an electron transport layer ETL, and a hole blocking layer HBL. Compared with FIG. 4, FIG. 7 illustrates a cross-sectional view of a light emitting element ED of one or more embodiments including a capping layer CPL provided on a second electrode EL2.

The first electrode EL1 has conductivity (e.g., is a conductor). The first electrode EL1 may be formed of a metal material, a metal alloy, or a conductive compound. The first electrode EL1 may be an anode or a cathode. In some embodiments, the first electrode EL1 may be a pixel electrode. The first electrode EL1 may be a transmissive electrode, a transflective electrode, or a reflective electrode. The first electrode EL1 may include at least one selected from among Ag, Mg, Cu, Al, Pt, Pd, Au, Ni, Nd, Ir, Cr, Li, Ca, LiF, Mo, Ti, W, In, Sn, and Zn, a compound of two or more selected from among these, a mixture of two or more selected from among these, and/or an oxide thereof.

When the first electrode EL1 is the transmissive electrode, the first electrode EL1 may include a transparent metal oxide such as indium tin oxide (ITO), indium zinc oxide (IZO), zinc oxide (ZnO), or indium tin zinc oxide (ITZO). When the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound or mixture thereof (e.g., a mixture of Ag and Mg). In some embodiments, the first electrode EL1 may have a multilayer structure including a reflective film or a transflective film formed of the herein-described materials, and a transparent conductive film formed of ITO, IZO, ZnO, ITZO, and/or the like. For example, the first electrode EL1 may have a three-layer structure of ITO/Ag/ITO. In some embodiments, the first electrode EL1 may include the herein-described metal materials, combinations of at least two metal materials of the herein-described metal materials, oxides of the herein-described metal materials, and/or the like. The thickness of the first electrode EL1 may be from about 700 angstrom (Å) to about 10,000 Å. For example, the thickness of the first electrode EL1 may be from about 1,000 Å to about 3,000 Å.

The hole transport region HTR is provided on the first electrode EL1. The hole transport region HTR may include at least one of a hole injection layer HIL, a hole transport layer HTL, an emission-auxiliary layer EAL, or an electron blocking layer EBL. The thickness of the hole transport region HTR may be, for example, from about 50 Å to about 15,000 Å. The emission-auxiliary layer EAL may be referred to as a buffer layer.

The hole transport region HTR may have a single layer formed of a single material, a single layer formed of a plurality of different materials, or a multilayer structure including a plurality of layers formed of a plurality of different materials.

For example, the hole transport region HTR may have a single layer structure of the hole injection layer HIL or the hole transport layer HTL, or may have a single layer structure formed of a hole injection material and a hole transport material. In some embodiments, the hole transport region HTR may have a single layer structure formed of a plurality of different materials, or a structure in which a hole injection layer HIL/hole transport layer HTL, a hole injection layer HIL/hole transport layer HTL/emission-auxiliary layer EAL, a hole injection layer HIL/emission-auxiliary layer EAL, a hole transport layer HTL/emission-auxiliary layer EAL, or a hole injection layer HIL/hole transport layer HTL/electron blocking layer EBL are stacked in order from the first electrode EL1.

The hole transport region HTR may be formed utilizing one or more suitable methods such as a vacuum deposition method, a spin coating method, a cast method, a Langmuir-Blodgett (LB) method, an inkjet printing method, a laser printing method, and a laser induced thermal imaging (LITI) method.

The hole transport region HTR may include a compound represented by Formula H-1.

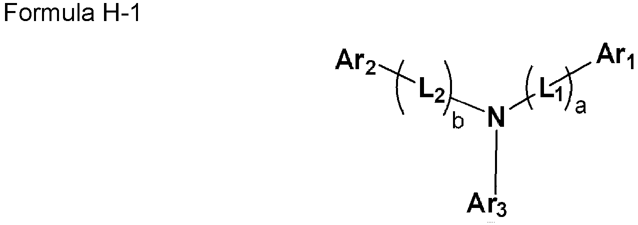

In Formula H-1, L₁ and L₂ are each independently a direct linkage, a substituted or unsubstituted arylene group having 6 to 30 ring-forming carbon atoms, or a substituted or unsubstituted heteroarylene group having 2 to 30 ring-forming carbon atoms. a and b are each independently an integer of 0 to 10. In some embodiments, when a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ are each independently a substituted or unsubstituted aryl group having 6 to 30 ring-forming carbon atoms, or a substituted or unsubstituted heteroaryl group having 2 to 30 ring-forming carbon atoms. In some embodiments, in Formula H-1, Ar₃ is a substituted or unsubstituted aryl group having 6 to 30 ring-forming carbon atoms, or a substituted or unsubstituted heteroaryl group having 2 to 30 ring-forming carbon atoms.

The compound represented by Formula H-1 herein may be a monoamine compound. In some embodiments, the compound represented by Formula H-1 herein may be a diamine compound in which at least one (e.g., selected from) among Ar₁ to Ar₃ includes the amine group as a substituent. In some embodiments, the compound represented by Formula H-1 herein may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂

The compound represented by Formula H-1 may be represented by any one selected from among the compounds in Compound Group H. However, the compounds listed in Compound Group H are examples, and the compounds represented by Formula H-1 are not limited to those represented by Compound Group H.

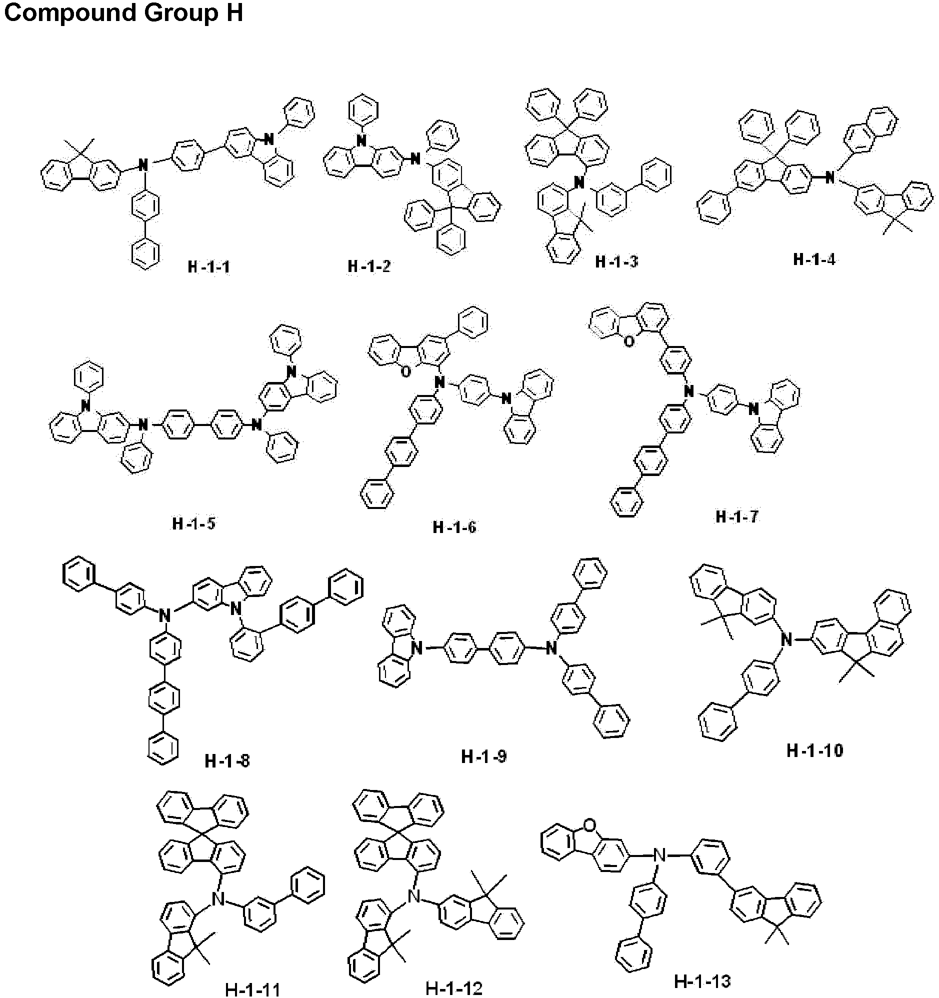

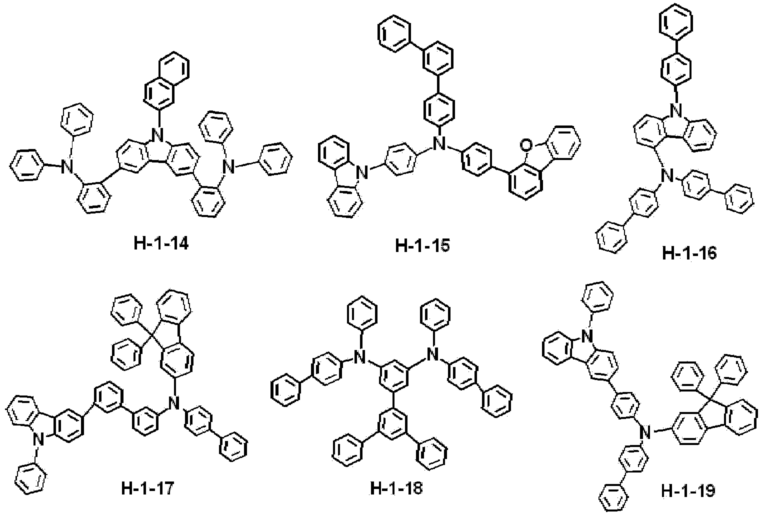

The hole transport region HTR may include at least one selected from among a phthalocyanine compound such as copper phthalocyanine; N¹,N^{1'}-([1,1'-biphenyl]-4,4'-diyl)bis(N¹-phenyl-N⁴,N⁴-di-m-tolylbenzene-1 ,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HATCN), and/or the like.

The hole transport region HTR may include at least one selected from among a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalene-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In some embodiments, the hole transport region HTR may include 9-(4-*tert-*butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may include the herein-described compounds of the hole transport region in at least one of a hole injection layer HIL, a hole transport layer HTL, an emission-auxiliary layer EAL, or an electron blocking layer EBL.

The thickness of the hole transport region HTR may be from about 100 A to about 10,000 Å, for example, from about 100 Å to about 5,000 Å. When the hole transport region HTR includes the hole injection layer HIL, the hole injection layer HIL may have, for example, a thickness of about 30 Å to about 1,000 Å. When the hole transport region HTR includes the hole transport layer HTL, the hole transport layer HTL may have a thickness of about 250 Å to about 1,000 Å. For example, when the hole transport region HTR includes the electron blocking layer EBL, the electron blocking layer EBL may have a thickness of about 10 Å to about 1,000 Å. When the thicknesses of the hole transport region HTR, the hole injection layer HIL, the hole transport layer HTL and the electron blocking layer EBL satisfy the herein-described ranges, satisfactory hole transport properties may be achieved without a substantial increase in driving voltage.

The hole transport region HTR may further include a charge generating material to increase conductivity in addition to the herein-described materials. The charge generating material may be dispersed uniformly or non-uniformly in the hole transport region HTR. The charge generating material may be, for example, a p-dopant. The p-dopant may include at least one of a halogenated metal compound, a quinone derivative, a metal oxide, or a cyano group-containing compound. For example, the p-dopant may include a metal halide compound such as Cul or Rbl, a quinone derivative such as tetracyanoquinodimethane (TCNQ) or 2,3,5,6-tetrafluoro-7,7,8,8-tetracyanoquinodimethane (F4-TCNQ), a metal oxide such as tungsten oxide or molybdenum oxide, a cyano group-containing compound such as dipyrazino[2,3-f: 2',3'-h] quinoxaline-2,3,6,7,10,11-hexacarbonitrile (HATCN) or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like.

As described herein, the hole transport region HTR may further include at least one of the emission-auxiliary layer EAL or the electron blocking layer EBL, in addition to the hole injection layer HIL and the hole transport layer HTL. The emission-auxiliary layer EAL may compensate a resonance distance according to the wavelength of light emitted from the emission layer EML and regulate a hole charge balance to increase light emitting efficiency. In some embodiments, the emission-auxiliary layer EAL may serve to prevent or reduce electrons from being injected into the hole transport region HTR. Materials which may be included in the hole transport region HTR may be included in the emission-auxiliary layer EAL. The electron blocking layer EBL is a layer that serves to prevent or reduce electrons from being injected from the electron transport region ETR to the hole transport region HTR.

In the light-emitting element ED according to one or more embodiments, the emission layer EML may include a polycyclic compound according to one or more embodiments. In the light-emitting element ED according to one or more embodiments, the light emitting layer EML may include a first compound which is a polycyclic compound according to one or more embodiments, and at least one compound of a second compound or a third compound. In some embodiments, in the light-emitting element ED according to one or more embodiments, the emission layer EML may further include a fourth compound. The second compound may include a tricyclic fused ring containing a nitrogen atom as a ring-forming atom. The third compound may include a hexagonal ring group containing at least one nitrogen atom as a ring-forming atom. The fourth compound may include an organometallic complex. The second to fourth compounds are described in more detail elsewhere herein.

### Polycyclic Compound

In this specification, the first compound may be referred to as a polycyclic compound according to one or more embodiments. The polycyclic compound according to one or more embodiments includes, as a core structure, a pentacyclic fused ring containing two nitrogen (N) atoms and one boron (B) atom as ring-forming atoms. In some embodiments, the polycyclic compound according to one or more embodiments may include two terphenyl groups bonded to the pentacyclic fused ring core structure, and a polycyclic ring connecting the two terphenyl groups. As the two terphenyl groups, the polycyclic ring connecting the two terphenyl groups, and the pentacyclic fused ring core structure may be bonded to each other, the polycyclic compound according to one or more embodiments may have a cyclized structure.

In some embodiments, the polycyclic compound according to one or more embodiments may include a sterically bulky substituent and/or the like, and may have a sphere-like structure in three dimensions. Due to the characteristics of the three-dimensional shape of the polycyclic compound according to one or more embodiments, aggregations, interactions, and/or the like between molecules of the polycyclic compound may be reduced, and therefore, the polycyclic compound may have excellent or suitable material stability.

In the polycyclic compound according to one or more embodiments, the pentacyclic fused ring core structure may be protected by a substituent and/or the like, and accordingly, the material stability of the polycyclic compound, according to one or more embodiments, may be improved. For example, in the polycyclic compound according to one or more embodiments, the pentacyclic fused ring core structure may have a molecular form surrounded and protected by a substituent and/or the like, and the P-orbital of a B atom, which is an atom forming the pentacyclic fused ring core structure, may be well protected by a substituent and/or the like, thereby enhancing the material stability.

In some embodiments, due to the three-dimensional structural characteristics of the polycyclic compound, according to one or more embodiments, which has a cyclized structure formed by the substituents, linkers, and/or the like, the pentacyclic fused ring core, corresponding to a multi-resonance core in which luminescence-related transitions occur, may be protected. In some embodiments, in the polycyclic compound according to one or more embodiments, molecular planarity may be reduced due to the three-dimensional structural characteristics to thereby increase the distance between the adjacent molecules, so that Dexter transitions may be reduced, and side reactions, and/or the like such as triplet-triplet annihilation (TTA), which causes inter-molecular interactions other than transitions for luminescence, may be reduced, thereby achieving excellent or suitable stability.

The light-emitting element ED according to one or more embodiments may include the polycyclic compound according to one or more embodiments. The polycyclic compound according to one or more embodiments is represented by Formula 1.

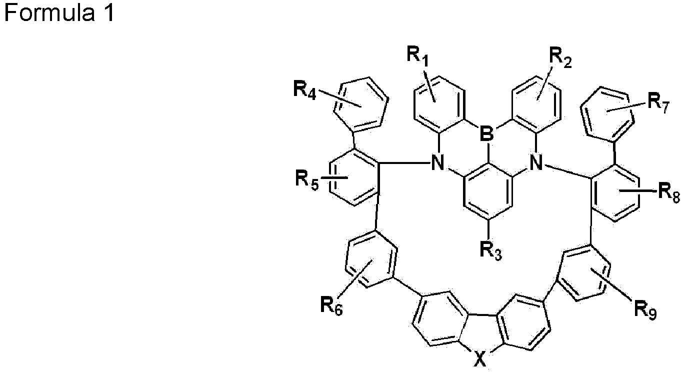

In Formula 1, X is O, S, Se, NRₐ, or CR_{b}R_{c}. In some embodiments, Rₐ to R_{c} are each independently a hydrogen atom, a deuterium atom, a halogen atom, a substituted or unsubstituted alkyl group having 1 to 10 carbon atoms, a substituted or unsubstituted alkenyl group having 2 to 10 carbon atoms, a substituted or unsubstituted oxy group, a substituted or unsubstituted thio group, a substituted or unsubstituted aryl group having 6 to 30 ring-forming carbon atoms, or a substituted or unsubstituted heteroaryl group having 3 to 30 ring-forming carbon atoms. For example, Rₐ to R_{c} may each independently be a hydrogen atom, a deuterium atom, an unsubstituted alkyl group having 1 to 10 carbon atoms, an alkyl group having 1 to 10 carbon atoms substituted with deuterium, a substituted or unsubstituted aryl group having 6 to 20 ring-forming carbon atoms, or a substituted or unsubstituted heteroaryl group having 6 to 30 ring-forming carbon atoms.

In Formula 1, R₁ to R₉ are each independently a hydrogen atom, a deuterium atom, a halogen atom, a cyano group, a substituted or unsubstituted alkyl group having 1 to 10 carbon atoms, a substituted or unsubstituted alkenyl group having 2 to 10 carbon atoms, a substituted or unsubstituted oxy group, a substituted or unsubstituted thio group, a substituted or unsubstituted aryl group having 6 to 30 ring-forming carbon atoms, or a substituted or unsubstituted heteroaryl group having 3 to 30 ring-forming carbon atoms, and/or bonded to an adjacent group to form a ring.

In Formula 1, at least one (e.g., selected from) among R₁ and R₂ may be a substituted or unsubstituted aryl group having 6 to 30 ring-forming carbon atoms, or a substituted or unsubstituted heteroaryl group having 3 to 30 ring-forming carbon atoms. For example, R₁ and R₂ may each independently be a substituted or unsubstituted aryl group having 6 to 20 ring-forming carbon atoms, or a substituted or unsubstituted heteroaryl group having 6 to 30 ring-forming carbon atoms.

In Formula 1, R₃ may be a hydrogen atom, a substituted or unsubstituted alkyl group having 1 to 10 carbon atoms, a substituted or unsubstituted aryl group having 6 to 30 ring-forming carbon atoms, or a substituted or unsubstituted heteroaryl group having 3 to 30 ring-forming carbon atoms. For example, R₃ may be a hydrogen atom, a substituted or unsubstituted alkyl group having 1 to 10 carbon atoms, a substituted or unsubstituted aryl group having 6 to 20 ring-forming carbon atoms, or a substituted or unsubstituted heteroaryl group having 6 to 30 ring-forming carbon atoms.

In the polycyclic compound, according to one or more embodiments, represented by Formula 1, at least one of the hydrogen atoms may be substituted with a deuterium atom, e.g., at least one selected from among R₁ to R₉ and Rₐ to R_{c} may be a deuterium atom. For example, in the polycyclic compound represented by Formula 1, not only the hydrogen atoms forming the fused ring core, terphenyl derivatives, and the polycyclic ring connecting the terphenyl derivatives, but also the hydrogen atoms in the substituents, respectively substituted therefor, may be substituted with deuterium atoms.

In one or more embodiments, the polycyclic compound in Formula 1 may be represented by Formula 1-1 to Formula 1-4.

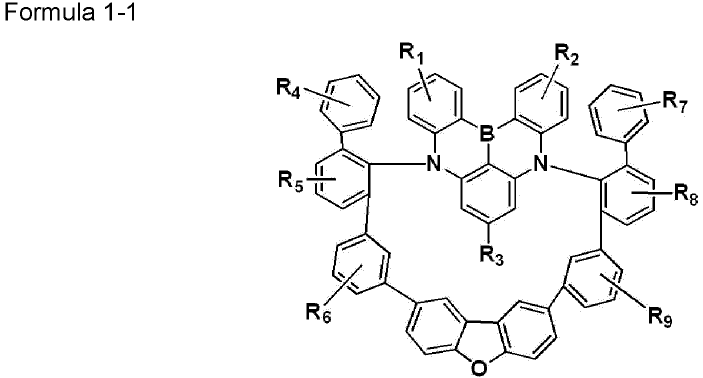

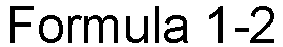

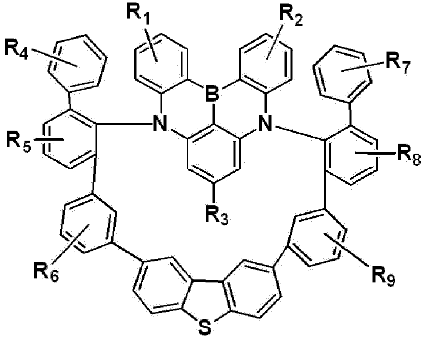

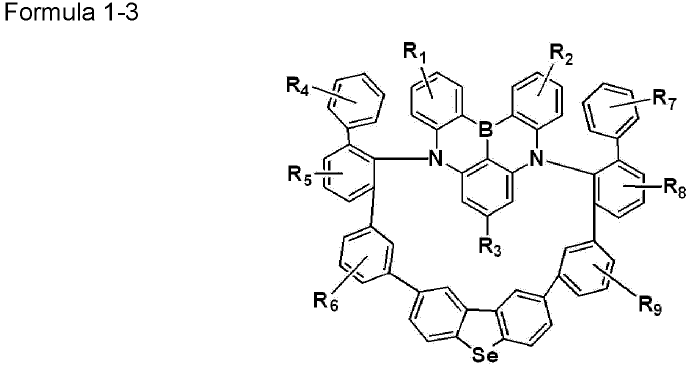

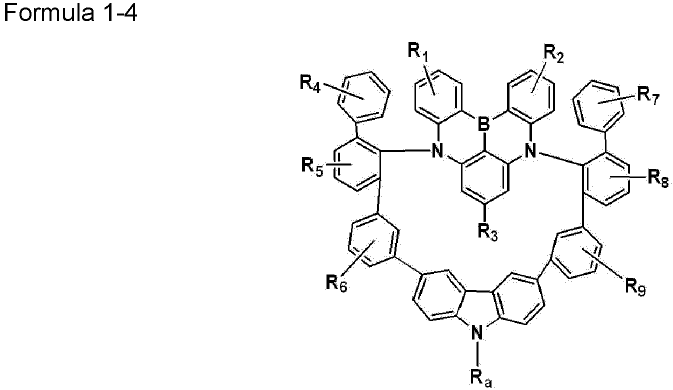

In Formula 1-1 to Formula 1-4, the description of Formula 1, previously described, is applied equally to Rₐ and R₁ to R₉. In Formula 1-4, Rₐ may be a hydrogen atom, a deuterium atom, an unsubstituted alkyl group having 1 to 10 carbon atoms, an alkyl group having 1 to 10 carbon atoms substituted with deuterium, a substituted or unsubstituted aryl group having 6 to 20 ring-forming carbon atoms, or a substituted or unsubstituted heteroaryl group having 6 to 30 ring-forming carbon atoms.

In the polycyclic compound, according to one or more embodiments, represented by Formula 1, and/or the like, a polycyclic ring of three rings, including (e.g., containing) X as a ring-forming atom, may serve as a linker that connects two terphenyl derivatives to each other. The pentacyclic fused ring core may be protected by the polycyclic ring of three rings and the terphenyl derivatives connected thereto. In some embodiments, the polycyclic compound, according to one or more embodiments, may include a sterically bulky substituent substituted at a position of R₁ or R₂, so that inter-molecular interactions of the polycyclic compound may be reduced, thereby achieving excellent or suitable material stability.

The polycyclic compound according to one or more embodiments may be represented by any one selected from among compounds of Compound Group 1. The light-emitting element ED according to one or more embodiments may include at least one selected from among the compounds of Compound Group 1. In Compound Group 1, D is a deuterium atom.

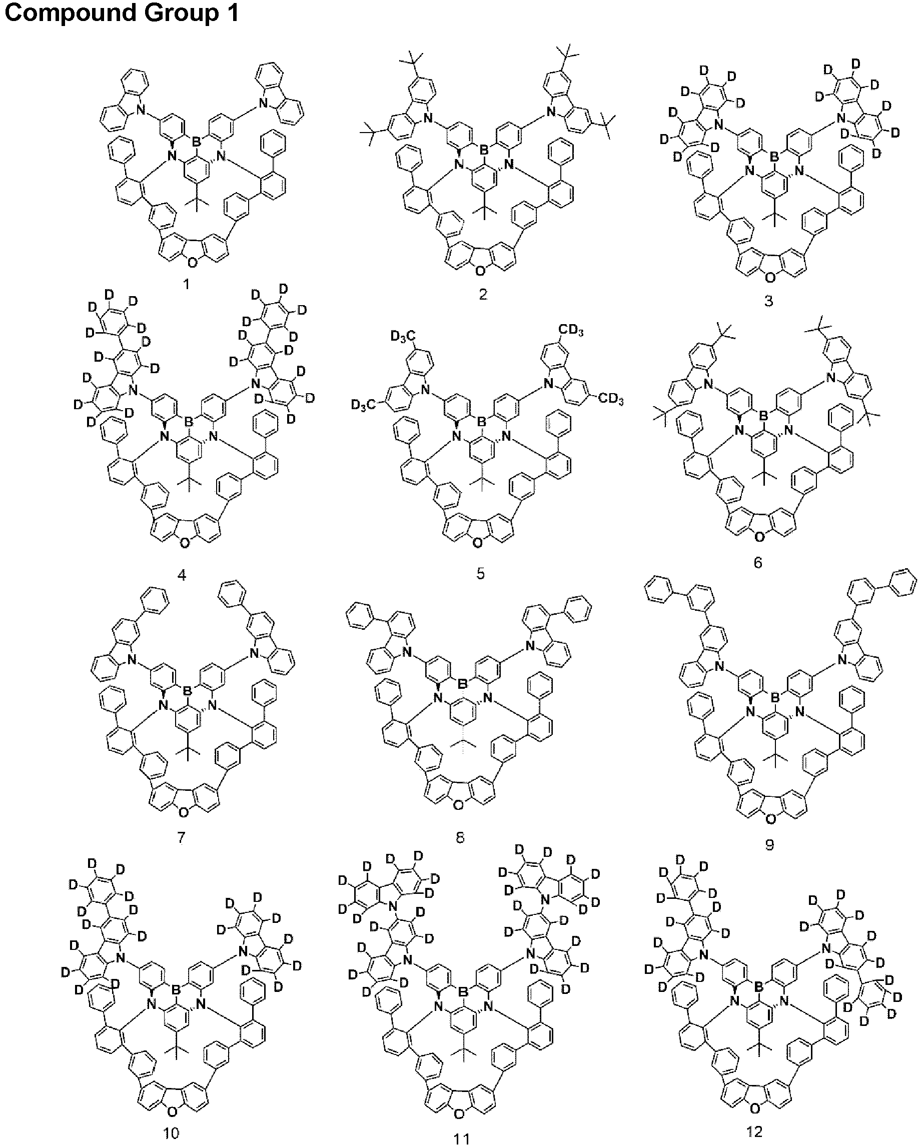

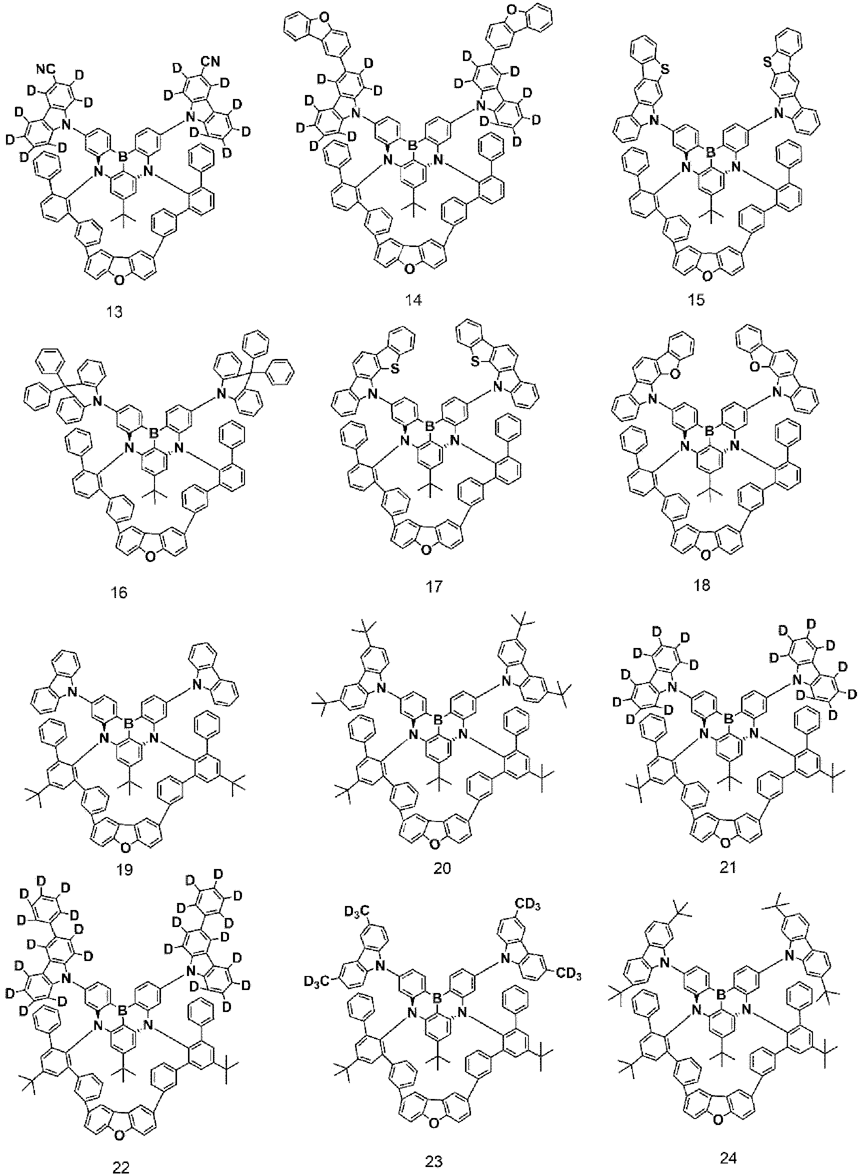

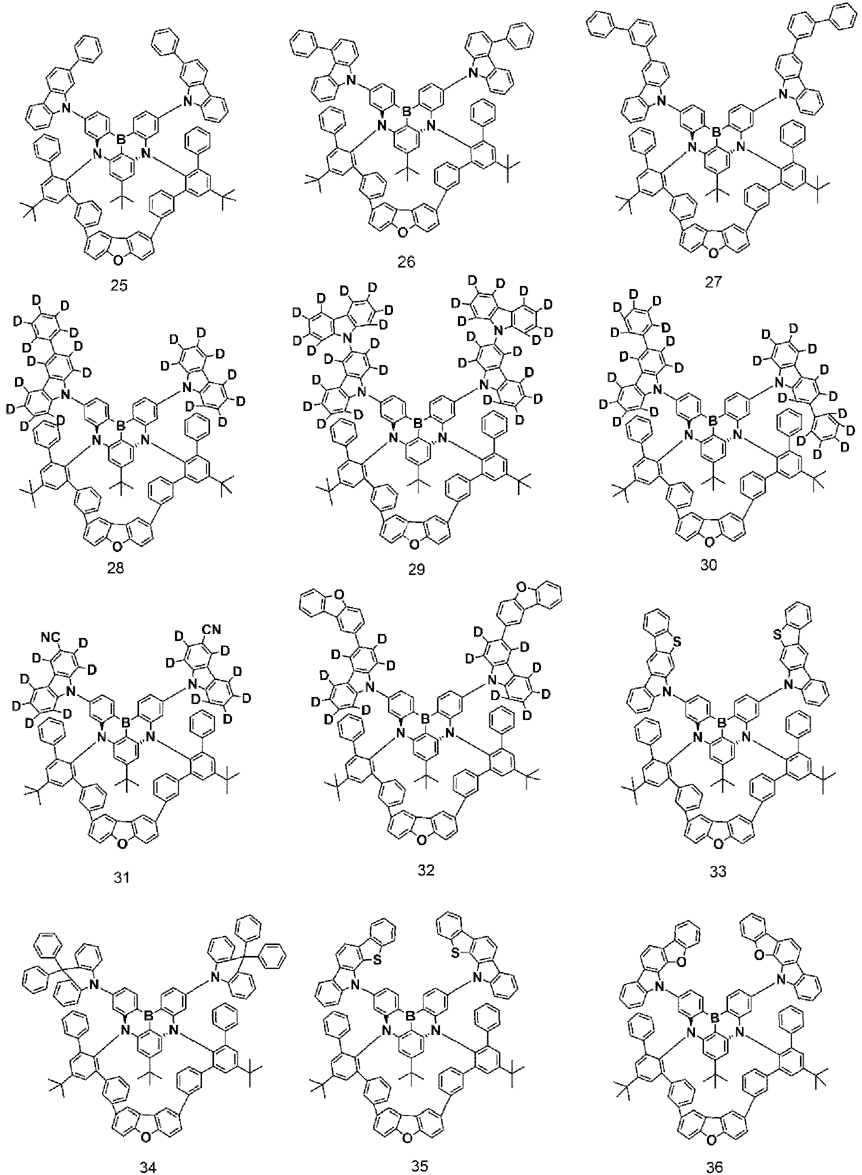

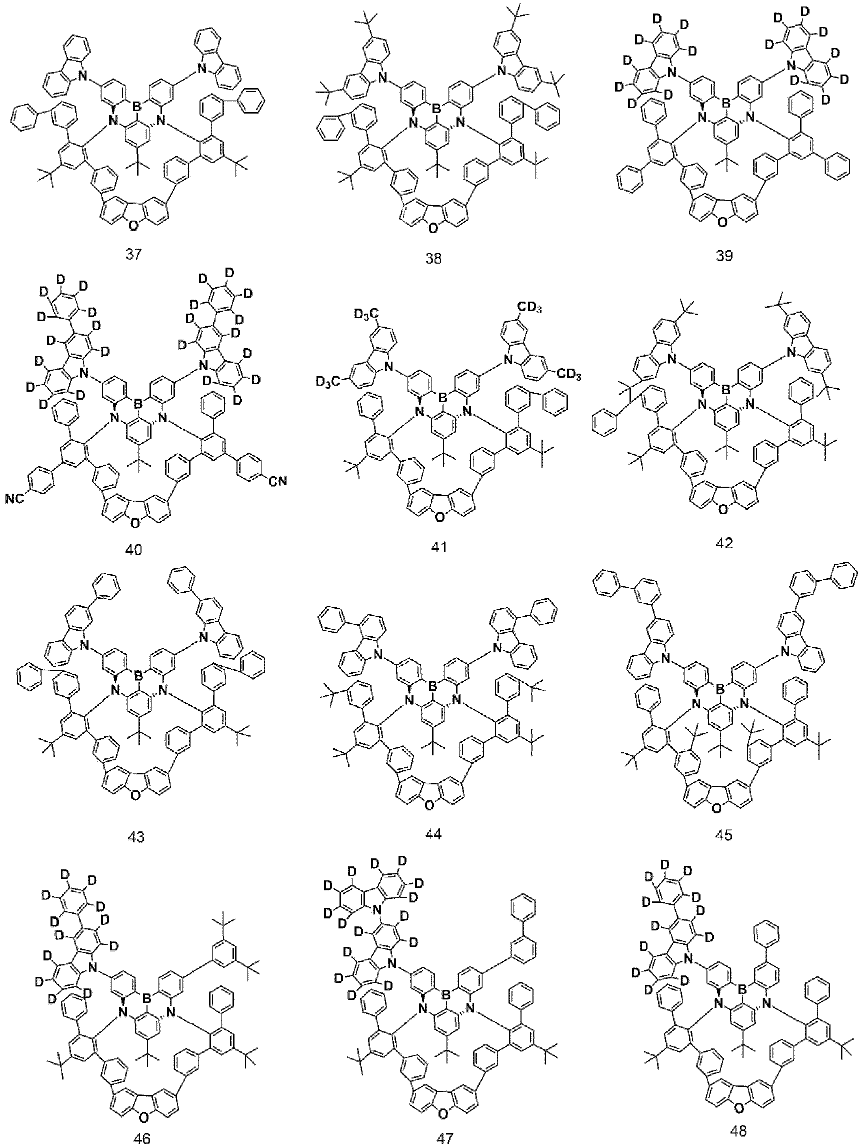

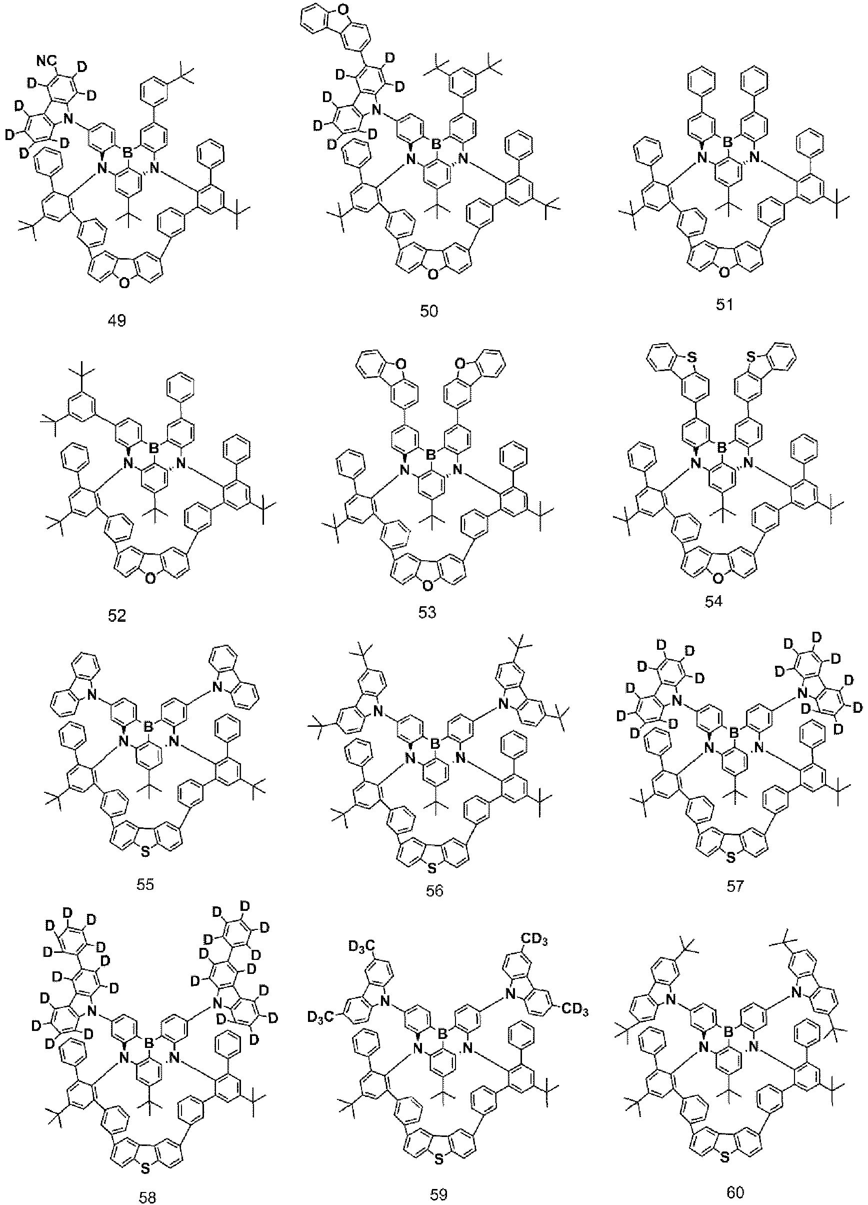

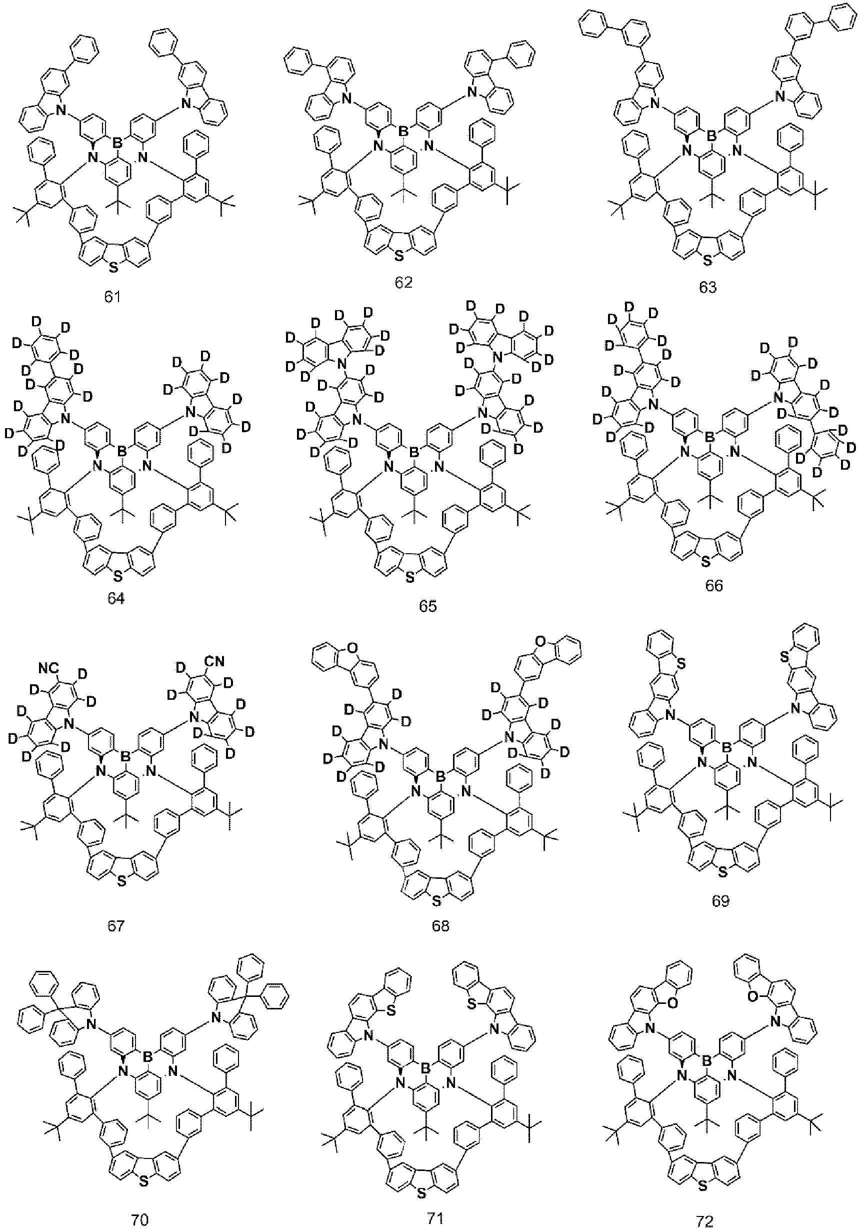

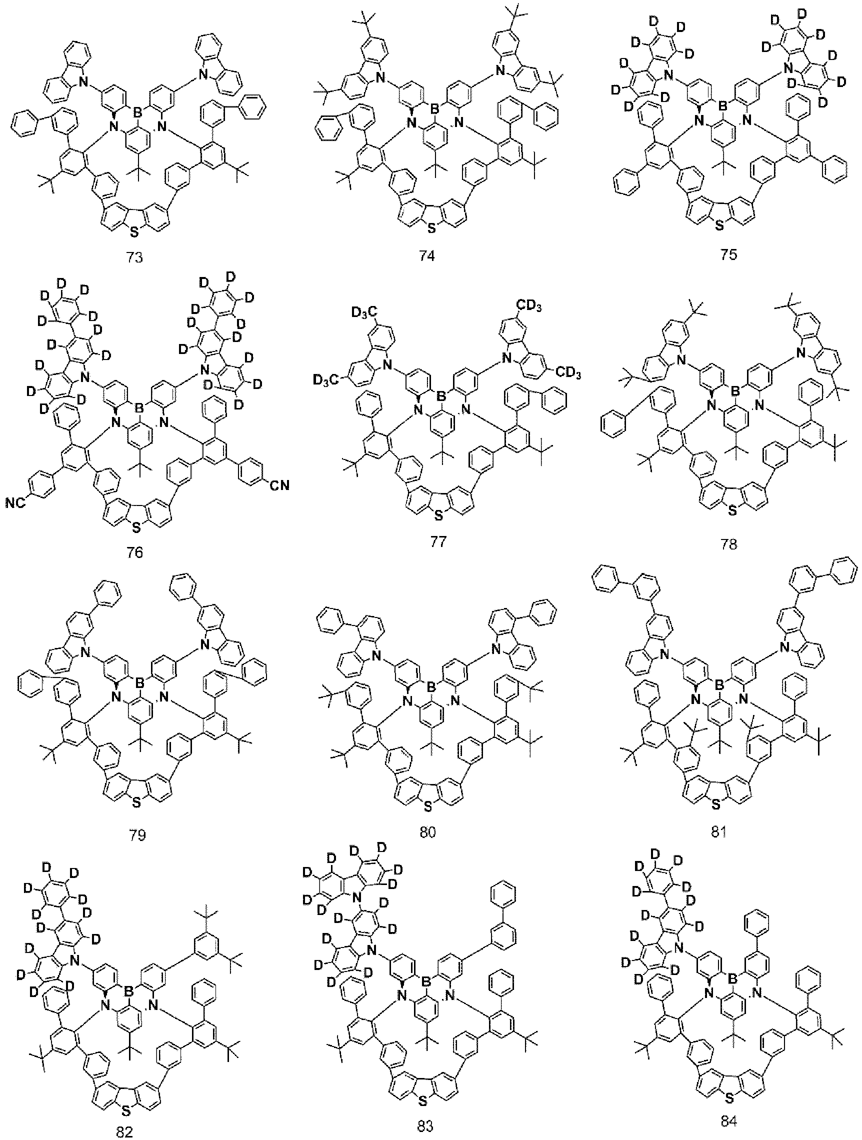

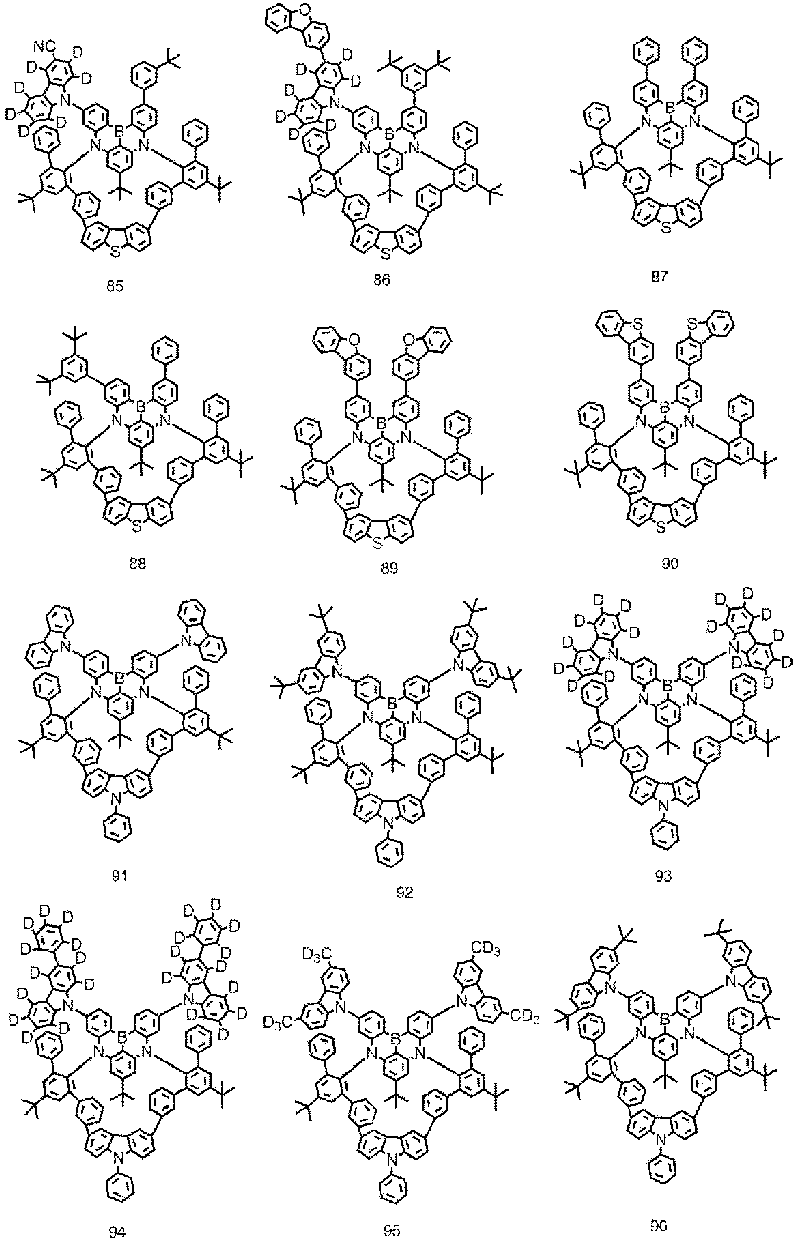

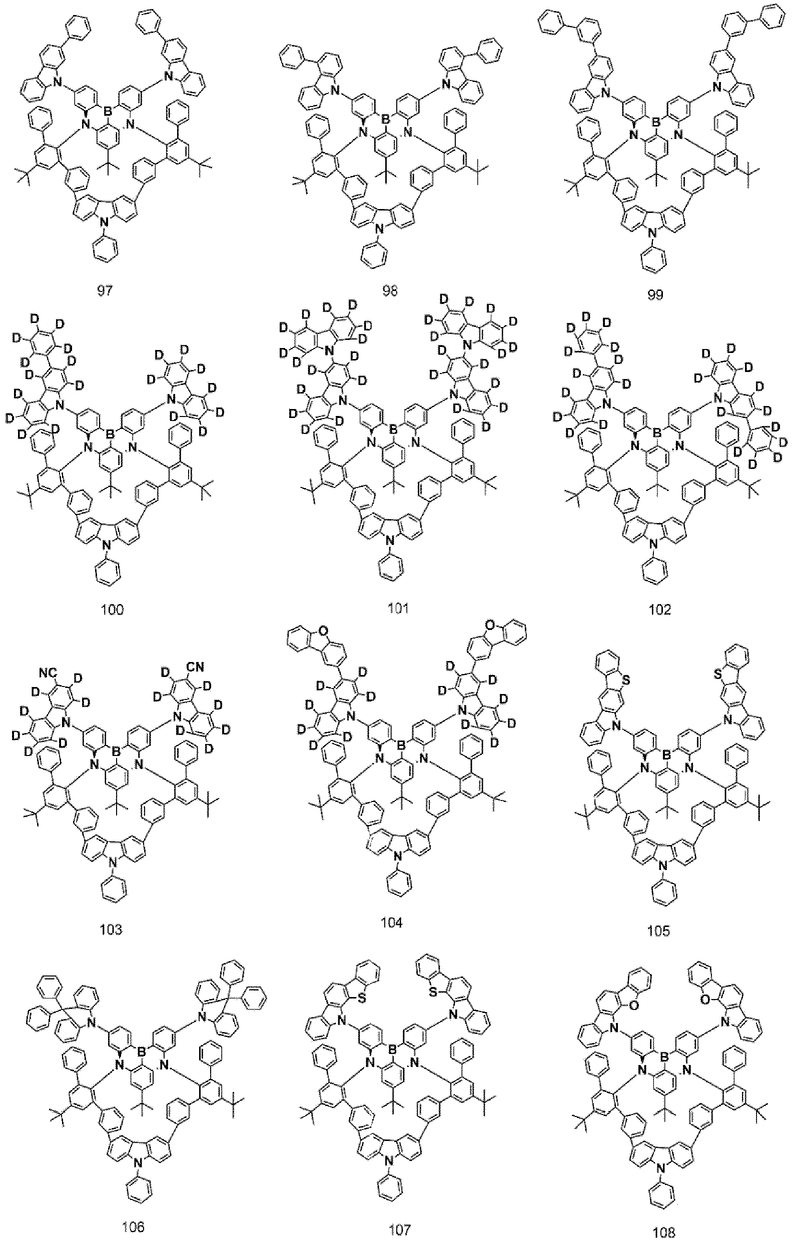

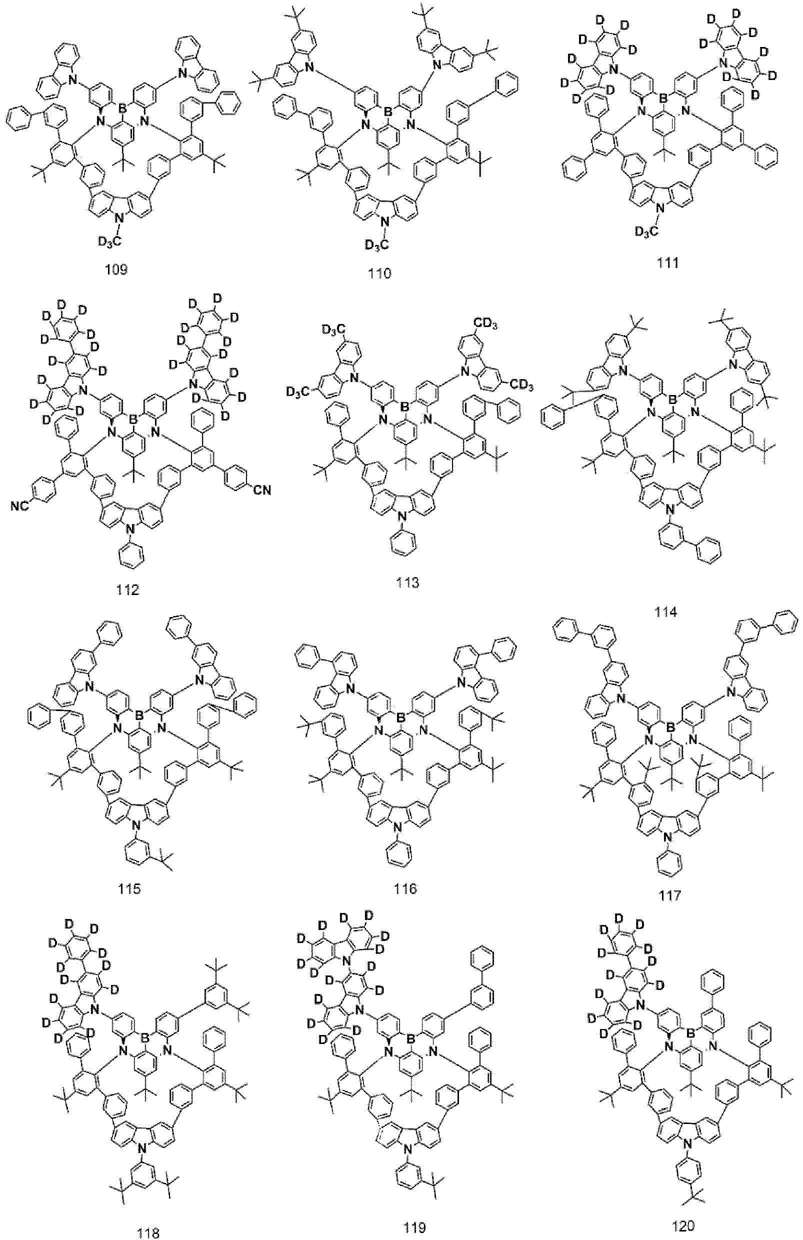

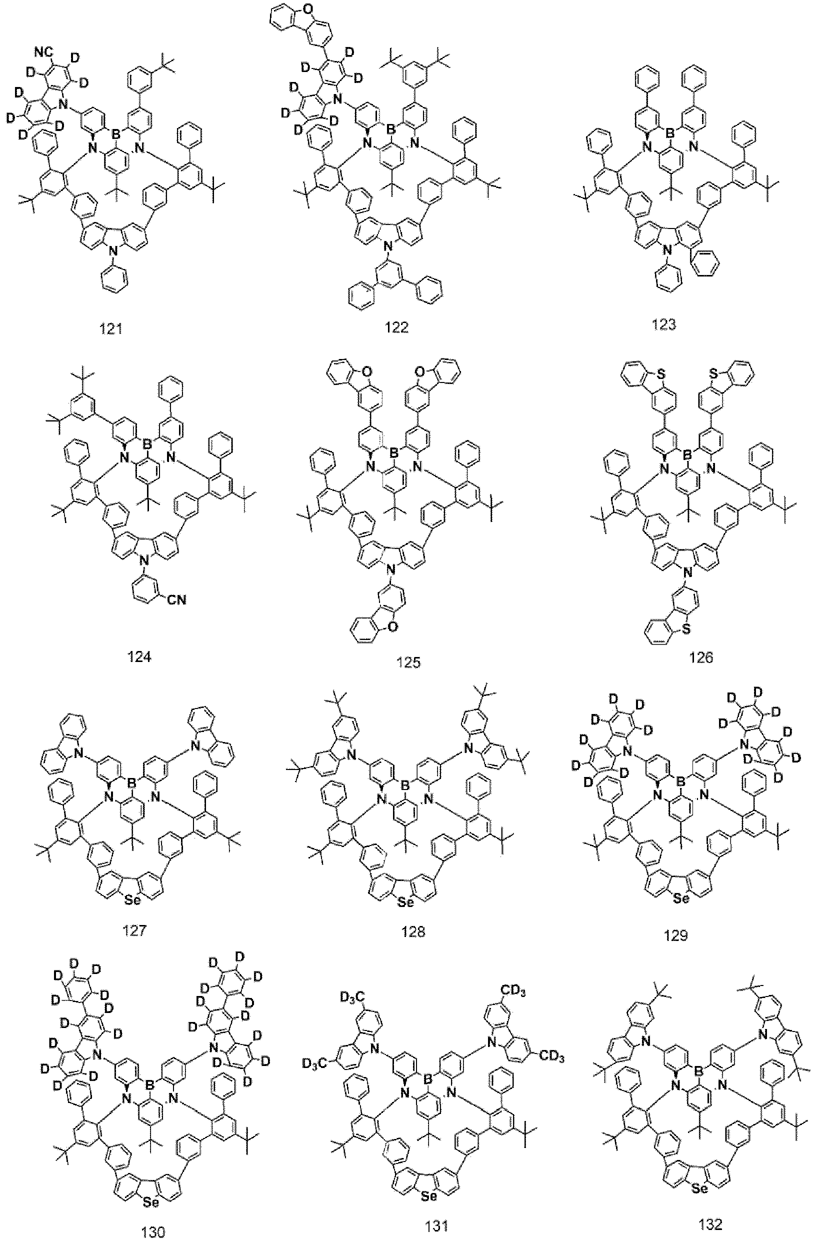

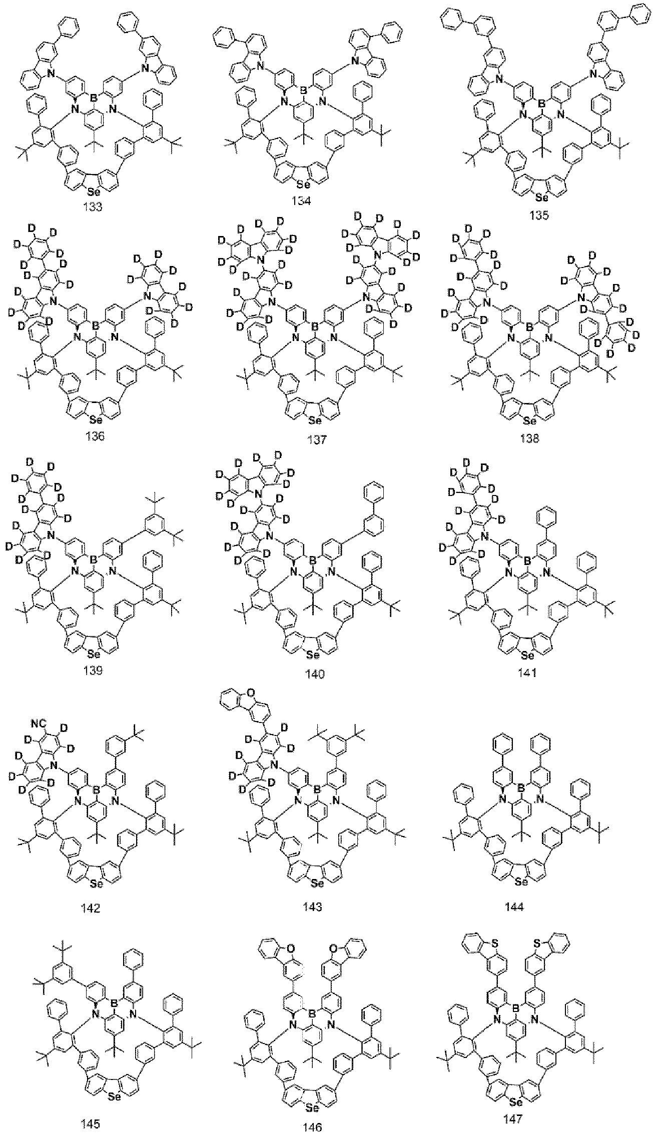

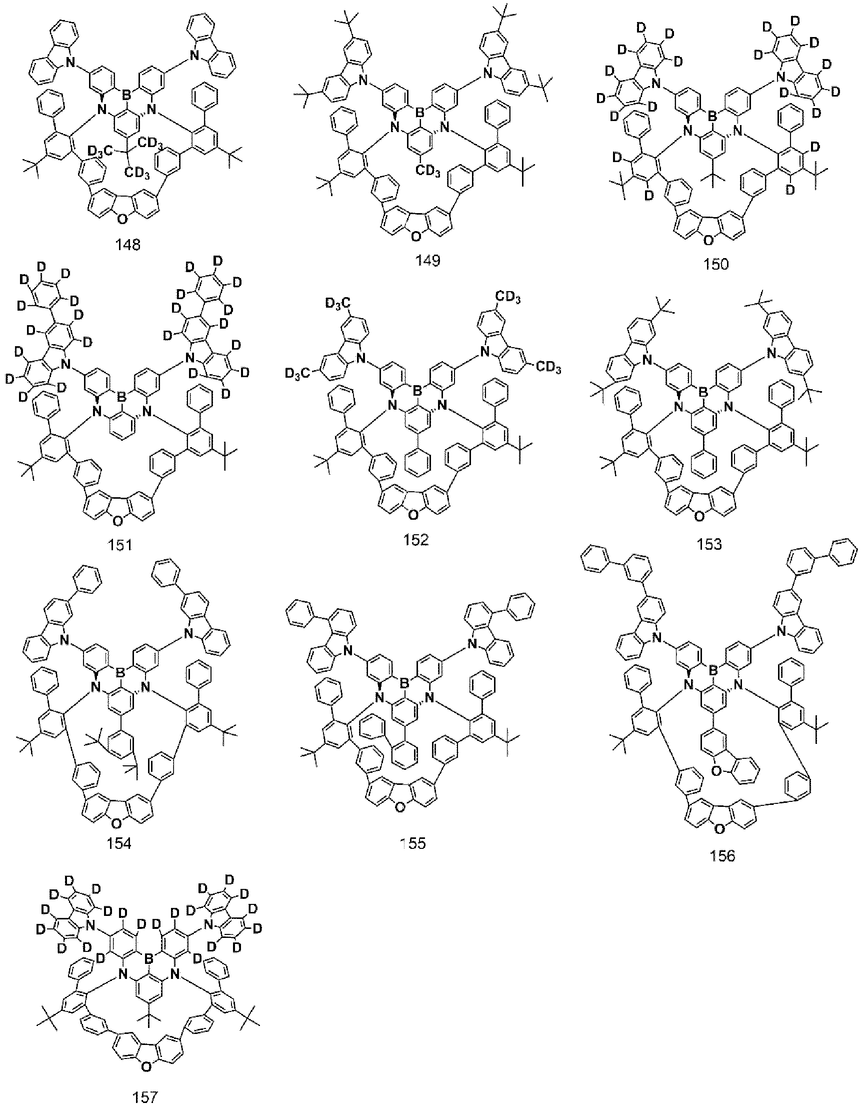

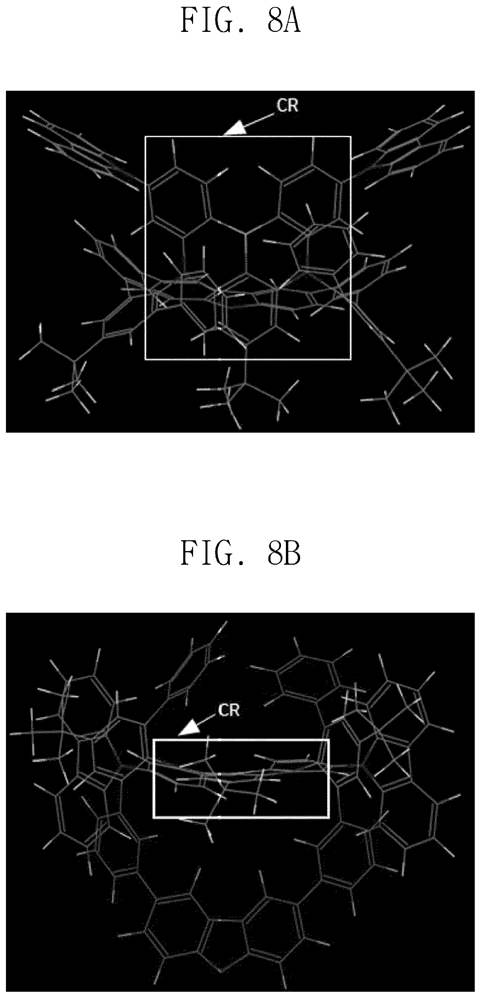

FIGS. 8A and 8B are images each showing a 3D structure of a polycyclic compound according to one or more embodiments. FIGS. 8A and 8B show a 3D structure of Compound 157 among the compounds of Compound Group 1. FIG. 8A shows the 3D structure of Compound 157 when viewed from the front, and FIG. 8B shows the 3D structure of Compound 157 when viewed from the bottom.

Referring to FIGS. 8A and 8B, it may be confirmed that a fused ring core CR part is surrounded by a substituent and/or the like. For example, it may be seen that a polycyclic compound according to one or more embodiments has a cyclized structure, when viewed as a whole molecule, due to the fused ring core CR, the substituents substituted therefor, and a polycyclic ring of three rings connecting between the substituents.

For example, the polycyclic compound according to one or more embodiments may have a three-dimensional cyclized structure, and the planarity thereof may be suppressed or reduced, so that inter-molecular interactions may be reduced, and the polycyclic compound may have a structure in which the fused ring core is surrounded and protected by the substituents and/or the like, thereby exhibiting excellent or suitable material stability.

A light-emitting element, according to one or more embodiments, including the polycyclic compound according to one or more embodiments may have high efficiency and long lifespan characteristics. In particular, the light-emitting element according to one or more embodiments, which includes, in an emission layer, the polycyclic compound according to one or more embodiments having improved material stability, may have excellent or suitable lifespan characteristics.

In the light-emitting element according to one or more embodiments, the emission layer EML may be a delayed fluorescent emission layer including a host and a dopant. More particularly, the emission layer EML may be to emit thermally activated delayed fluorescence (TADF). The polycyclic compound according to one or more embodiments may be a delayed fluorescent dopant. In particular, the polycyclic compound according to one or more embodiments may be a thermally activated delayed fluorescent dopant.

The emission layer EML may include the polycyclic compound, according to one or more embodiments, as a dopant. The polycyclic compound according to one or more embodiments may be to emit blue color light. For example, the polycyclic compound according to one or more embodiments may be a light-emitting material having an emission center wavelength in a wavelength region of about 430 nanometer (nm) to about 490 nm. In particular, the polycyclic compound according to one or more embodiments may be a light-emitting material having an emission center wavelength in a wavelength region of about 450 nm to about 470 nm.

In one or more embodiments, the emission layer EML may include the polycyclic compound according to one or more embodiments, and include at least one (e.g., selected from) among second to fourth compounds. In one or more embodiments, the emission layer EML may include the second compound represented by Formula HT-1. For example, the second compound may be utilized as a hole-transporting host material of the emission layer EML.

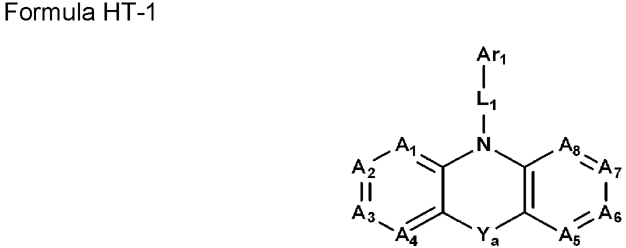

In Formula HT-1, A₁ to A₈ are each independently N or CR₅₁. For example, A₁ to A₈ may be all CR₅₁. In some embodiments, any one selected from among A₁ to A₈ may be N, and the rest (i.e., any remaining A₁ to A₈) may be CR₅₁.

In Formula HT-1, L₁ is a direct linkage, a substituted or unsubstituted arylene group having 6 to 30 ring-forming carbon atoms, or a substituted or unsubstituted heteroarylene group having 2 to 30 ring-forming carbon atoms. For example, L₁ may be a direct linkage, a substituted or unsubstituted phenylene group, a substituted or unsubstituted divalent biphenyl group, a substituted or unsubstituted divalent carbazole group, and/or the like.

In Formula HT-1, Yₐ is a direct linkage, CR₅₂R₅₃, or SiR₅₄R₅₅. For example, it may refer to that two benzene rings are connected to the nitrogen atom in Formula HT-1 via a direct linkage, 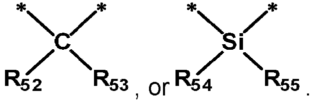 In Formula HT-1, when Yₐ is a direct linkage, the second compound, represented by Formula HT-1, may include a carbazole moiety.

In Formula HT-1, Ar₁ is a substituted or unsubstituted aryl group having 6 to 30 ring-forming carbon atoms, or a substituted or unsubstituted heteroaryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, a substituted or unsubstituted biphenyl group, and/or the like.

In Formula HT-1, R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In some embodiments, R₅₁ to R₅₅ may each be bonded with an adjacent group to form a ring. For example, R₅₁ to R₅₅ may each independently be a hydrogen atom or a deuterium atom. R₅₁ to R₅₅ may each independently be an unsubstituted methyl group, or unsubstituted phenyl group.

In one or more embodiments, the second compound represented by Formula HT-1 may be represented by any one selected from among compounds suggested in Compound Group 2. The emission layer EML may include at least one selected from among the compounds, suggested in Compound Group 2, as a hole-transporting host material.

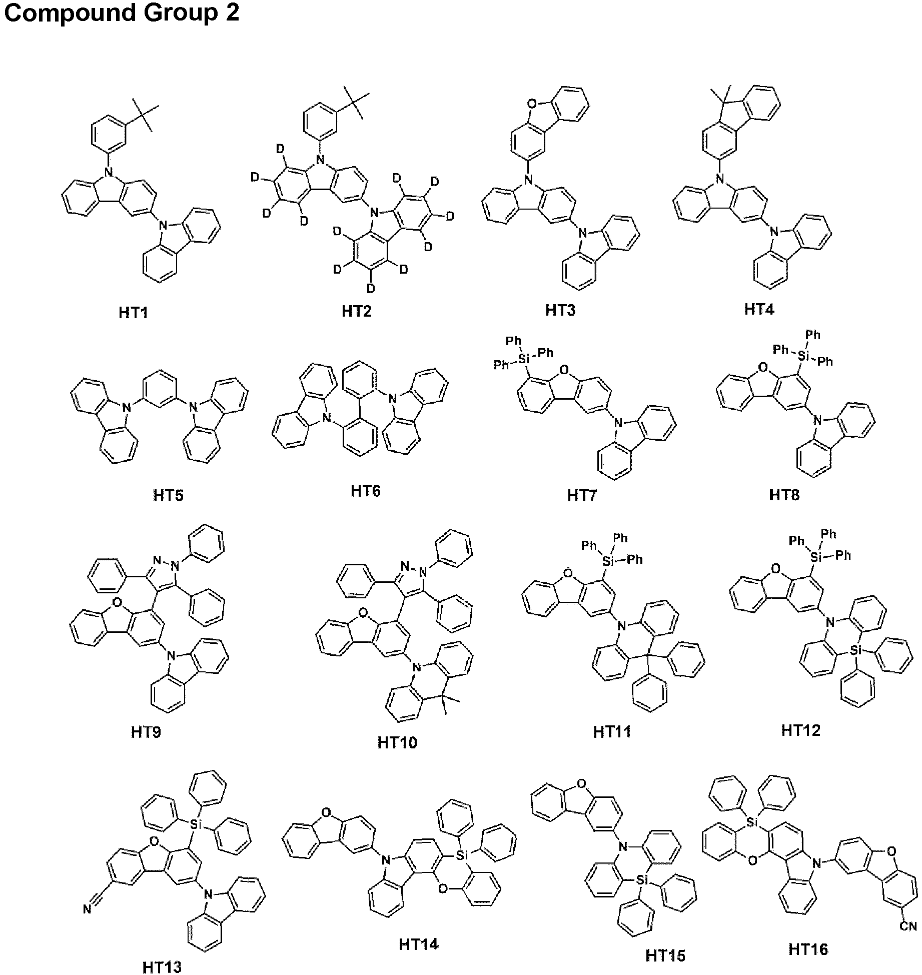

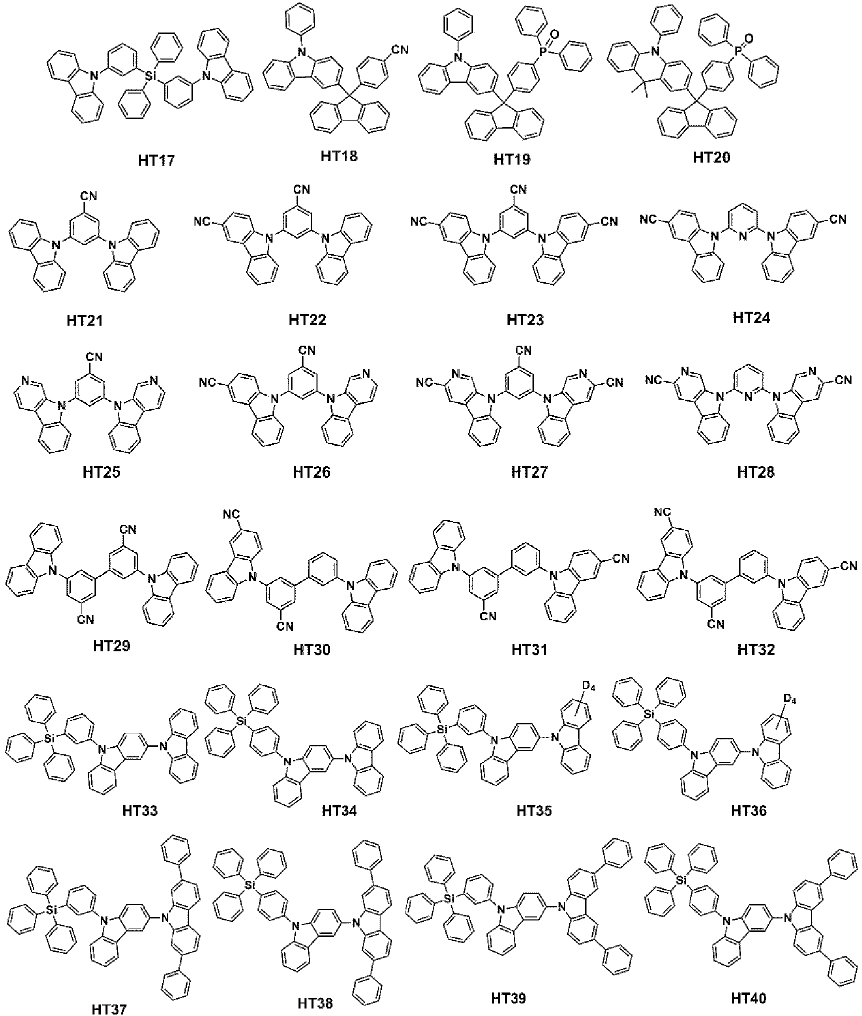

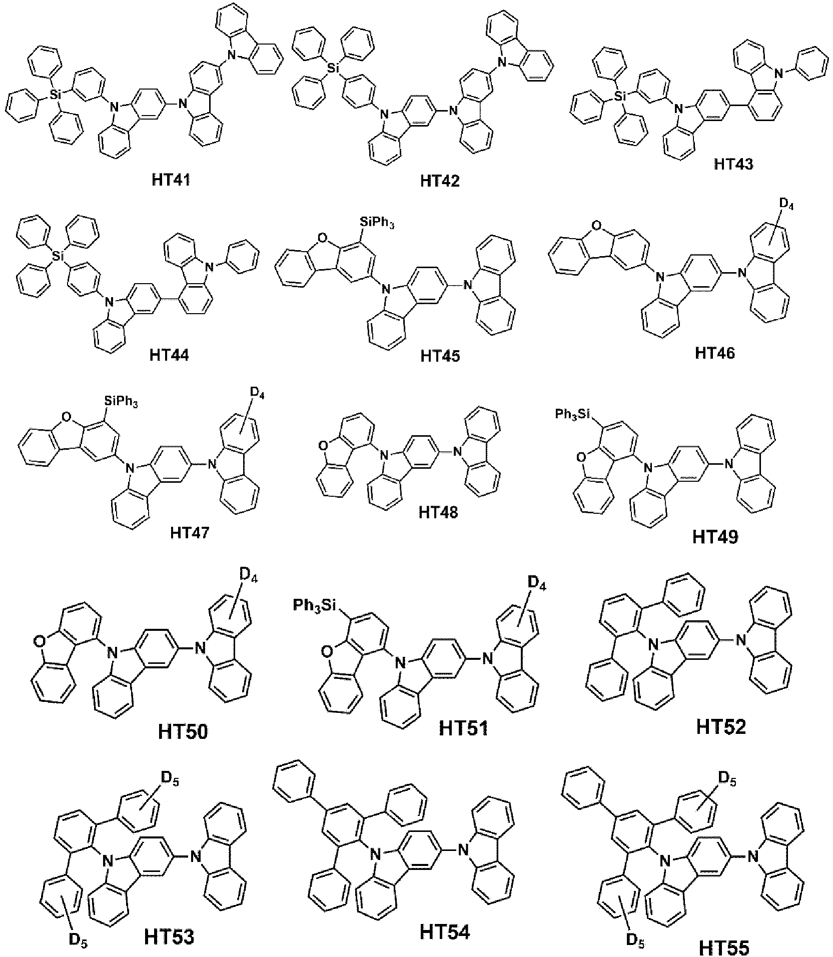

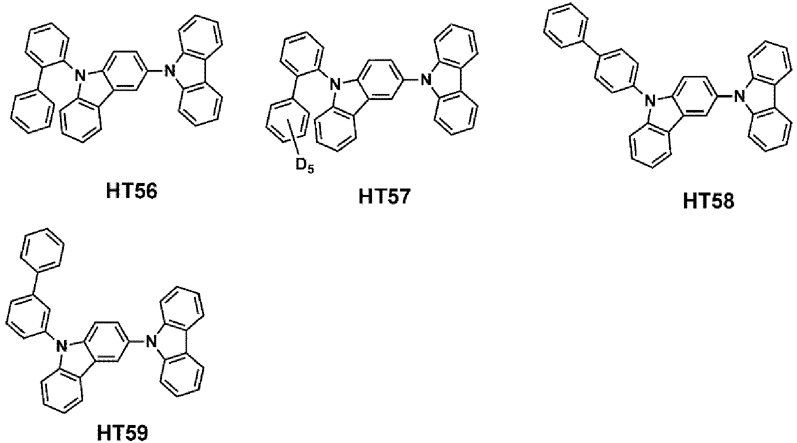

Among the specific compounds suggested in Compound Group 2, "D" may refer to a deuterium atom, and "Ph" may refer to a substituted or unsubstituted phenyl group. For example, among the specific compounds suggested in Compound Group 2, "Ph" may be an unsubstituted phenyl group.

In one or more embodiments, the emission layer EML may include a third compound represented by Formula ET-1. For example, the third compound may be utilized as an electron-transporting host material of the emission layer EML.

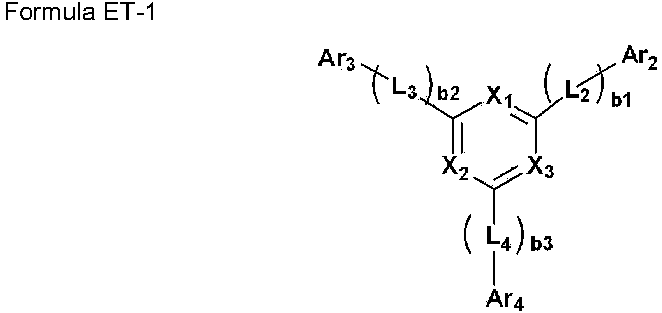

In Formula ET-1, X₁ to X₃ are each independently N or CR₅₆, and at least one selected from among X₁ to X₃ is N, (e.g., at least one selected from among X₁ to X₃ may be N, and the rest may be CR₅₆. For example, any one selected from among X₁ to X₃ may be N, and the rest (i.e., two remaining X₁ to X₃) may each independently be CR₅₆. In this case, the third compound, represented by Formula ET-1, may include a pyridine moiety. In some embodiments, two among X₁ to X₃ may be N, and the rest (i.e., one remaining X₁ to X₃) may be CR₅₆. In this case, the third compound, represented by Formula ET-1, may include a pyrimidine moiety. In some embodiments, X₁ to X₃ may be all N. In this case, the third compound, represented by Formula ET-1, may include a triazine moiety.

In Formula ET-1, R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 are each independently an integer of 0 to 10.

In Formula ET-1, Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may be a substituted or unsubstituted phenyl group, or a substituted or unsubstituted carbazole group.

In Formula ET-1, L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms. In some embodiments, when b1 to b3 are integers of 2 or more, L₂ to L₄ may each independently be a substituted or unsubstituted arylene group having 6 to 30 ring-forming carbon atoms, or a substituted or unsubstituted heteroarylene group having 2 to 30 ring-forming carbon atoms.

In one or more embodiments, the third compound may be represented by any one selected from among compounds of Compound Group 3. The light-emitting element ED according to one or more embodiments may include any one selected from among the compounds of Compound Group 3.

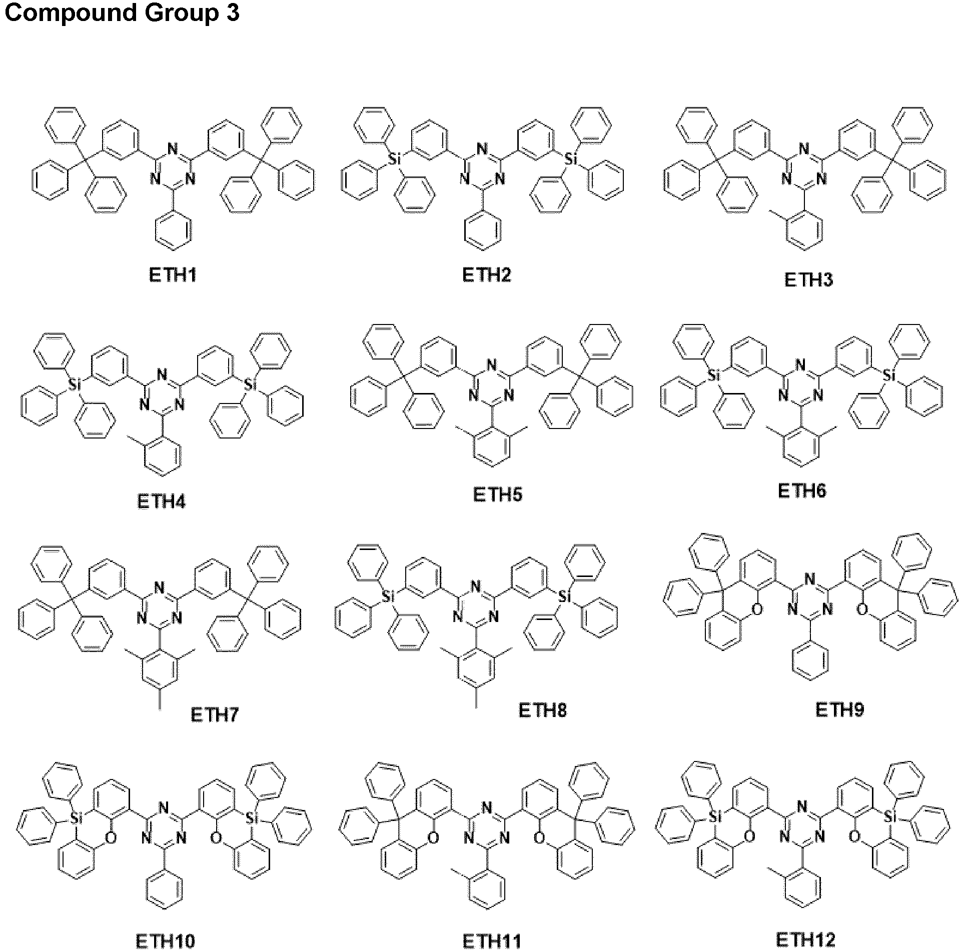

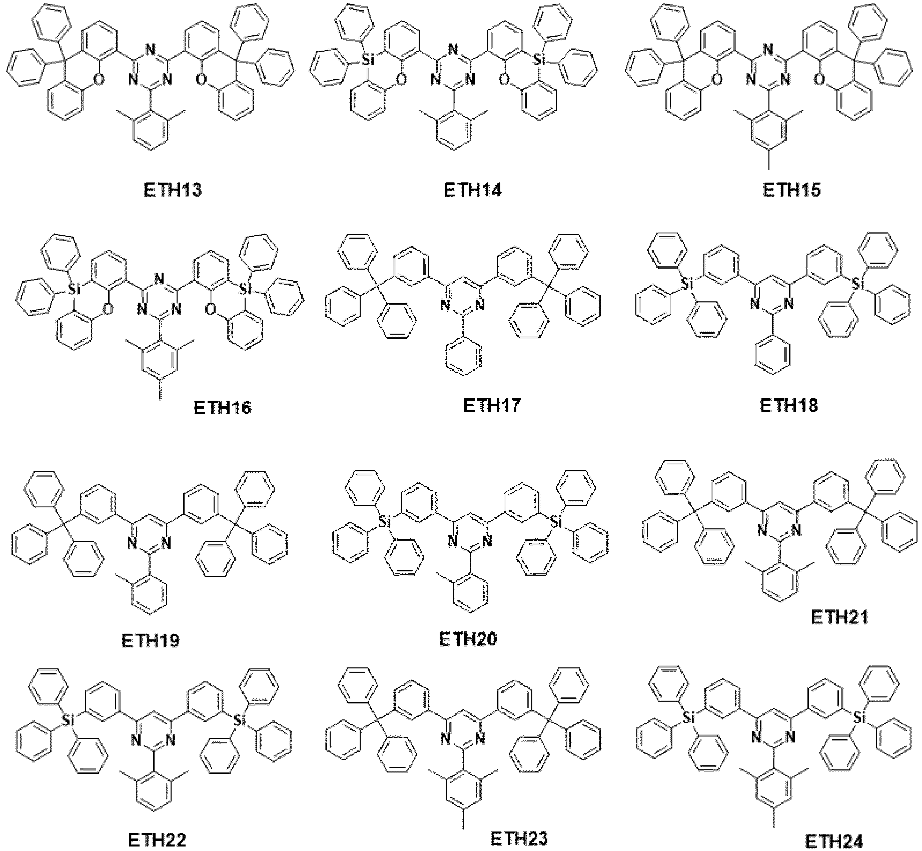

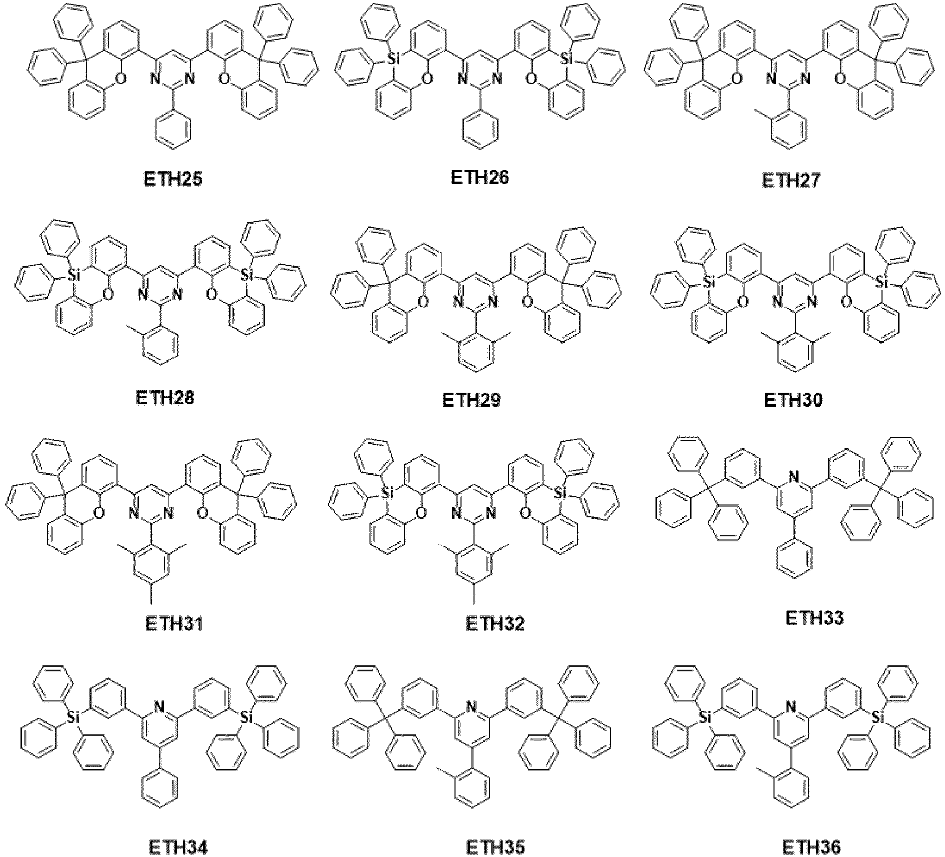

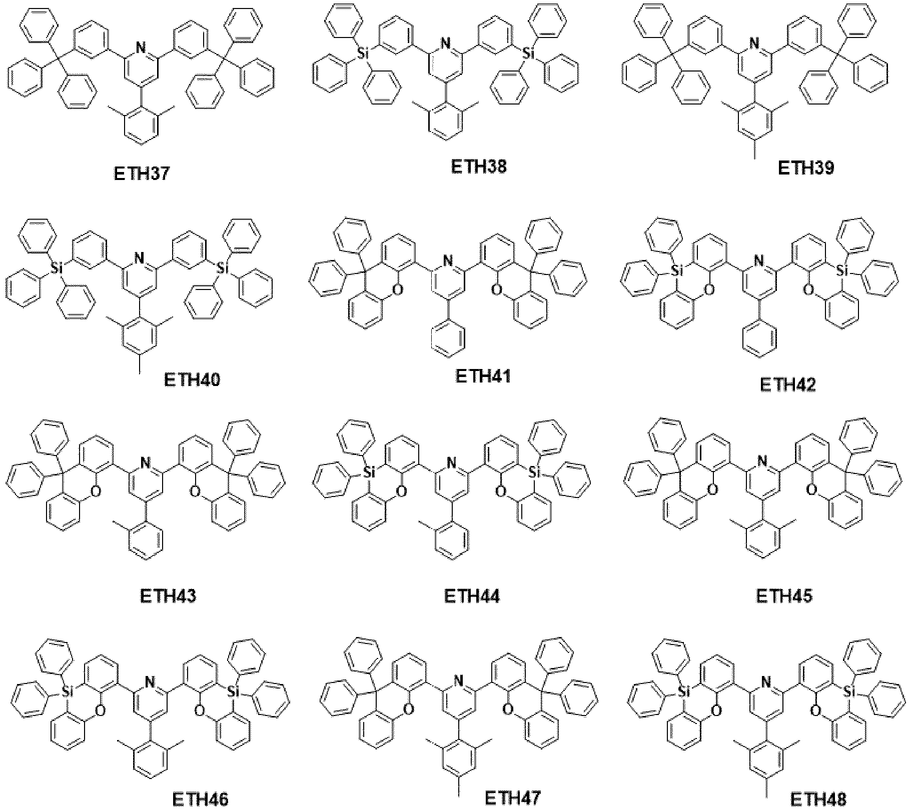

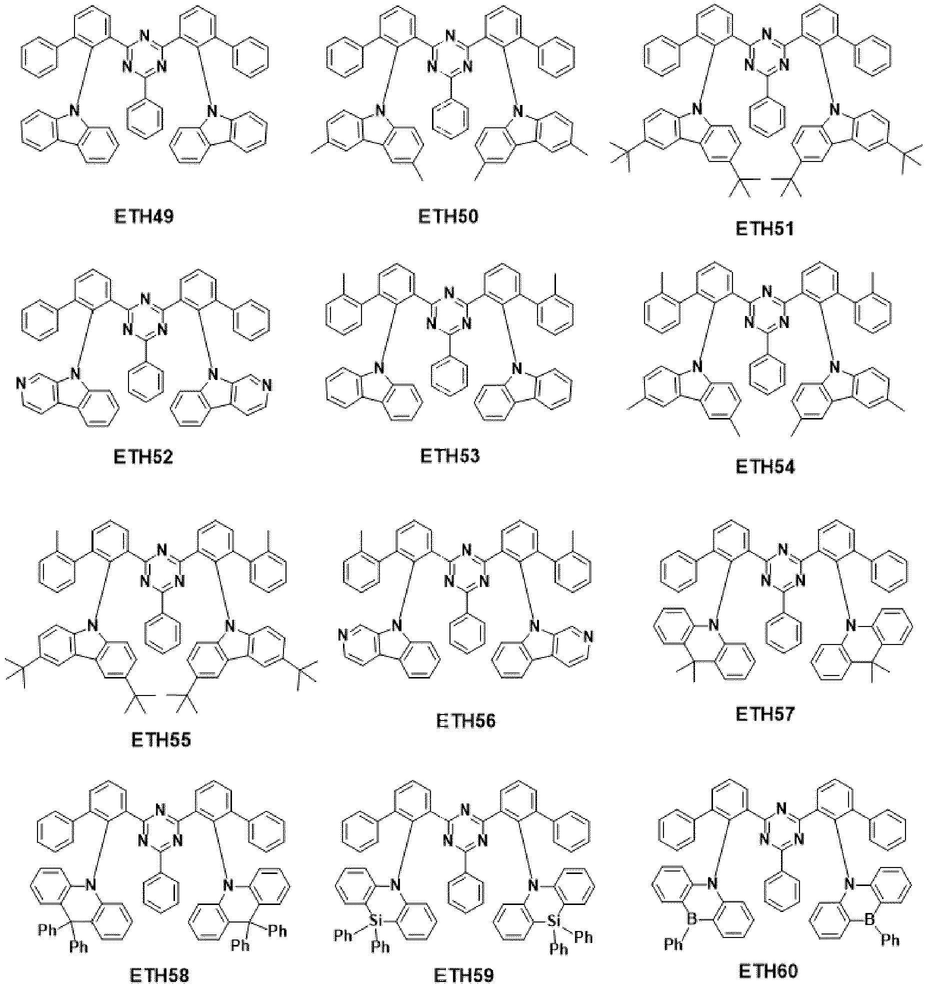

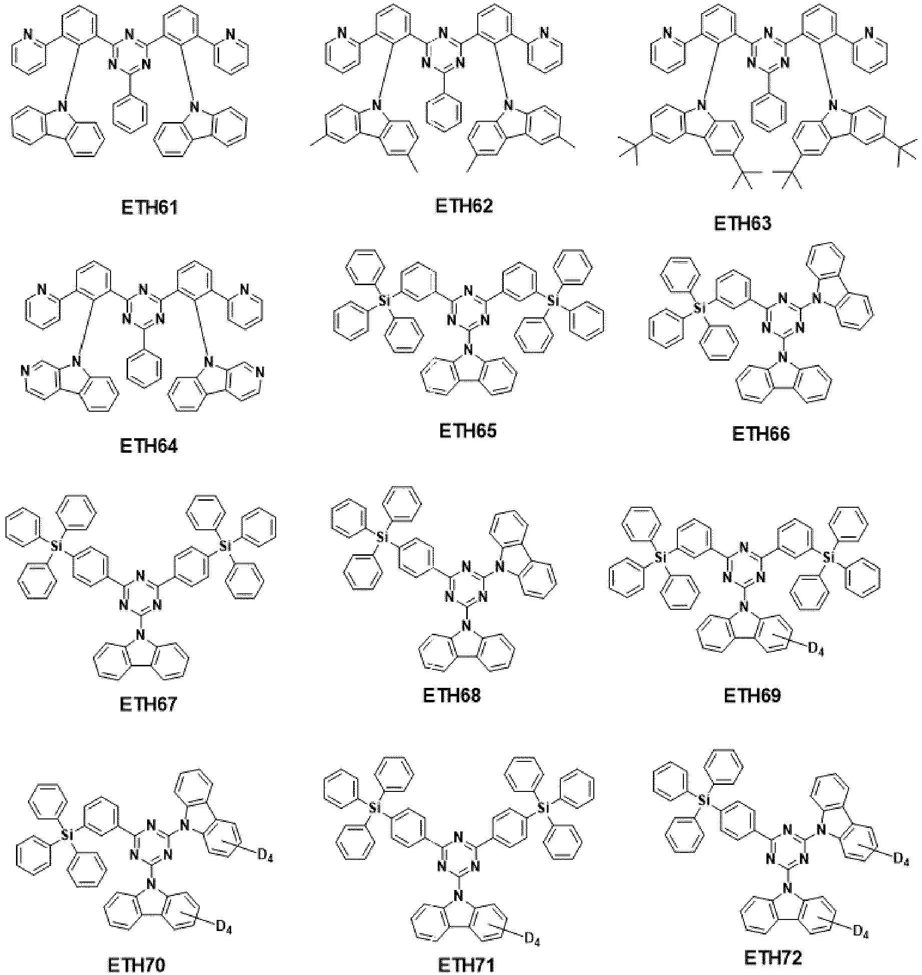

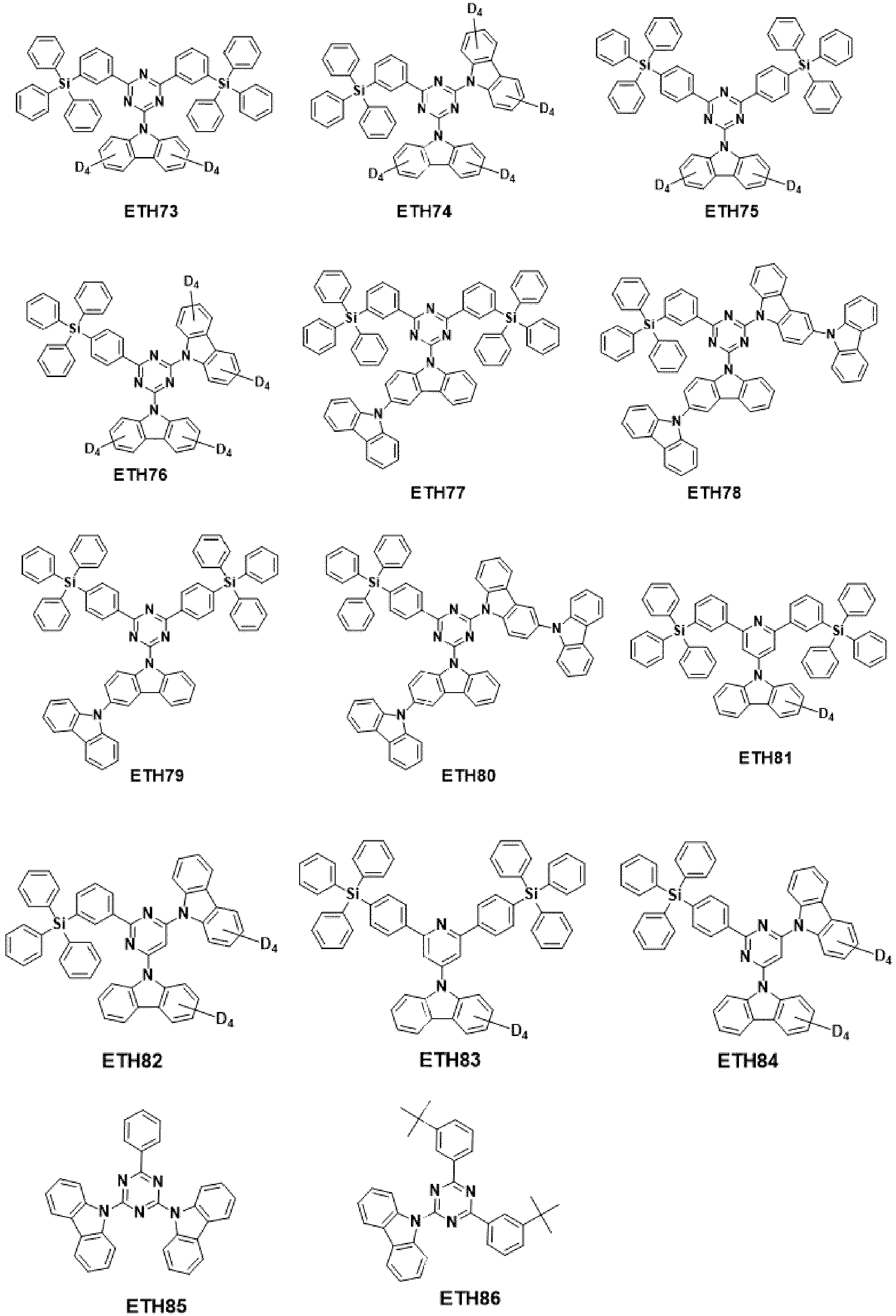

Among the (e.g., specific) compounds suggested in Compound Group 3, "D" refers to a deuterium atom, and "Ph" refers to an unsubstituted phenyl group.

The emission layer EML may include the second compound and the third compound, and the second compound and the third compound may form an exciplex. In the emission layer EML, the exciplex may be formed by a hole-transporting host and an electron-transporting host. In this case, the triplet energy of the exciplex, formed by the hole-transporting host and the electron-transporting host, may correspond to the difference in energy level between the lowest unoccupied molecular orbital (LUMO) of the electron-transporting host and the highest occupied molecular orbital (HOMO) of the hole-transporting host.

For example, the triplet (T1) energy level of the exciplex formed by the hole-transporting host and the electron-transporting host may have an absolute value of about 2.4 electron volt (eV) to about 3.0 eV. In some embodiments, the exciplex may have a smaller triplet energy value than the energy gap of each of host materials. The exciplex may have a triplet energy less than about 3.0 eV, which is the energy gap of each of the hole-transporting host and the electron-transporting host.

In one or more embodiments, the emission layer EML may further include a fourth compound in addition to the first compound to third compound previously described. The fourth compound may be utilized as a phosphorescent sensitizer of the emission layer EML. Energy transfer from the fourth compound to the first compound may cause light to be emitted.

For example, the emission layer EML may include an organometallic complex, which contains platinum (Pt) as a core metal atom and contains ligands bonded to the core metal atom, as the fourth compound. In the light-emitting element ED according to one or more embodiments, the emission layer EML may include a compound represented by Formula D-1 as the fourth compound.

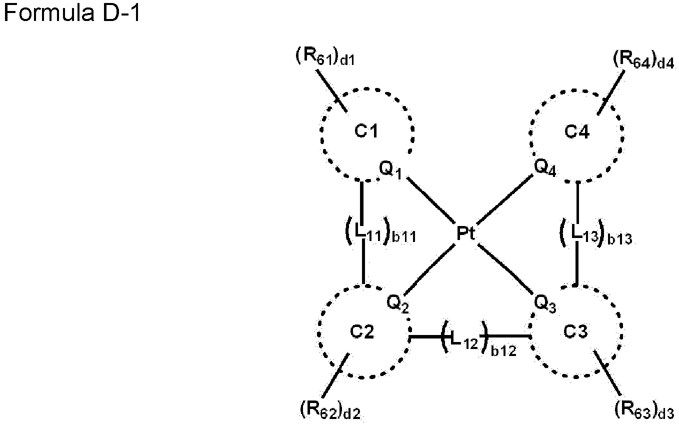

In Formula D-1, Q₁ to Q₄ are each independently C or N. C1 to C4 are each independently a substituted or unsubstituted hydrocarbon ring having 5 to 30 ring-forming carbon atoms, or a substituted or unsubstituted hetero ring having 2 to 30 ring-forming carbon atoms.

In Formula D-1, L₁₁ to L₁₃ are each independently a direct linkage, *-O-*, *-S-* , 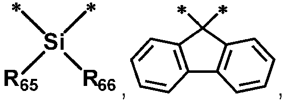 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, "-*" refers to a part connected to C1 to C4.

In Formula D-1, b11 to b13 are each independently 0 or 1. When b11 is 0, C1 and C2 may not be connected to each other. When b12 is 0, C2 and C3 may not be connected to each other. When b13 is 0, C3 and C4 may not be connected to each other.

In Formula D-1, R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In some embodiments, R₆₁ to R₆₆ may each be bonded to an adjacent group to form a ring. R₆₁ to R₆₆ may each independently be a substituted or unsubstituted methyl group, or a substituted or unsubstituted t-butyl group.

In Formula D-1, d1 to d4 are each independently an integer of 0 to 4. In Formula D-1, when each of d1 to d4 is 0, the fourth compound may be unsubstituted with R₆₁ to R₆₄. When each of d1 to d4 is 4, and each of R₆₁ to R₆₄ is a hydrogen atom, the case may be the same as the case where each of d1 to d4 is 0. When each of d1 to d4 is an integer of 2 or more, R₆₁ to R₆₄, each provided in plurality, may be all the same, or at least one (e.g., selected from) among R₆₁ to R₆₄, each provided in plurality, may be different (e.g., from the others).

In Formula D-1, C1 to C4 may each independently be a substituted or unsubstituted hydrocarbon ring, or a substituted or unsubstituted hetero ring, represented by any one selected from among C-1 to C-4.

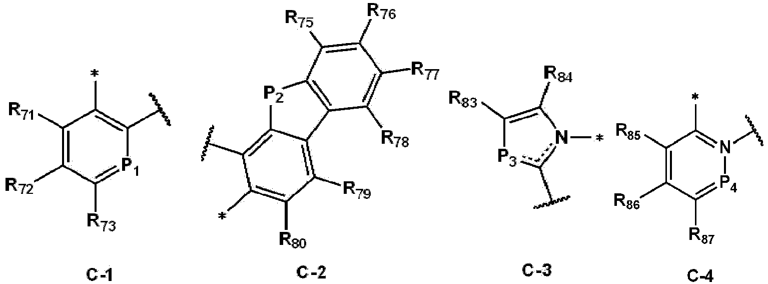

In C-1 to C-4, P₁ is C-* or CR₇₄, P₂ is N-* or NR₈₁, P₃ is N-* or NR₈₂, and P₄ is C-* or CR₈₈. R₇₁ to R₈₈ are each independently a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or bonded to an adjacent group to form a ring.

In some embodiments, in C-1 to C-4, " 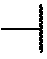 " is a part connected to Pt that is the core metal atom, and "-*" corresponds to a part connected to the adjacent ring groups (C1 to C4) or linkers L₁₁ to L₁₃.

The emission layer EML according to one or more embodiments may include the first compound which is the polycyclic compound, and at least one (e.g., selected from) among the second to fourth compounds. For example, the emission layer EML may include the first compound, the second compound, and the third compound. In the emission layer EML, the second compound and the third compound may form an exciplex, and energy transfer from the exciplex to the first compound may cause light to be emitted.

In some embodiments, the emission layer EML may include the first compound, the second compound, the third compound, and the fourth compound. In the emission layer EML, the second compound and the third compound may form an exciplex, and energy transfer from the fourth compound to the first compound may cause light to be emitted. In one or more embodiments, the fourth compound may be a sensitizer. In the light-emitting element ED according to one or more embodiments, the fourth compound, included in the emission layer EML, may serve as the sensitizer, and may thus perform transferring energy from a host to the first compound that is a luminescent dopant. For example, the fourth compound, which serves as an auxiliary dopant, may accelerate the energy transfer to the first compound, which is a luminescent dopant, and thus increase the luminescence rate of the first compound. Therefore, the emission layer EML according to one or more embodiments may have improved luminous efficiency. In some embodiments, when the energy transfer to the first compound increases, an exciton formed in the emission layer EML may be to emit light quickly without being accumulated inside the emission layer EML, and thus deterioration of the light-emitting element may be reduced. Therefore, the light-emitting element ED according to one or more embodiments may have improved lifespan.

The light-emitting element ED according to one or more embodiments may include all the first compound, the second compound, the third compound, and the fourth compound, and thus the emission layer EML may include two host materials and two dopant materials in combination. In the light-emitting element ED according to one or more embodiments, the emission layer EML may concurrently (e.g., simultaneously) include the second compound and the third compound that are two different hosts, the first compound that emits delayed fluorescence, and the fourth compound that includes an organometallic complex, thereby exhibiting excellent or suitable luminous efficiency characteristics.

In one or more embodiments, the fourth compound, represented by Formula D-1, may be represented by at least one (e.g., selected from) among compounds suggested in Compound Group 4. The emission layer EML may include at least one selected from among the compounds, suggested in Compound Group 4, as a sensitizer material.

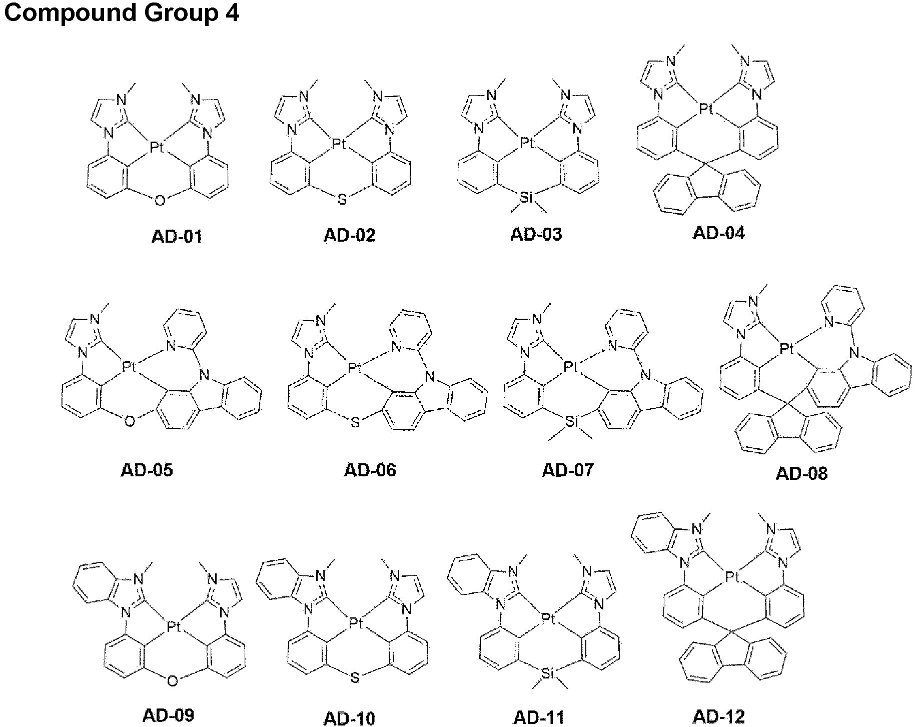

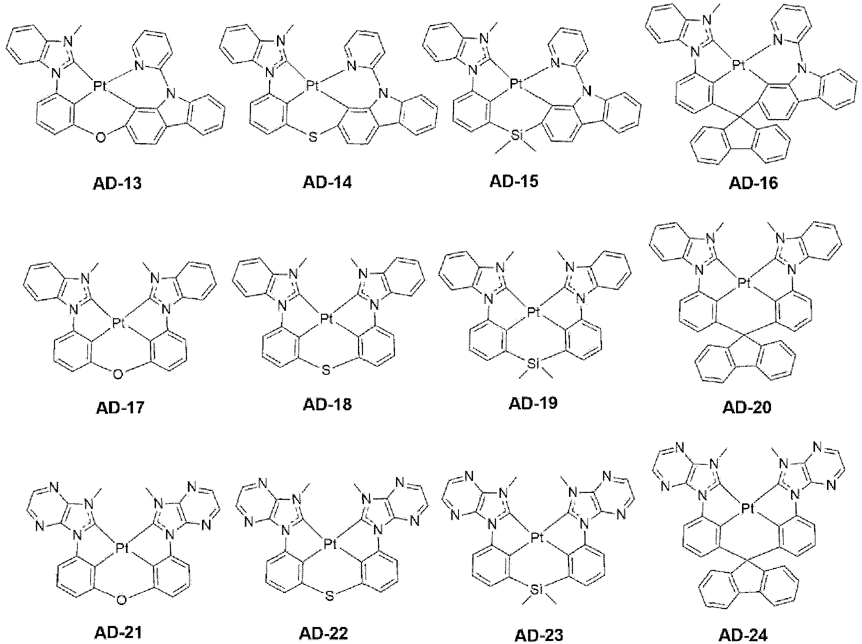

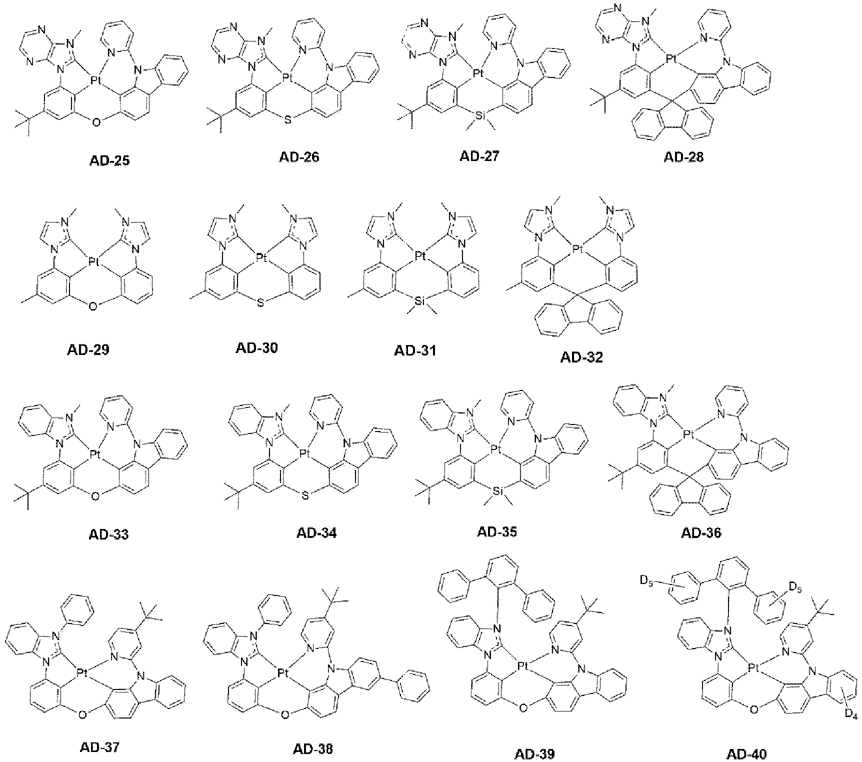

Among the (e.g., specific) compounds suggested in Compound Group 4, "D" refers to a deuterium atom.

In the light-emitting element ED according to one or more embodiments, when the emission layer EML includes all of the first compound, the second compound, and the third compound, previously described, the content (e.g., amount) of the first compound may be about 0.1 wt% to about 5 wt% with respect to the total weight of the first compound, the second compound, and the third compound. When the content (e.g., amount) of the first compound falls within the aforementioned ratio range, energy transfers from the second compound and the third compound to the first compound may increase, and accordingly, the luminous efficiency and the lifespan of the element may be increased.

In the emission layer EML, the content (e.g., amount) of the second compound and the third compound may be the remainder excluding the weight of the first compound. For example, in the emission layer EML, the content (e.g., amount) of the second compound and the third compound may be about 65 wt% to about 95 wt% with respect to the total weight of the first compound, the second compound, and the third compound.

A weight ratio of the second compound to the third compound with respect to the total weight of the second compound and the third compound may be about 3:7 to about 7:3.

When the content (e.g., amount) of the second compound and the third compound falls within the aforementioned ratio range, charge balance characteristics in the emission layer EML may be improved, and thus the luminous efficiency and the lifespan of the element may increase. When the content (e.g., amount) of the second compound and the third compound is out of the aforementioned ratio range, the charge balance in the emission layer EML may be disrupted, so that the luminous efficiency may be reduced, and the element may deteriorate easily.

When the emission layer EML includes the fourth compound, the content (e.g., amount) of the fourth compound may be about 10 wt% to about 30 wt% with respect to the total weight of the first compound, the second compound, the third compound, and the fourth compound. When the content (e.g., amount) of the fourth compound falls within the aforementioned content (e.g., amount) range, energy transfers from a host to the first compound, which is a luminescent dopant, may increase, so that the luminescence rate may be improved, and accordingly, the luminous efficiency of the emission layer EML may be improved. When the first compound, the second compound, the third compound, and the fourth compound, included in the emission layer EML, fall within the ranges of the aforementioned content (e.g., amount) ratio range, it may be possible to achieve excellent or suitable luminous efficiency and long lifespan.

The emission layer EML may have a thickness of, for example, about 100 Å to about 1000 Å, or about 100 Å to about 300 Å. The emission layer EML may have a single layer formed of a single material, a single layer formed of a plurality of different materials, or a multi-layer structure including a plurality of layers formed of a plurality of different materials.

In the light-emitting element ED, according to one or more embodiments, illustrated in FIGS. 3 to 7, the emission layer EML may include the aforementioned polycyclic compound, according to one or more embodiments, as a dopant. In some embodiments, in the light-emitting element ED, according to one or more embodiments, illustrated in FIGS. 3 to 7, the emission layer EML may include the first compound that is the polycyclic compound according to one or more embodiments, and at least one selected from among the second compound represented by Formula HT-1 and the third compound represented by Formula ET-1. In some embodiments, in the light-emitting element ED, according to one or more embodiments, illustrated in FIGS. 3 to 7, the emission layer EML may include the first compound that is the polycyclic compound according to one or more embodiments, the second compound represented by Formula HT-1, the third compound represented by Formula ET-1, and the fourth compound represented by Formula D-1.

In the light emitting element ED of one or more embodiments, the emission layer EML may further include an anthracene derivative, a pyrene derivative, a fluoranthene derivative, a chrysene derivative, a dihydrobenzanthracene derivative, and/or a triphenylene derivative. For example, the emission layer EML may further include the anthracene derivative and/or the pyrene derivative.

In each light emitting element ED of embodiments illustrated in FIGS. 3 to 7, the emission layer EML may include a host and a dopant, and for example the emission layer EML may further include a compound represented by Formula E-1.

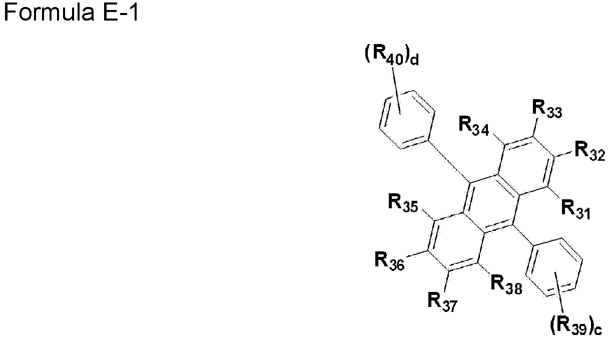

In Formula E-1, R₃₁ to R₄₀ are each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In some embodiments, R₃₁ to R₄₀ may be bonded to an adjacent group to form a saturated hydrocarbon ring or an unsaturated hydrocarbon ring, a saturated heterocycle, or an unsaturated heterocycle.

In Formula E-1, c and d are each independently an integer of 0 to 5.

Formula E-1 may be represented by any one selected from among Compound E1 to Compound E19.

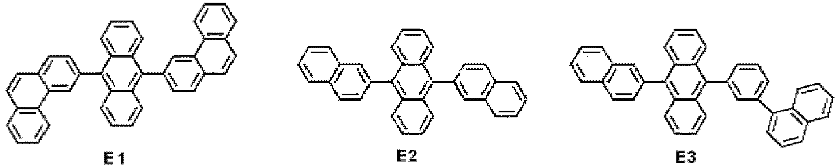

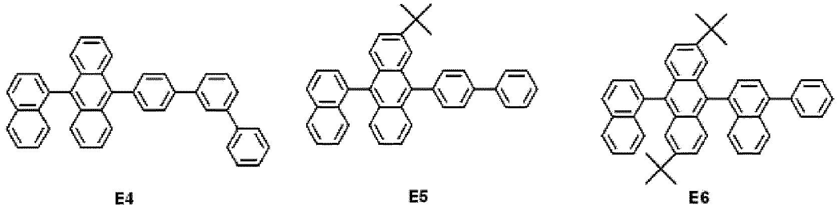

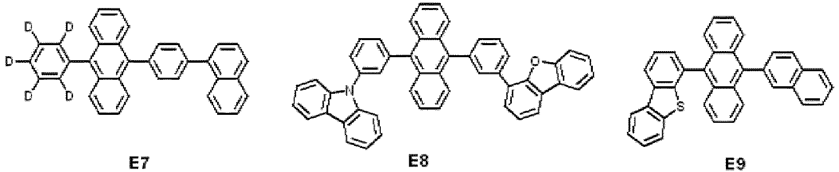

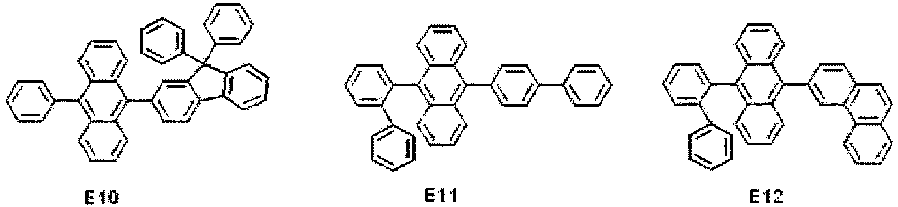

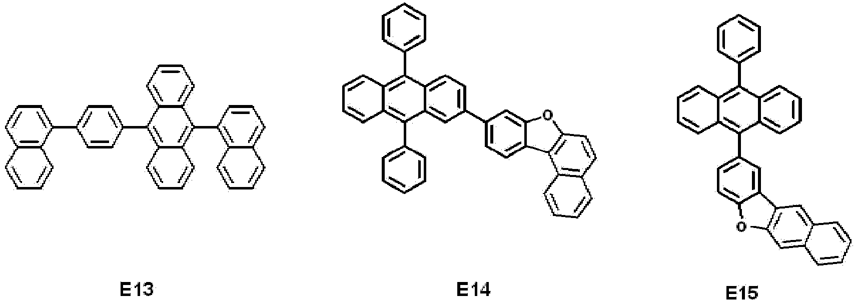

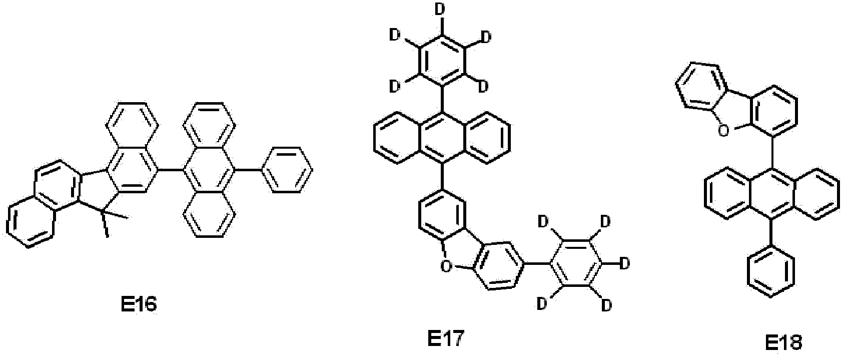

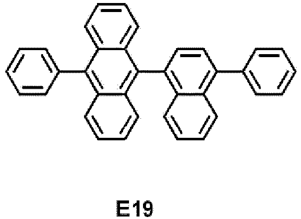

In one or more embodiments, the emission layer EML may further include a compound represented by Formula E-2a or Formula E-2b. The compound represented by Formula E-2a or Formula E-2b may be utilized as a phosphorescent host material.

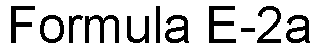

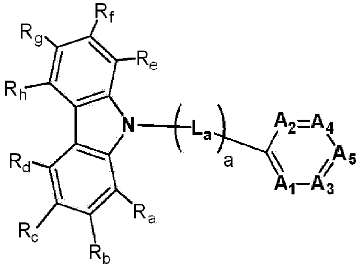

In Formula E-2a, a is an integer of 0 to 10, and Lₐ is a direct linkage, a substituted or unsubstituted arylene group having 6 to 30 ring-forming carbon atoms, or a substituted or unsubstituted heteroarylene group having 2 to 30 ring-forming carbon atoms. In some embodiments, when a is an integer of 2 or greater, a plurality of Lₐ's may each independently be a substituted or unsubstituted arylene group having 6 to 30 ring-forming carbon atoms, or a substituted or unsubstituted heteroarylene group having 2 to 30 ring-forming carbon atoms.

In some embodiments, in Formula E-2a, A₁ to A₅ are each independently N or CRᵢ. Rₐ to Rᵢ are each independently a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. Rₐ to Rᵢ may be bonded to an adjacent group to form a hydrocarbon ring or a heterocycle containing N, O, S, and/or the like, as a ring-forming atom.

In some embodiments, in Formula E-2a, two or three selected from among A₁ to A₅ may be N, and the rest (i.e., each of any remaining A₁ to A₅) may be CRᵢ.

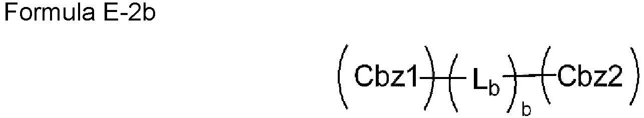

In Formula E-2b, Cbz1 and Cbz2 are each independently an unsubstituted carbazole group, or a carbazole group substituted with an aryl group having 6 to 30 ring-forming carbon atoms. L_{b} is a direct linkage, a substituted or unsubstituted arylene group having 6 to 30 ring-forming carbon atoms, or a substituted or unsubstituted heteroarylene group having 2 to 30 ring-forming carbon atoms. In some embodiments, b is an integer of 0 to 10, and when b is an integer of 2 or more, a plurality of L_{b}'s may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2a or Formula E-2b may be represented by any one selected from among the compounds of Compound Group E-2. However, the compounds listed in Compound Group E-2 are examples, and the compound represented by Formula E-2a or Formula E-2b is not limited to those represented in Compound Group E-2.

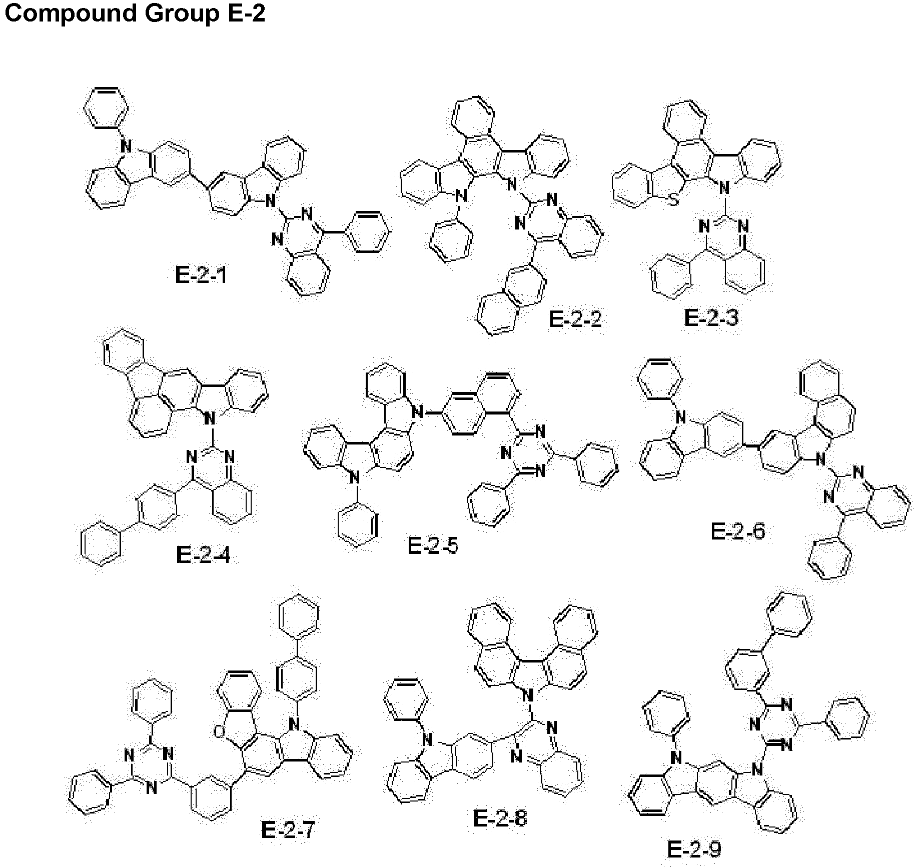

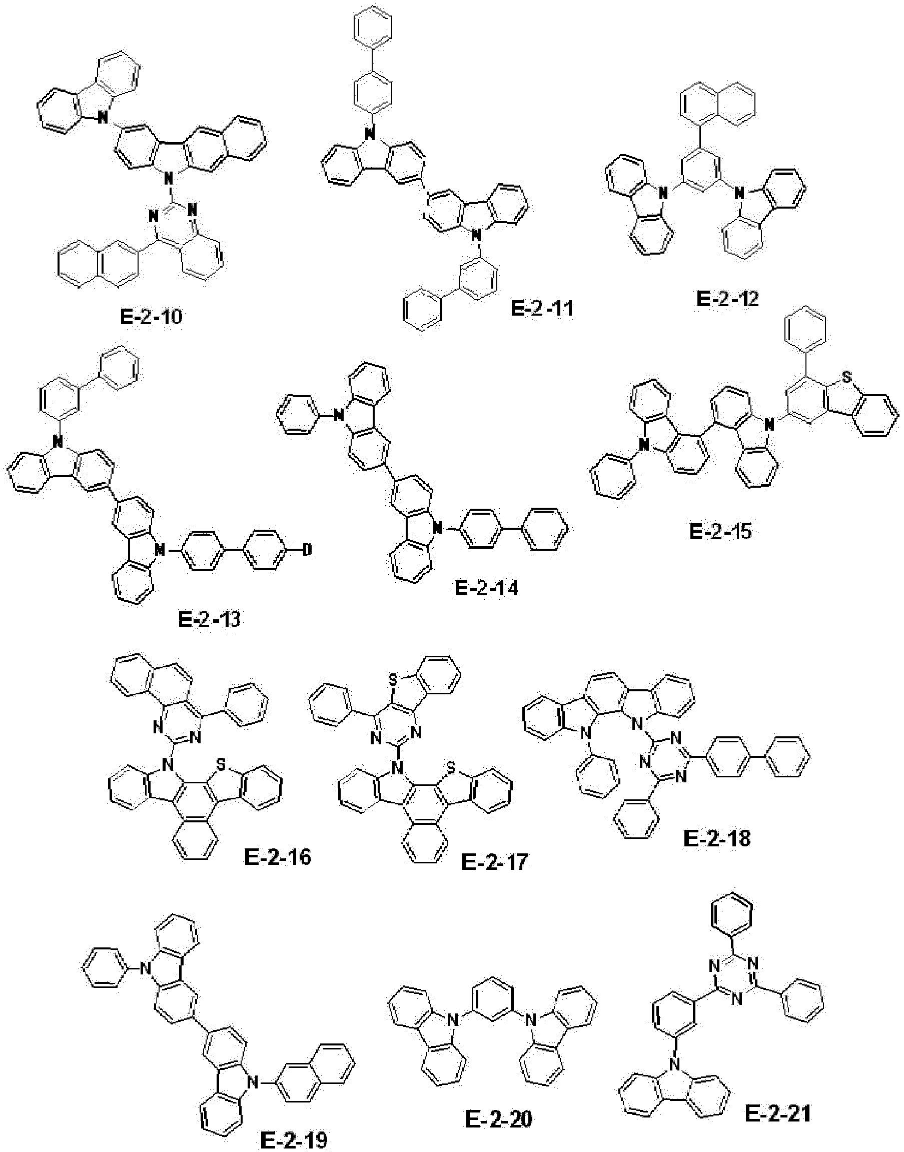

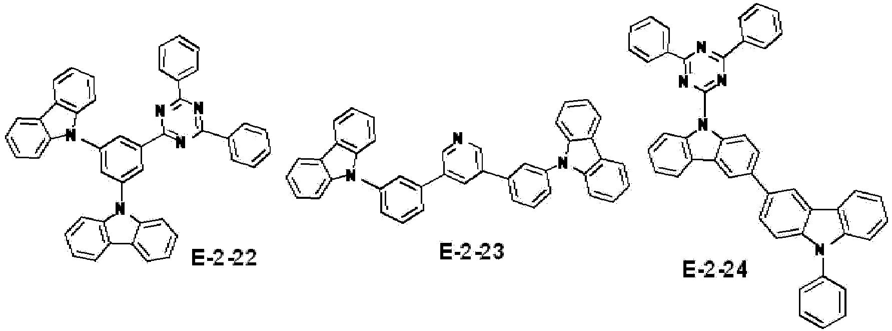

The emission layer EML may include the compound represented by Formula M-a. The compound represented by Formula M-a may be utilized as a phosphorescent dopant material.

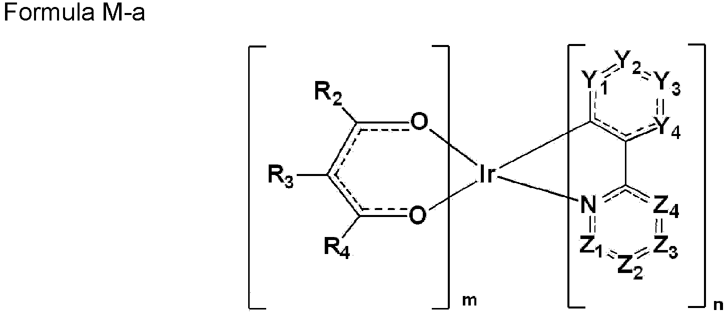

In Formula M-a herein, Y₁ to Y₄ and Z₁ to Z₄ are each independently CR₁ or N, R₁ to R₄ are each independently a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In Formula M-a, m is 0 or 1, and n is 2 or 3. In Formula M-a, when m is 0, n is 3, and when m is 1, n is 2.

The compound represented by Formula M-a may be utilized as a phosphorescent dopant.

The compound represented by Formula M-a may be represented by any one among Compound M-a1 to Compound M-a25. However, Compounds M-a1 to M-a25 are examples, and the compound represented by Formula M-a is not limited to those represented by Compounds M-a1 to M-a25.

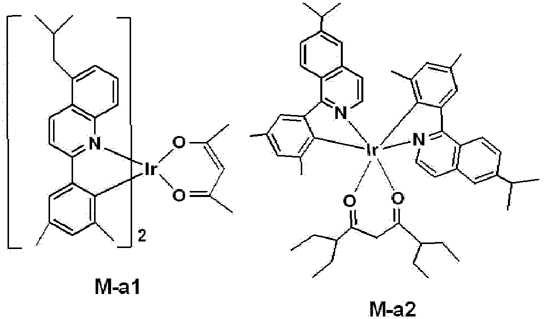

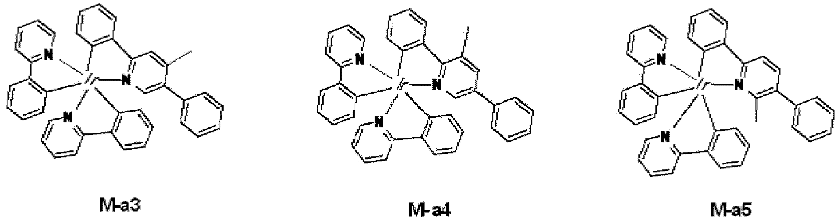

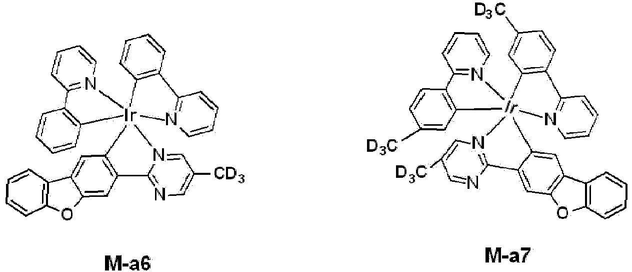

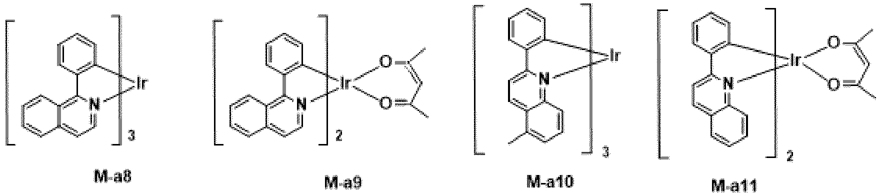

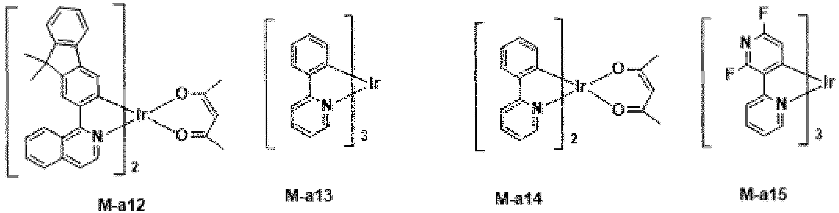

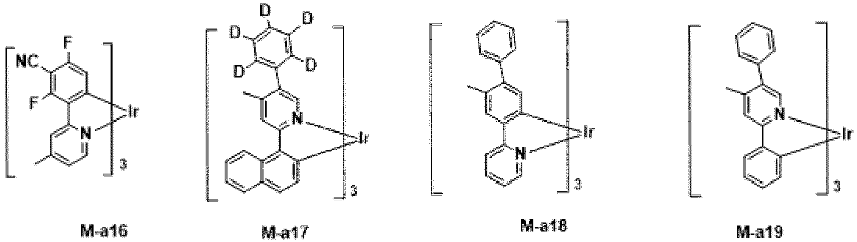

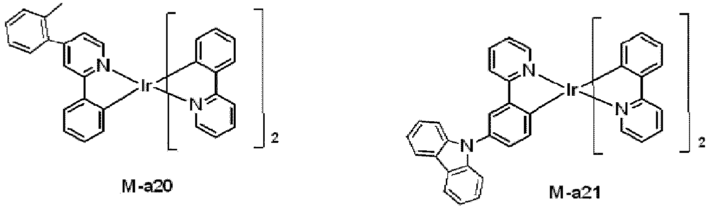

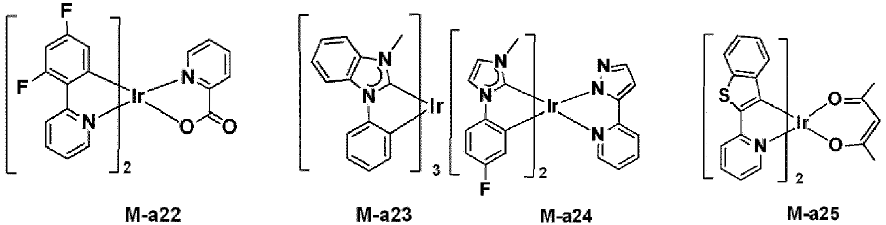

The emission layer EML may further include a compound represented by any one selected from among Formula F-a to Formula F-c. The compound represented by Formula F-a to Formula F-c may be utilized as a fluorescence dopant material.

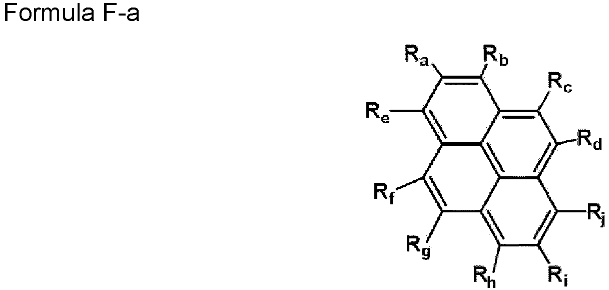

In Formula F-a herein, two selected from among Rₐ to Rⱼ are each independently substituted with *-NAr₁Ar₂. The others, which are not substituted with *-NAr₁Ar₂, among Rₐ to Rⱼ are each independently a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ are each independently a substituted or unsubstituted aryl group having 6 to 30 ring-forming carbon atoms, or a substituted or unsubstituted heteroaryl group having 2 to 30 ring-forming carbon atoms. For example, at least one of Ar₁ or Ar₂ may be a heteroaryl group containing O or S as a ring-forming atom.

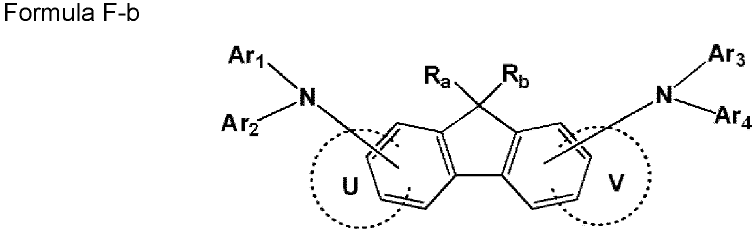

In Formula F-b herein, Rₐ and R_{b} are each independently a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. Ar₁ to Ar₄ are each independently a substituted or unsubstituted aryl group having 6 to 30 ring-forming carbon atoms, or a substituted or unsubstituted heteroaryl group having 2 to 30 ring-forming carbon atoms.

In Formula F-b, U and V are each independently a substituted or unsubstituted hydrocarbon ring having 5 to 30 ring-forming carbon atoms, or a substituted or unsubstituted heterocycle having 2 to 30 ring-forming carbon atoms. At least one selected from among Ar₁ to Ar₄ may be a heteroaryl group containing O or S as a ring-forming atom.

In Formula F-b, the number of rings represented by U and V may each independently be 0 or 1. For example, in Formula F-b, it refers to that when the number of U or V is 1, one ring constitutes a fused ring at a portion indicated by U or V, and when the number of U or V is 0, a ring indicated by U or V does not exist. For example, when the number of U is 0 and the number of V is 1, or when the number of U is 1 and the number of V is 0, the fused ring having a fluorene core in Formula F-b may be a cyclic compound having four rings. In some embodiments, when each number of U and V is 0, the fused ring in Formula F-b may be a cyclic compound having three rings. In some embodiments, when each number of U and V is 1, the fused ring having a fluorene core in Formula F-b may be a cyclic compound having five rings.

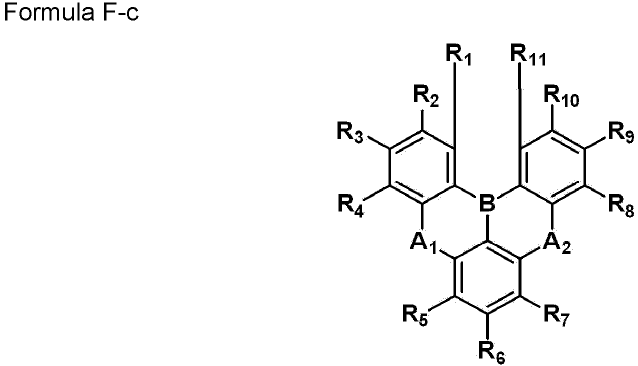

In Formula F-c, A₁ and A₂ are each independently O, S, Se, or NRₘ, and Rₘ is a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring.

In Formula F-c, A₁ and A₂ may each independently be bonded to substituents of an adjacent ring to form a fused ring. For example, when A₁ and A₂ may each independently be NRₘ, A₁ may be bonded to R₄ or R₅ to form a ring. In some embodiments, A₂ may be bonded to R₇ or R₈ to form a ring.

In one or more embodiments, the emission layer EML may further include, as a suitable dopant material, at least one selected from among a styryl derivative (*e.g*., 1,4-bis[2-(3-N-ethylcarbazolyl)vinyl]benzene (BCzVB), 4-(di-p-tolylamino)-4'-[(dip-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and a derivative thereof (*e.g*., 2,5,8,11-tetra-t-butylperylene (TBP)), pyrene and a derivative thereof (*e.g.*, 1,1-dipyrene, 1,4-dipyrenylbenzene, 1,4-bis(N,N-diphenylamino)pyrene), and/or the like.

The emission layer EML may further include a suitable phosphorescence dopant material. For example, a metal complex containing iridium (Ir), platinum (Pt), osmium (Os), gold (Au), titanium (Ti), zirconium (Zr), hafnium (Hf), europium (Eu), terbium (Tb), or thulium (Tm) may be utilized as a phosphorescent dopant. For example, iridium(III) bis(4,6-difluorophenylpyridinato- C2,N)picolinate (FIrpic), bis(2,4-difluorophenylpyridinato)-tetrakis(1-pyrazolyl)borate iridium(III) (FIr6), or platinum octaethyl porphyrin (PtOEP) may be utilized as a phosphorescent dopant.

The emission layer EML may include a quantum dot material. The core of the quantum dots may be selected from a Group II-VI compound, a Group I-II-VI compound, a Group II-IV-VI compound, a Group I-II-IV-VI compound, a Group II-IV-V compound, a Group III-VI compound, a Group I-III-VI compound, a Group III-V compound, a Group III-II-V compound, a Group IV-VI compound, a Group IV element, a Group IV compound, and a combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a mixture thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, and a mixture thereof.

The Group III-VI compound may include a binary compound such as In₂S₃ or In₂Se₃, a ternary compound such as InGaS₃ or InGaSe₃, or any combination thereof.

The Group I-III-VI compound may be selected from a ternary compound selected from the group consisting of AgInS, AgInS₂, CuInS, CuInS₂, AgGaS₂, CuGaS₂ CuGaO₂, AgGaO₂, AgAlO₂, and a mixture thereof, or a quaternary compound such as AgInGaS₂ or CuInGaS₂.

The Group III-V compound may be selected from the group consisting of a binary compound selected from the group consisting of GaN, GaP, GaAs, GaSb, AIN, AlP, AlAs, AlSb, InN, InP, InAs, InSb, and a mixture thereof, a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and a mixture thereof, and a quaternary compound selected from the group consisting of GaAlNP, GaAINAs, GaAINSb, GaAlPAs, GaAlPSb, GaInNP, GaInNAs, GaInNSb, GaInPAs, GaInPSb, InAINP, InAINAs, InAINSb, InAlPAs, InAlPSb, and a mixture thereof. In some embodiments, the Group III-V compound may further include a Group II metal. For example, InZnP, and/or the like, may be selected as a Group III-II-V compound.

The Group IV-VI compound may be selected from the group consisting of a binary compound selected from the group consisting of SnS, SnSe, SnTe, PbS, PbSe, PbTe, and a mixture thereof, a ternary compound selected from the group consisting of SnSeS, SnSeTe, SnSTe, PbSeS, PbSeTe, PbSTe, SnPbS, SnPbSe, SnPbTe, and a mixture thereof, and a quaternary compound selected from the group consisting of SnPbSSe, SnPbSeTe, SnPbSTe, and a mixture thereof. The Group IV element may be selected from the group consisting of Si, Ge, and a mixture thereof. The Group IV compound may be a binary compound selected from the group consisting of SiC, SiGe, and a mixture thereof.

Each element included in a polynary (i.e., multi-element) compound such as the binary compound, the ternary compound, or the quaternary compound may be present in a particle with a substantially uniform or non-substantially uniform concentration distribution. For example, the formulae refer to the types (kinds) of elements included in the compounds, and the elemental ratio in the compound may be different. For example, AgInGaS₂ may refer to AgInₓGa₁₋ₓS₂ (where x is a real number of 0 to 1).

In some embodiments, the quantum dot may have a single structure or a double structure of core-shell in which the concentration of each element included in the quantum dot is substantially uniform. For example, the material included in the core may be different from the material included in the shell.

The shell of the quantum dot may serve as a protection layer to prevent or reduce the chemical deformation of the core to maintain semiconductor properties, and/or a charging layer to impart electrophoresis properties to the quantum dot. The shell may be a single layer or a multilayer. An interface between the core and the shell may have a concentration gradient in which the concentration of an element present in the shell becomes lower towards the center.

An example of the shell of the quantum dots may include a metal or non-metal oxide, a semiconductor compound, or a combination thereof. For example, the metal or non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO, or a ternary compound such as MgAl₂O₄, CoFe₂O₄, NiFe₂O₄, or CoMn₂O₄.

Also, examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like.

Each element included in a polynary compound such as the binary compound, or the ternary compound may be present in a particle with a substantially uniform or non-substantially uniform concentration distribution. For example, the formulae refer to the types (kinds) of elements included in the compounds, and the elemental ratio in the compound may be different.

The quantum dot may have a full width of half maximum (FWHM) of an emission wavelength spectrum of about 45 nm or less, about 40 nm or less, and more about 30 nm or less, and color purity or color reproducibility may be improved in the above range. In some embodiments, light emitted through such a quantum dot is emitted in all directions, and thus a wide viewing angle may be improved.

In some embodiments, although the form of the quantum dot is not particularly limited as long as it is a form commonly utilized in the art, more specifically, the quantum dot in the form of spherical, pyramidal, multi-arm, or cubic nanoparticles, nanotubes, nanowires, nanofibers, nanoplate particles, and/or the like may be utilized.

As the size of the quantum dot is adjusted or the elemental ratio in the quantum dot compound is adjusted, it may be possible to control the energy band gap, and thus light in one or more suitable wavelength ranges may be obtained in the quantum dot emission layer. Therefore, the quantum dot as described herein (utilizing different sizes of quantum dots or different elemental ratios in the quantum dot compound) may be utilized, and thus the light emitting element, which emits light in one or more suitable wavelengths, may be implemented. For example, the adjustment of the size of the quantum dot or the elemental ratio in the quantum dot compound may be selected to emit red, green, and/or blue light. In some embodiments, the quantum dots may be configured to emit white light by combining one or more suitable colors of light.

In each of the light emitting elements ED of embodiments illustrated in FIGS. 3 to 7, the electron transport region ETR is provided on the emission layer EML. The electron transport region ETR may include at least one of the hole blocking layer HBL, the electron transport layer ETL, or the electron injection layer EIL.

The electron transport region ETR may have a single layer formed of a single material, a single layer formed of a plurality of different materials, or a multilayer structure including a plurality of layers formed of a plurality of different materials.

For example, the electron transport region ETR may have a single layer structure of the electron injection layer EIL or the electron transport layer ETL, and may have a single layer structure formed of an electron injection material and an electron transport material. In some embodiments, the electron transport region ETR may have a single layer structure formed of a plurality of different materials, or may have a structure in which an electron transport layer ETL/electron injection layer EIL, a hole blocking layer HBL/electron transport layer ETL/electron injection layer EIL are stacked in order from the emission layer EML. The electron transport region ETR may have a thickness, for example, from about 1,000 Å to about 1,500 Å.

The electron transport region ETR may be formed utilizing one or more suitable methods such as a vacuum deposition method, a spin coating method, a cast method, a Langmuir-Blodgett (LB) method, an inkjet printing method, a laser printing method, and/or a laser induced thermal imaging (LITI) method.

The electron transport region ETR may include a compound represented by Formula ET-2.

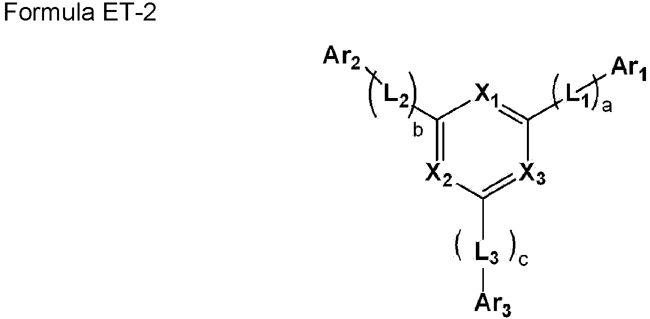

In Formula ET-2, at least one selected from among X₁ to X₃ is N, and the rest (e.g., any remaining one, or each of the remaining, X₁ to X₃) are CRₐ. Rₐ is a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c are each independently an integer of 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. In some embodiments, when a to c may each independently be an integer of 2 or more, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

The electron transport region ETR may include an anthracene-based compound. The electron transport region ETR may include, for example, tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), beryllium bis(benzoquinolin-10-olate) (Bebq₂), 9,10-di(naphthalene-2-yl)anthracene (ADN), 1,3-bis[3,5-di(pyridin-3-yl)phenyl]benzene (BmPyPhB), or a mixture thereof.

The electron transport region ETR may include at least one selected from among Compound ET1 to Compound ET36.

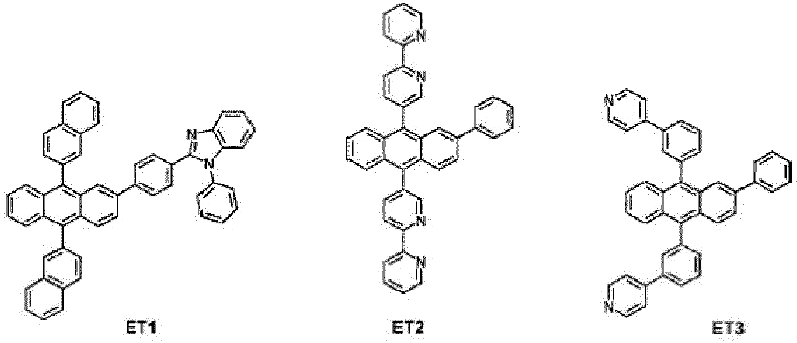

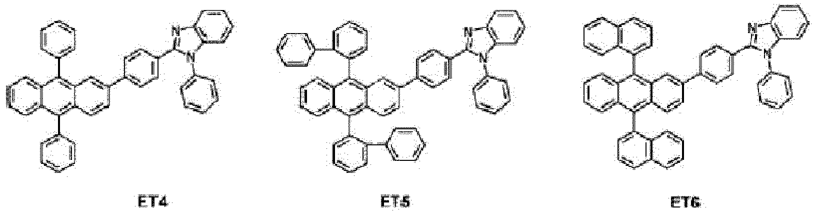

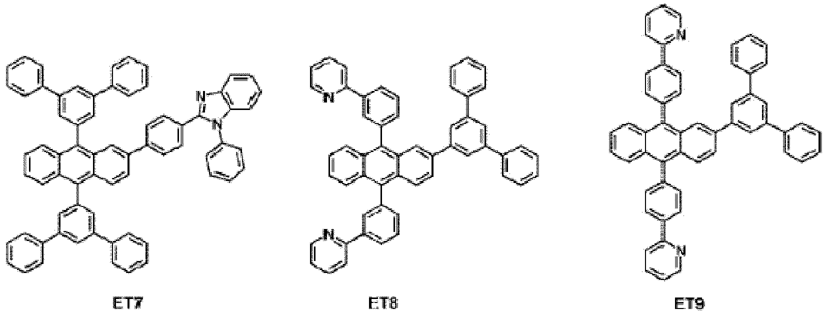

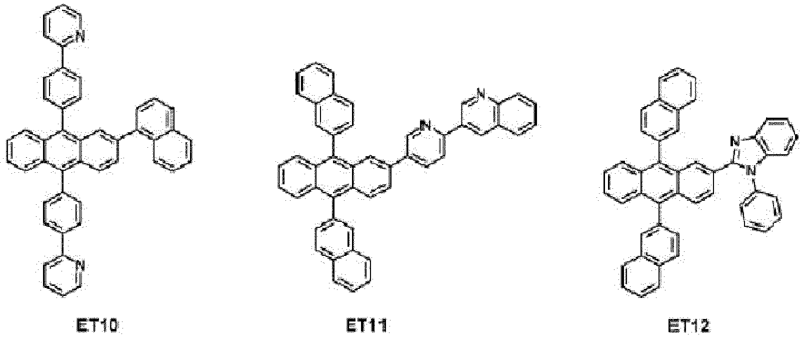

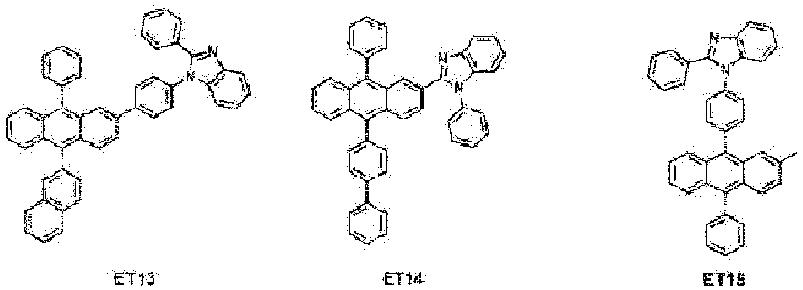

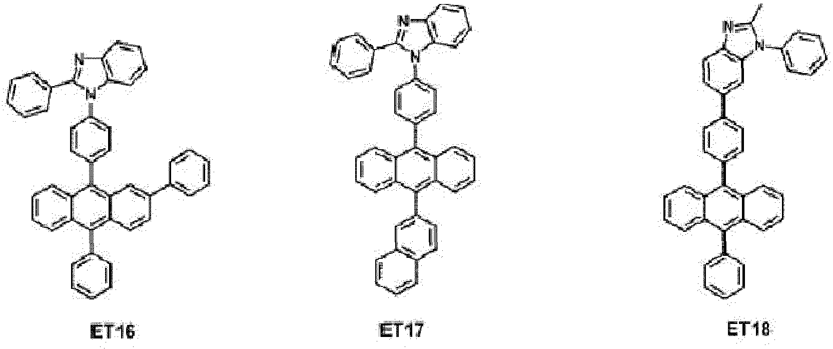

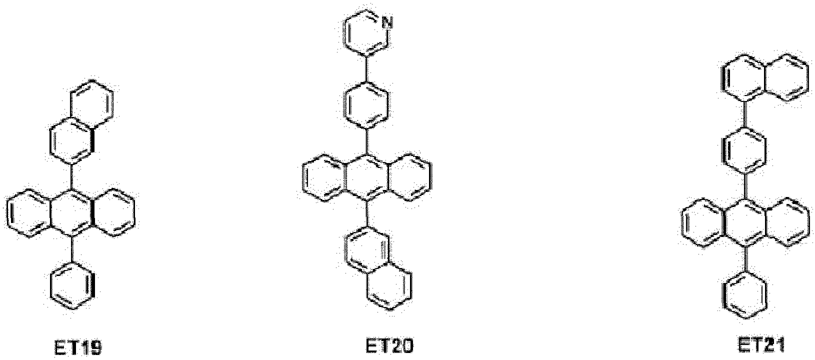

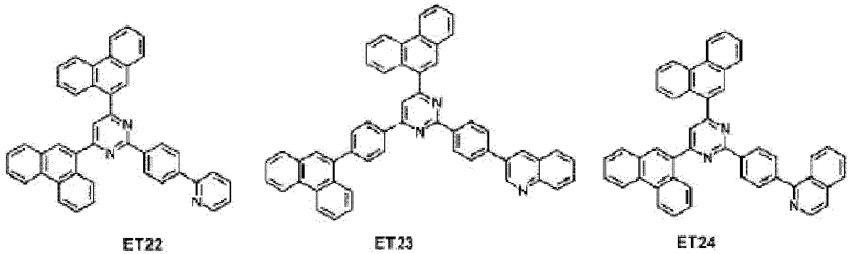

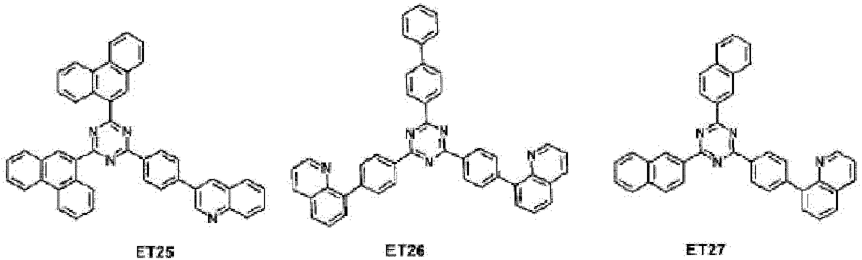

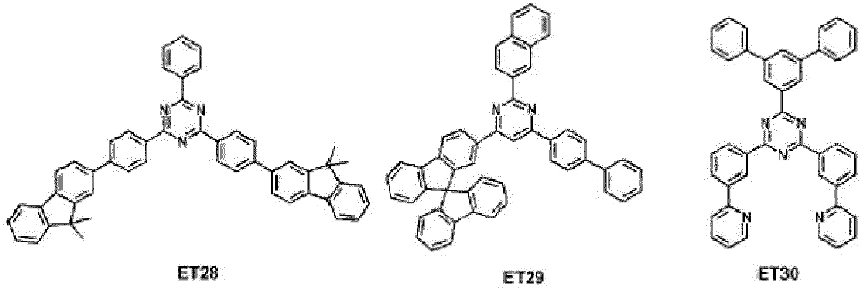

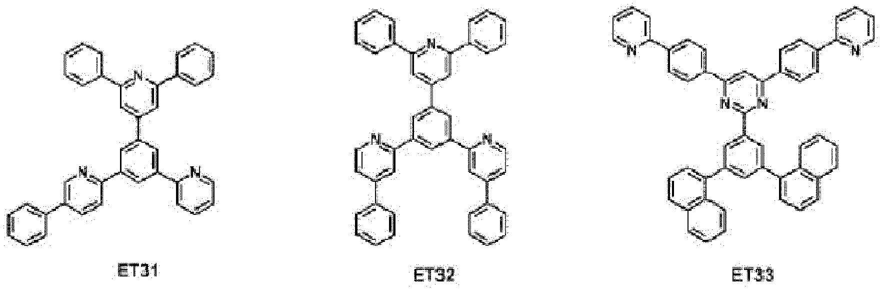

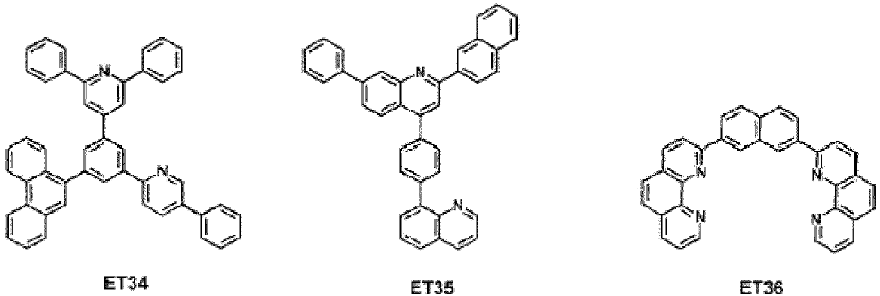

In some embodiments, the electron transport region ETR may include a metal halide such as LiF, NaCl, CsF, RbCl, RbI, Cul, and KI, a lanthanide metal such as Yb, and a co-deposited material of the metal halide and the lanthanide metal. For example, the electron transport region ETR may include KI:Yb, Rbl:Yb, LiF:Yb, and/or the like, as a co-deposited material. In some embodiments, the electron transport region ETR may be formed utilizing a metal oxide such as Li₂O or BaO, or 8-hydroxyl-lithium quinolate (Liq), and/or the like. The electron transport region ETR may also be formed of a mixture material of an electron transport material and an insulating organometallic salt. The organometallic salt may be a material having an energy band gap of about 4 eV or more. For example, the organometallic salt may include, for example, a metal acetate, a metal benzoate, a metal acetoacetate, a metal acetylacetonate, or a metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to the herein-described materials.

The electron transport region ETR may include the herein-described compounds of the electron transport region in at least one of the electron injection layer EIL, the electron transport layer ETL, or the hole blocking layer HBL.

When the electron transport region ETR includes the electron transport layer ETL, the electron transport layer ETL may have a thickness of about 100 Å to about 1,000 Å, for example, about 150 Å to about 500 Å. When the thickness of the electron transport layer ETL satisfies the aforementioned range, satisfactory electron transport characteristics may be obtained without a substantial increase in driving voltage. When the electron transport region ETR includes the electron injection layer EIL, the electron injection layer EIL may have a thickness of about 1 Å to about 100 Å, for example, about 3 Å to about 90 Å. When the thickness of the electron injection layer EIL satisfies the herein-described range, satisfactory electron injection characteristics may be obtained without a substantial increase in driving voltage.

The second electrode EL2 is provided on the electron transport region ETR. The second electrode EL2 may be a common electrode. The second electrode EL2 may be a cathode or an anode. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), and/or the like.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (e.g., AgMg, AgYb, or MgAg). In some embodiments, the second electrode EL2 may have a multilayer structure including a reflective film or a transflective film formed of the herein-described materials, and a transparent conductive film formed of ITO, IZO, ZnO, ITZO, and/or the like. For example, the second electrode EL2 may include the herein-described metal materials, combinations of at least two metal materials of the herein-described metal materials, oxides of the herein-described metal materials, and/or the like.

In some embodiments, the second electrode EL2 may be connected with an auxiliary electrode. When the second electrode EL2 is connected with the auxiliary electrode, the resistance of the second electrode EL2 may be decreased.

In some embodiments, a capping layer CPL may further be provided on the second electrode EL2 of the light emitting element ED of one or more embodiments. The capping layer CPL may include a multilayer or a single layer.

In one or more embodiments, the capping layer CPL may be an organic layer or an inorganic layer. For example, when the capping layer CPL contains an inorganic material, the inorganic material may include an alkaline metal compound (e.g., LiF), an alkaline earth metal compound (e.g., MgF₂), SiON, SiNₓ, SiOy, and/or the like.

For example, when the capping layer CPL includes an organic material, the organic material may include α-NPD (N,N'-Bis(naphthalen-1-yl)-N,N'-bis(phenyl)-2,2'-dimethylbenzidine), NPB (N,N'-Di(1-naphthyl)-N,N'-diphenyl-(1,1'-biphenyl)-4,4'-diamine), TPD (N,N'-Bis(3-methylphenyl)-N,N'-diphenylbenzidine), m-MTDATA, Alq₃, CuPc (Copper(II) phthalocyanine), N4,N4,N4',N4'-tetra(biphenyl-4-yl)biphenyl-4,4'-diamine (TPD15), 4,4',4"-tris(carbazol-9-yl)triphenylamine (TCTA), and/or the like, or an epoxy resin, or acrylate such as methacrylate. The capping layer CPL may include at least one selected from among Compounds P1 to P5.

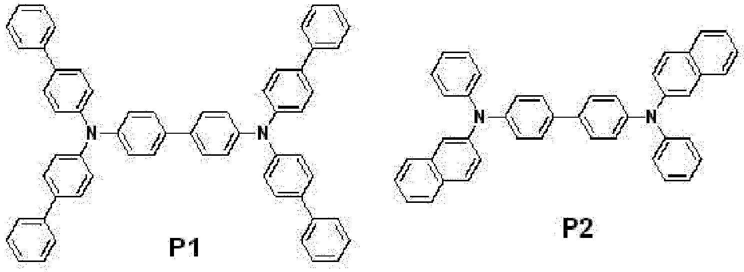

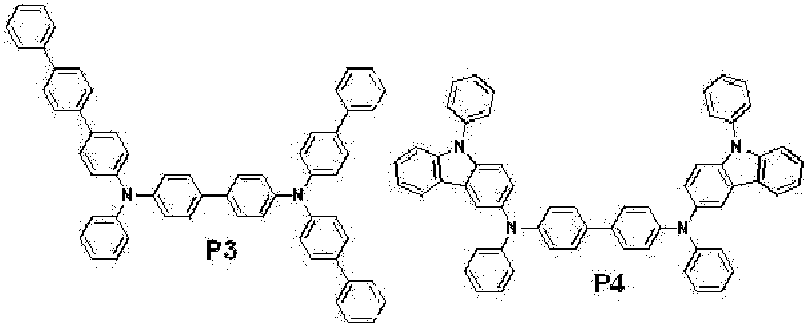

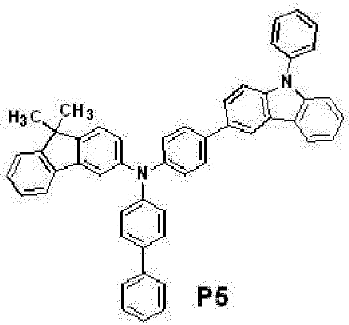

In some embodiments, the refractive index of the capping layer CPL may be about 1.6 or more. For example, the refractive index of the capping layer CPL may be about 1.6 or more with respect to light in a wavelength range of about 550 nm to about 660 nm.

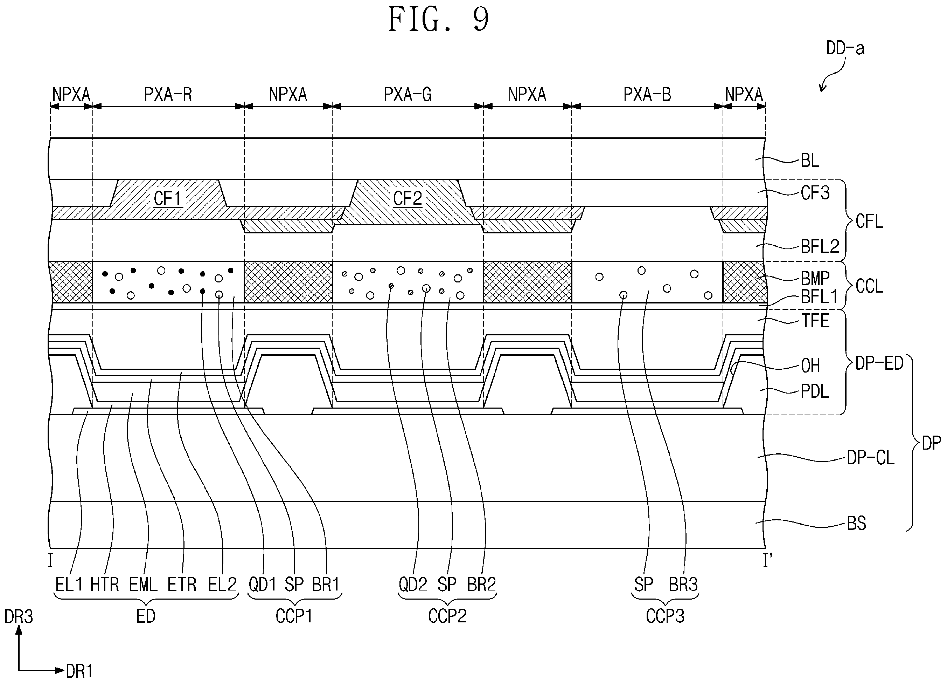

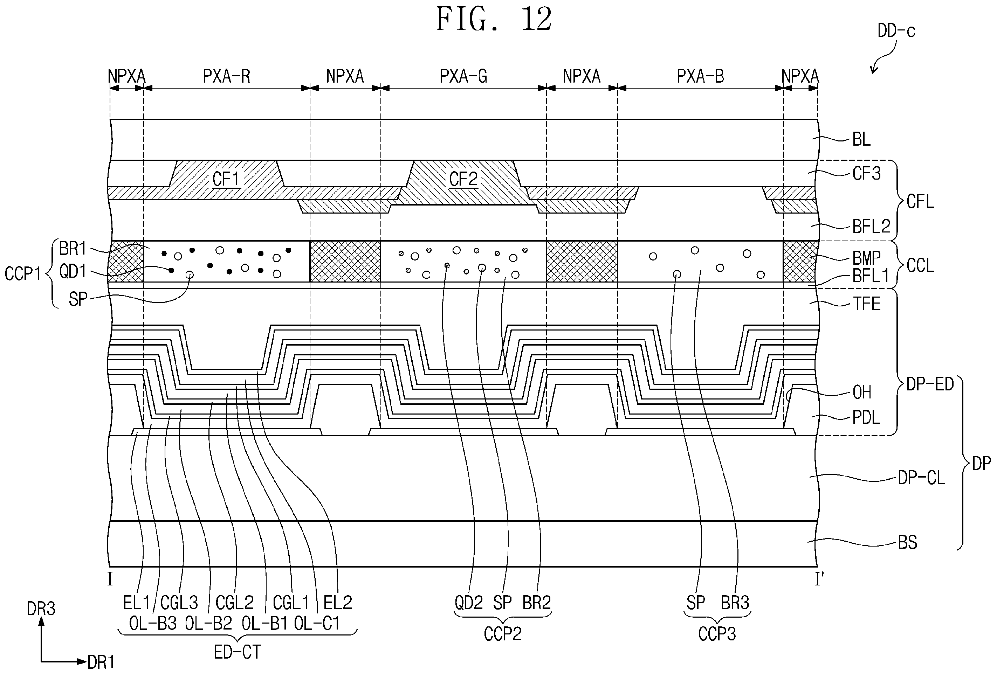

Each of FIGS. 9 to 12 is a cross-sectional view of a display device according to one or more embodiments of the present disclosure. Hereinafter, in describing the display devices of embodiments with reference to FIGS. 9 to 12, the duplicated features which have been described in FIGS. 1 to 7 are not described again, but their differences will be mainly described (e.g., in more detail).

Referring to FIG. 9, the display device DD-a according to one or more embodiments may include a display panel DP including a display element layer DP-ED, a light control layer CCL provided on the display panel DP, and a color filter layer CFL. In one or more embodiments illustrated in FIG. 9, the display panel DP may include a base layer BS, a circuit layer DP-CL provided on the base layer BS, and the display element layer DP-ED, and the display element layer DP-ED may include a light emitting element ED.

The light emitting element ED may include a first electrode EL1, a hole transport region HTR provided on the first electrode EL1, an emission layer EML provided on the hole transport region HTR, an electron transport region ETR provided on the emission layer EML, and a second electrode EL2 provided on the electron transport region ETR. In some embodiments, the structure of the light-emitting element previously described with reference to FIGS. 3 to 7 may be applied equally to the structure of the light-emitting element ED illustrated in FIG. 9. The light-emitting element ED illustrated in FIG. 9 may include a polycyclic compound according to one or more embodiments, and at least one (e.g., selected from) among second to fourth compounds. Accordingly, the light-emitting element ED may have high efficiency and long lifespan characteristics.

Referring to FIG. 9, the emission layer EML may be provided in an opening OH defined in a pixel defining layer PDL. For example, the emission layer EML which is divided by the pixel defining layer PDL and provided corresponding to each light emitting regions PXA-R, PXA-G, and PXA-B may be to emit light in substantially the same wavelength range. In the display device DD-a of one or more embodiments, the emission layer EML may be to emit blue light. In some embodiments, unlike the configuration illustrated, in one or more embodiments, the emission layer EML may be provided as a common layer in the entire light emitting regions PXA-R, PXA-G, and PXA-B.

The light control layer CCL may be provided on the display panel DP. The light control layer CCL may include a light conversion body. The light conversion body may be a quantum dot, a phosphor, and/or the like. The light conversion body may be to emit provided light by converting the wavelength thereof. For example, the light control layer CCL may be a layer containing the quantum dot or a layer containing the phosphor.

The light control layer CCL may include a plurality of light control parts CCP1, CCP2 and CCP3. The light control parts CCP1, CCP2, and CCP3 may be spaced and/or apart from each other.

Referring to FIG. 9, divided patterns BMP may be provided between the light control parts CCP1, CCP2 and CCP3 which are spaced and/or apart from each other. FIG. 9 illustrates that the divided patterns BMP do not overlap the light control parts CCP1, CCP2 and CCP3, but at least a portion of the edges of the light control parts CCP1, CCP2 and CCP3 may overlap the divided patterns BMP.

The light control layer CCL may include a first light control part CCP1 containing a first quantum dot QD1 which converts first color light provided from the light emitting element ED into second color light, a second light control part CCP2 containing a second quantum dot QD2 which converts the first color light into third color light, and a third light control part CCP3 which transmits the first color light.

In one or more embodiments, the first light control part CCP1 may provide red light that is the second color light, and the second light control part CCP2 may provide green light that is the third color light. The third light control part CCP3 may provide blue light by transmitting the blue light that is the first color light provided from the light emitting element ED. For example, the first quantum dot QD1 may be a red quantum dot, and the second quantum dot QD2 may be a green quantum dot. The same as described herein may be applied with respect to the quantum dots QD1 and QD2.

In some embodiments, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) any quantum dot but include the scatterer SP.

The scatterer SP may be inorganic particles. For example, the scatterer SP may include at least one of TiO₂, ZnO, Al₂O₃, SiO₂, or hollow sphere silica. The scatterer SP may include any one selected from among TiO₂, ZnO, Al₂O₃, SiO₂, and hollow sphere silica, or may be a mixture of at least two materials selected from among TiO₂, ZnO, Al₂O₃, SiO₂, and hollow sphere silica.

The first light control part CCP1, the second light control part CCP2, and the third light control part CCP3 each may include base resins BR1, BR2, and BR3, respectively, in which the quantum dots QD1 and QD2 and the scatterer SP are dispersed. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may be formed of one or more suitable resin compositions, which may be generally referred to as a binder. For example, the base resins BR1, BR2, and BR3 may be acrylic-based resins, urethane-based resins, silicone-based resins, epoxy-based resins, and/or the like. The base resins BR1, BR2, and BR3 may be transparent resins. In one or more embodiments, the first base resin BR1, the second base resin BR2, and the third base resin BR3 may be the same as or different from each other.

The light control layer CCL may include a barrier layer BFL1. The barrier layer BFL1 may serve to prevent or reduce the penetration of moisture and/or oxygen (hereinafter, referred to as 'moisture/oxygen'). The barrier layer BFL1 may block or reduce the light control parts CCP1, CCP2 and CCP3 from being exposed to moisture/oxygen. In some embodiments, the barrier layer BFL1 may cover the light control parts CCP1, CCP2, and CCP3. In some embodiments, the barrier layer BFL2 may be provided between the light control parts CCP1, CCP2, and CCP3 and the color filter layer CFL.

The barrier layers BFL1 and BFL2 may include at least one inorganic layer. For example, the barrier layers BFL1 and BFL2 may include an inorganic material. For example, the barrier layers BFL1 and BFL2 may include a silicon nitride, an aluminium nitride, a zirconium nitride, a titanium nitride, a hafnium nitride, a tantalum nitride, a silicon oxide, an aluminium oxide, a titanium oxide, a tin oxide, a cerium oxide, a silicon oxynitride, a metal thin film which secures a transmittance, and/or the like. In some embodiments, the barrier layers BFL1 and BFL2 may further include an organic film. The barrier layers BFL1 and BFL2 may be formed of a single layer or a plurality of layers.

In the display device DD-a of one or more embodiments, the color filter layer CFL may be provided on the light control layer CCL. For example, the color filter layer CFL may be directly provided on the light control layer CCL. In this case, the barrier layer BFL2 may not be provided.

The color filter layer CFL may include filters CF1, CF2, and CF3. The color filter layer CFL may include a first filter CF1 configured to transmit the second color light, a second filter CF2 configured to transmit the third color light, and a third filter CF3 configured to transmit the first color light. For example, the first filter CF1 may be a red filter, the second filter CF2 may be a green filter, and the third filter CF3 may be a blue filter. The filters CF1, CF2, and CF3 each may include a polymeric photosensitive resin and a pigment or dye. The first filter CF1 may include a red pigment or dye, the second filter CF2 may include a green pigment or dye, and the third filter CF3 may include a blue pigment or dye.

In some embodiments, the third filter CF3 may not include (e.g., may exclude) a pigment or dye. The third filter CF3 may include a polymeric photosensitive resin and may not include (e.g., may exclude) a pigment or dye. The third filter CF3 may be transparent. The third filter CF3 may be formed of a transparent photosensitive resin.

Furthermore, in one or more embodiments, the first filter CF1 and the second filter CF2 may be a yellow filter. The first filter CF1 and the second filter CF2 may not be separated but be provided as one filter.

In one or more embodiments, the color filter layer CFL may further include a light shielding part. The light shielding part may be a black matrix. The light shielding part may include an organic light shielding material or an inorganic light shielding material containing a black pigment or dye. The light shielding part may prevent or reduce light leakage, and may separate boundaries between the adjacent filters CF1, CF2, and CF3. Also, in one or more embodiments, the light shielding part may be formed of a blue filter.

The first to third filters CF1, CF2, and CF3 may be provided corresponding to the red light emitting region PXA-R, the green light emitting region PXA-G, and the blue light emitting region PXA-B, respectively.

The base substrate BL may be a member which provides a base surface in which the color filter layer CFL, the light control layer CCL, and/or the like are provided. The base substrate BL may be a glass substrate, a metal substrate, a plastic substrate, and/or the like. The base substrate BL may be an inorganic layer, an organic layer, or a composite material layer. In some embodiments, unlike the configuration illustrated, in one or more embodiments, the base substrate BL may not be provided.

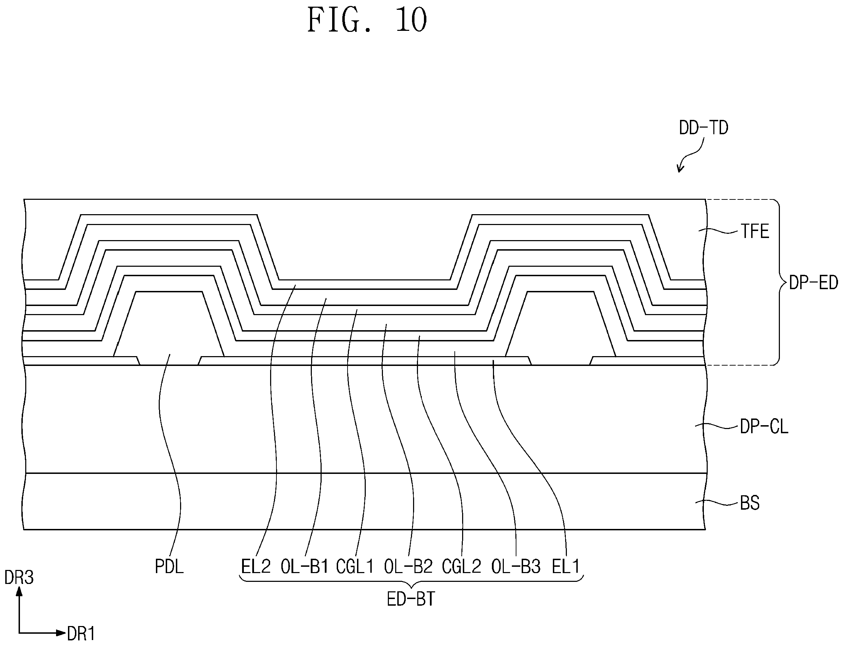

FIG. 10 is a cross-sectional view illustrating a portion of a display device DD-TD according to one or more embodiments. In a display device DD-TD according to one or more embodiments, a light-emitting element ED-BT may include a plurality of light-emitting structures OL-B1, OL-B2, and OL-B3. The plurality of light-emitting structures OL-B1, OL-B2, and OL-B3 may include a polycyclic compound according to one or more embodiments, and at least one selected from among second to fourth compounds. Accordingly, the light-emitting element ED-BT may have high efficiency and long lifespan characteristics.

The light emitting element ED-BT may include a first electrode EL1 and a second electrode EL2 which face each other, and the plurality of light emitting structures OL-B1, OL-B2, and OL-B3 sequentially stacked in the thickness direction between the first electrode EL1 and the second electrode EL2. The light emitting structures OL-B1, OL-B2, and OL-B3 each may include an emission layer EML (FIG. 9) and a hole transport region HTR and an electron transport region ETR provided with the emission layer EML (FIG. 9) located therebetween. For example, the light emitting element ED-BT included in the display device DD-TD of one or more embodiments may be a light emitting element having a tandem structure and including a plurality of emission layers.

In one or more embodiments illustrated in FIG. 10, all light beams respectively emitted from the light emitting structures OL-B1, OL-B2, and OL-B3 may be blue light. The light beams respectively emitted from the light emitting structures OL-B1, OL-B2, and OL-B3 may have wavelength ranges different from each other. For example, the light emitting element ED-BT including the plurality of light emitting structures OL-B1, OL-B2, and OL-B3 which emit light beams having wavelength ranges different from each other may be to emit white light.

A charge generating layer CGL1 and CGL2 may be provided between the neighboring light-emitting structures OL-B1, OL-B2 and OL-B3. The charge generating layer CGL1 and CGL2 may include a p-type or kind charge generating layer and/or an n-type or kind charge generating layer.

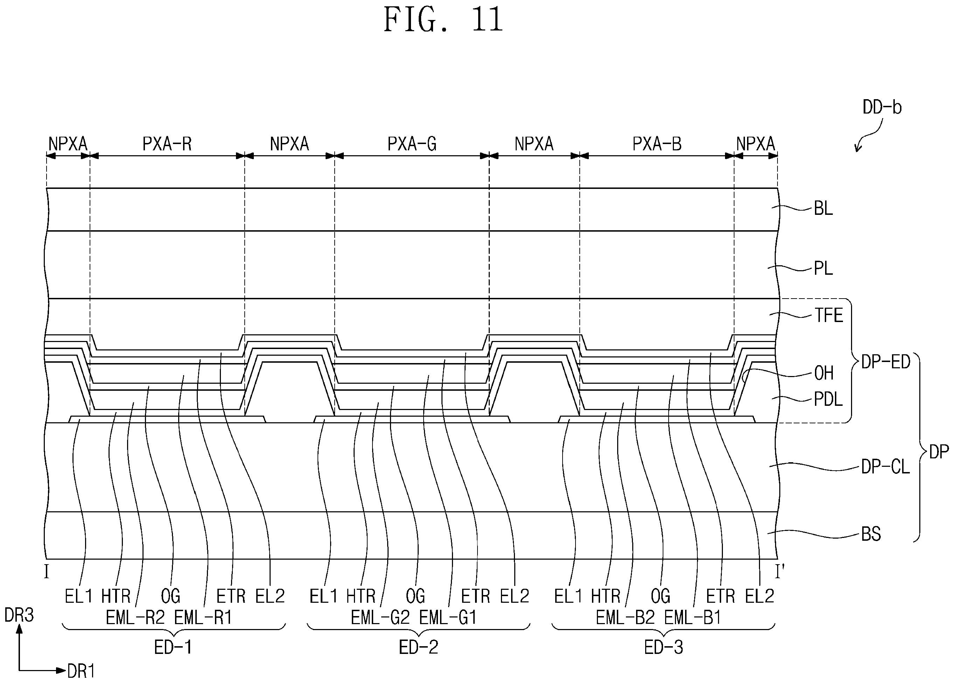

Referring to FIG. 11, a display device DD-b according to one or more embodiments may include light-emitting elements ED-1, ED-2, and ED-3 in each of which two emission layers are stacked. At least one of (i.e., at least one selected from among) the light-emitting elements ED-1, ED-2, or ED-3 may include a polycyclic compound according to one or more embodiments, and at least one (e.g., selected from) among second to fourth compounds. Accordingly, the light-emitting elements ED-1, ED-2, and ED-3 may have high efficiency and long lifespan characteristics.

Compared with the display device DD of an embodiment illustrated in FIG. 2, one or more embodiments of a display device DD-b illustrated in FIG. 11 has a difference in that the first to third light emitting elements ED-1, ED-2, and ED-3 each include two emission layers stacked in the thickness direction. In each of the first to third light emitting elements ED-1, ED-2, and ED-3, the two emission layers may be to emit light in substantially the same wavelength region.

The first light emitting element ED-1 may include a first red emission layer EML-R1 and a second red emission layer EML-R2. The second light emitting element ED-2 may include a first green emission layer EML-G1 and a second green emission layer EML-G2. In some embodiments, the third light emitting element ED-3 may include a first blue emission layer EML-B1 and a second blue emission layer EML-B2. An emission auxiliary part OG may be provided between the first red emission layer EML-R1 and the second red emission layer EML-R2, between the first green emission layer EML-G1 and the second green emission layer EML-G2, and between the first blue emission layer EML-B1 and the second blue emission layer EML-B2.

The emission auxiliary part OG may include a single layer or a multilayer. The emission auxiliary part OG may include a charge generation layer. More specifically, the emission auxiliary part OG may include an electron transport region, a charge generation layer, and a hole transport region that are sequentially stacked. The emission auxiliary part OG may be provided as a common layer in the whole of the first to third light emitting elements ED-1, ED-2, and ED-3. The emission auxiliary part OG may be provided by being patterned within the openings OH defined in the pixel defining layer PDL.

The first red emission layer EML-R1, the first green emission layer EML-G1, and the first blue emission layer EML-B1 may be provided between the electron transport region ETR and the emission auxiliary part OG. The second red emission layer EML-R2, the second green emission layer EML-G2, and the second blue emission layer EML-B2 may be provided between the emission auxiliary part OG and the hole transport region HTR.

For example, the first light emitting element ED-1 may include the first electrode EL1, the hole transport region HTR, the second red emission layer EML-R2, the emission auxiliary part OG, the first red emission layer EML-R1, the electron transport region ETR, and the second electrode EL2 that are sequentially stacked. The second light emitting element ED-2 may include the first electrode EL1, the hole transport region HTR, the second green emission layer EML-G2, the emission auxiliary part OG, the first green emission layer EML-G1, the electron transport region ETR, and the second electrode EL2 that are sequentially stacked. The third light emitting element ED-3 may include the first electrode EL1, the hole transport region HTR, the second blue emission layer EML-B2, the emission auxiliary part OG, the first blue emission layer EML-B1, the electron transport region ETR, and the second electrode EL2 that are sequentially stacked.

In some embodiments, an optical auxiliary layer PL may be provided on the display element layer DP-ED. The optical auxiliary layer PL may include a polarizing layer. The optical auxiliary layer PL may be provided on the display panel DP and control reflected light in the display panel DP due to external light. Unlike the configuration illustrated, the optical auxiliary layer PL in the display device according to one or more embodiments may not be provided.

Unlike FIGS. 10 and 11, FIG. 12 illustrates that a display device DD-c includes four light-emitting structures OL-B1, OL-B2, OL-B3, and OL-C1. A light-emitting element ED-CT may include a first electrode EL1 and a second electrode EL2 facing each other, and the first to fourth light-emitting structures OL-B3, OL-B2, OL-B1, and OL-C1, sequentially stacked in the thickness direction between the first electrode EL1 and the second electrode EL2. At least one selected from among the first to fourth light-emitting structures OL-B1, OL-B2, OL-B3, and OL-C1 may include a polycyclic compound according to one or more embodiments, and at least one selected from among second to fourth compounds. Accordingly, the light-emitting element ED-CT may have high efficiency and long lifespan characteristics.

Charge generation layers CGL1, CGL2, and CGL3 may be provided between the first to fourth light emitting structures OL-B1, OL-B2, OL-B3, and OL-C1. Among the four light emitting structures, the first to third light emitting structures OL-B1, OL-B2, and OL-B3 may be to emit blue light, and the fourth light emitting structure OL-C1 may be to emit green light. The first to fourth light emitting structures OL-B1, OL-B2, OL-B3, and OL-C1 may be to emit light beams in different wavelength regions. The charge generation layers CGL1, CGL2, and CGL3 provided between adjacent light emitting structures OL-B1, OL-B2, OL-B3, and OL-C1 may include a p-type or kind charge generation layer (e.g., a p-charge generation layer) and/or an n-type or kind charge generation layer (e.g., an n-charge generation layer).

In one or more embodiments, the electronic apparatus may include a display device including a plurality of light emitting elements, and a control part which controls the display device. The electronic apparatus of one or more embodiments may be a device that is activated according to an electrical signal. The electronic apparatus may include display devices of one or more suitable embodiments. For example, the electronic apparatus may include not only large-sized electronic apparatuses such as a television set, a monitor, or an outdoor billboard but also include small- and medium-sized electronic apparatuses such as a personal computer, a laptop computer, a personal digital terminal, a display device for a vehicle, a game console, a portable electronic device, or a camera.

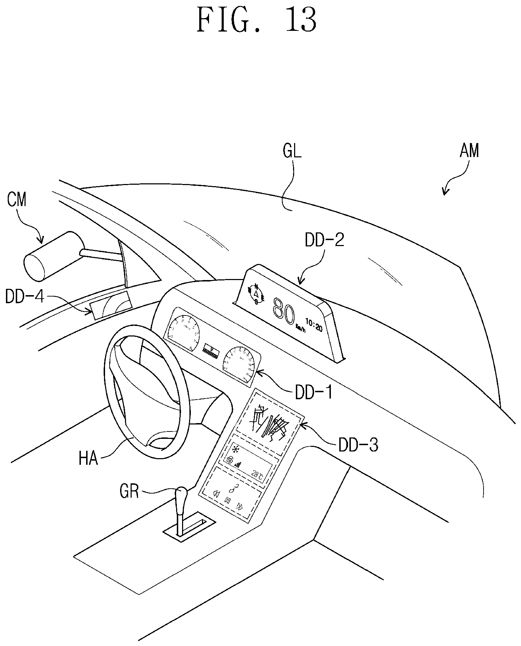

FIG. 13 is a view illustrating a vehicle AM in which first to fourth display devices DD-1, DD-2, DD-3, and DD-4 are provided. At least one (e.g., selected from) among the first to fourth display devices DD-1, DD-2, DD-3, and DD-4 may include the same configuration as the display devices DD, DD-TD, DD-a, DD-b, and DD-c as described with reference to FIGS. 1, and 2, and 9 to 12.

FIG. 13 illustrates a vehicle AM, but this is an example, and the first to fourth display devices DD-1, DD-2, DD-3, and DD-4 may be provided in another transportation refers to such as bicycles, motorcycles, trains, ships, and airplanes. In some embodiments, at least one (e.g., selected from) among the first to fourth display devices DD-1, DD-2, DD-3, and DD-4 including the same configuration as the display devices DD, DD-TD, DD-a, DD-b, and DD-c of one or more embodiments may be employed in a personal computer, a laptop computer, a personal digital terminal, a game console, a portable electronic device, a television, a monitor, an outdoor billboard, and/or the like. In some embodiments, these are merely provided as embodiments, and thus may be employed in other electronic apparatuses unless departing from the present disclosure.

At least one (e.g., selected from) among the first to fourth display devices DD-1, DD-2, DD-3, and DD-4 may include the light-emitting element ED described with reference to FIGS. 3 to 7. At least one (e.g., selected from) among the first to fourth display devices DD-1, DD-2, DD-3, and DD-4 may include a polycyclic compound according to one or more embodiments, and at least one (e.g., selected from) among second to fourth compounds. Accordingly, the first to fourth display devices DD-1, DD-2, DD-3, and DD-4, including the polycyclic compound according to one or more embodiments, and at least one (e.g., selected from) among the second to fourth compounds, may have improved display efficiency and display lifespan.

Referring to FIG. 13, the vehicle AM may include a steering wheel HA and a gear GR for driving the vehicle AM. In some embodiments, the vehicle AM may include a front window GL provided so as to face the driver.

The first display device DD-1 may be provided in a first region overlapping the steering wheel HA. For example, the first display device DD-1 may be a digital cluster which displays first information of the vehicle AM. The first information may include a first scale which indicates a driving speed of the vehicle AM, a second scale which indicates an engine speed (that is, revolutions per minute (RPM)), an image which indicates a fuel state, and/or the like. A first scale and a second scale may be indicated as a digital image.

The second display device DD-2 may be provided in a second region facing the driver's seat and overlapping the front window GL. The driver's seat may be a seat in which the steering wheel HA is provided. For example, the second display device DD-2 may be a head up display (HUD) which displays second information of the vehicle AM. The second display device DD-2 may be optically transparent. The second information may include digital numbers which indicate a driving speed, and may further include information such as the current time. Unlike the configuration illustrated, the second information of the second display device DD-2 may be projected to the front window GL to be displayed.

The third display device DD-3 may be provided in a third region adjacent to the gear GR. For example, the third display device DD-3 may be provided between the driver's seat and the passenger seat and may be a center information display (CID) for a vehicle for displaying third information. The passenger seat may be a seat spaced and/or apart from the driver's seat with the gear GR provided therebetween. The third information may include information about traffic (e.g., navigation information), playing music or radio or a video (or an image), temperatures inside the vehicle AM, and/or the like.

The fourth display device DD-4 may be spaced and/or apart from the steering wheel HA and the gear GR, and may be provided in a fourth region adjacent to the side of the vehicle AM. For example, the fourth display device DD-4 may be a digital side-view mirror which displays fourth information. The fourth display device DD-4 may display an image outside the vehicle AM taken by a camera module CM provided outside the vehicle AM. The fourth information may include an image outside the vehicle AM.

The herein-described first to fourth information may be examples, and the first to fourth display devices DD-1, DD-2, DD-3, and DD-4 may further display information about the inside and outside of the vehicle AM. The first to fourth information may include different information. A part of the first to fourth information may include the same information as one another.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6.

The light emitting device, light emitting element, and/or any other relevant devices or components according to embodiments of the present disclosure described herein may be implemented utilizing any suitable hardware, firmware (e.g., an application-specific integrated circuit), software, or a combination of software, firmware, and hardware. For example, the various components of the light emitting device and/or light emitting element may be formed on one integrated circuit (IC) chip or on separate IC chips. Further, the various components of the light emitting device and/or light emitting element may be implemented on a flexible printed circuit film, a tape carrier package (TCP), a printed circuit board (PCB), or formed on one substrate. Further, the various components of the device and/or element may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In the present disclosure, when particles are spherical, "diameter" indicates an average particle diameter, and when the particles are non-spherical, the "diameter" indicates a major axis length. The diameter (or size) of the particles may be measured by particle size analysis, dynamic light scattering, scanning electron microscopy, and/or transmission electron microscope photography. When the size of the particles is measured utilizing a particle size analyzer, the average particle diameter (or size) may be referred to as D50. The term "D50" as utilized herein refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size. Particle size analysis may be performed with a HORIBA LA-950 laser particle size analyzer.

Hereinafter, a polycyclic compound according to one or more embodiments of the present disclosure and a light-emitting element according to one or more embodiments will be described in more detail referring to examples and comparative examples. In some embodiments, the embodiments are only illustrations to assist the understanding of the present disclosure, and the scope of the present disclosure should not be limited thereto.

### Examples

### 1. Synthesis of polycyclic compound according to one or more embodiments

The synthetic method of the polycyclic compound according to one or more embodiments will be described in particular by exemplifying the synthetic methods of Compounds 22, 39, 51, 65, 108, 118, and 152. In some embodiments, the synthetic methods of the polycyclic compounds, to be described, are embodiments, and the synthetic method of the compound according to one or more embodiments of the present disclosure should not be limited to the embodiments.

### (1) Synthesis of Compound 22

Polycyclic Compound 22 according to one or more embodiments may be synthesized by, for example, the steps (e.g., acts or tasks) of Reaction 1.

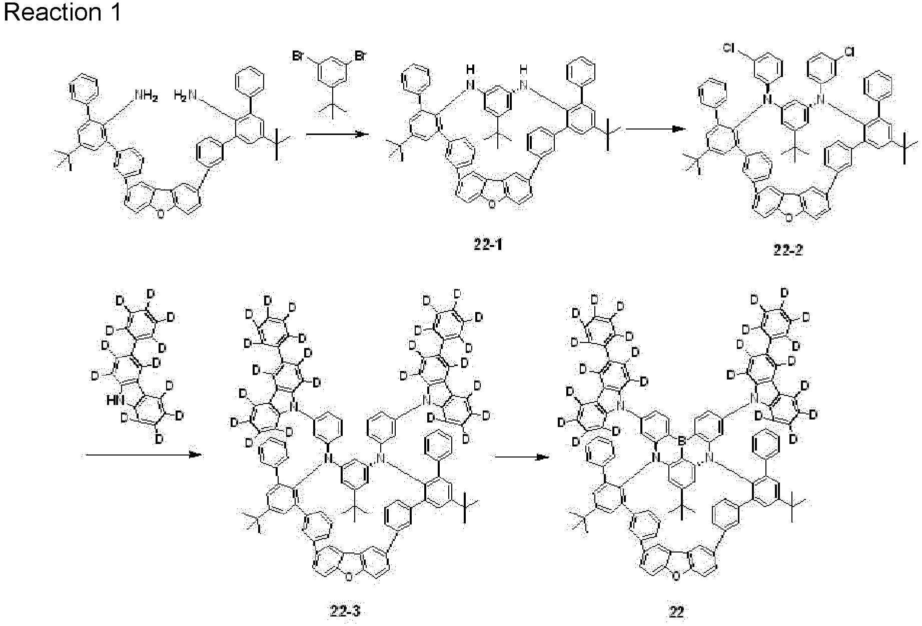

### Synthesis of Intermediate 22-1

3,3"'-(dibenzo[b,d]furan-2,8-diyl)bis(5'-(tert-butyl)-[1‴, 1ʺʺ:3ʺʺ,1‴ʺ-terphenyl]-2'-amine) (1 eq), 1,3-dibromo-5-(tert-butyl)benzene (1 eq), tris (dibenzylideneacetone)dipalladium(0) (0.2 eq), 1,1'-bis (diphenylphosphino)ferrocene (0.4 eq), and sodium tert-butoxide (3 eq) were dissolved in o-xylene, and then stirred at about 140°C for about 10 hours. After cooling, the reaction solution was washed three times with ethyl acetate and water, and then liquid was separated to obtain an organic layer. The organic layer was dried over anhydrous MgSO₄, and dried under a reduced pressure. Intermediate 22-1 was obtained by purifying the resultant through column chromatography utilizing MC and n-hexane (yield: 40%).

### Synthesis of Intermediate 22-2

1-bromo-3-chlorobenzene (4 eq), Intermediate 22-1 (1 eq), tris(dibenzylideneacetone)dipalladium(0) (0.1 eq), tri-tert-butylphosphine (0.2 eq), and sodium tert-butoxide (3 eq) were dissolved in o-xylene, and then stirred at about 160°C for about 36 hours. After cooling, the reaction solution was washed three times with ethyl acetate and water, and then liquid was separated to obtain an organic layer. The organic layer was dried over anhydrous MgSO₄, and then dried under a reduced pressure. Intermediate 22-2 was obtained by purifying the resultant through column chromatography utilizing MC and n-hexane (yield: 81%).

### Synthesis of Intermediate 22-3

Intermediate 22-2 (1 eq), 3-(phenyl-d5)-9H-carbazole-1,2,4,5,6,7,8-d7 (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at about 140°C for about 24 hours. After cooling, the reaction solution was washed three times with ethyl acetate and water, and then liquid was separated to obtain an organic layer. The organic layer was dried over anhydrous MgSO₄, and dried under a reduced pressure. Intermediate 22-3 was obtained by purifying the resultant through column chromatography utilizing MC and n-hexane (yield: 85%).

### Synthesis of Compound 22

Intermediate 22-3 (1 eq) was dissolved in ortho dichlorobenzene, then cooled at about 0°C, and under a nitrogen atmosphere, BBr₃ (3 eq) was slowly injected. After completion of dropping, the temperature was raised to about 180°C to stir for about 48 hours. After cooling, triethylamine was slowly dropped to a flask containing reactants to quench the reaction, then ethyl alcohol was added to the reactants to precipitate and filter, and a reaction product was obtained. The solid content (e.g., amount) thus obtained was purified through column chromatography utilizing MC and n-hexane to obtain Compound 22 (yield: 5%).

### (2) Synthesis of Compound 39

Polycyclic Compound 39 according to one or more embodiments may be synthesized by, for example, the steps of Reaction 2.

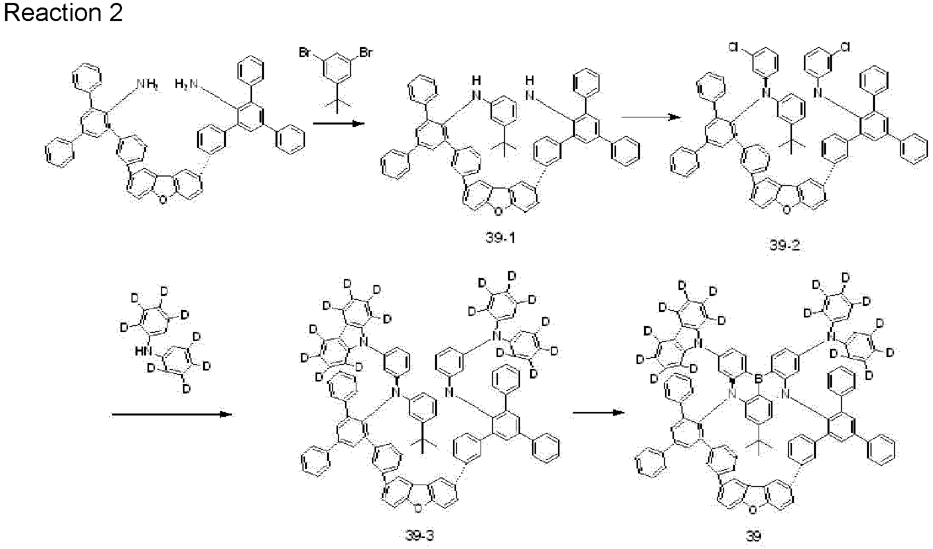

### Synthesis of Intermediate 39-1

5',5ʺʺ-(dibenzo[b,d]furan-2,8-diylbis(3,1-phenylene))bis(([1,1':-3',1"-terphenyl]-4'-amine) (1 eq), 1,3-dibromo-5-(tert-butyl)benzene (1 eq), tris(dibenzylideneacetone)dipalladium(0) (0.2 eq), 1,1'-bis(diphenylphosphino)ferrocene (0.4 eq), and sodium tert-butoxide (3 eq) were dissolved in o-xylene, and then stirred at about 140°C for about 10 hours. After cooling, the reaction solution was washed three times with ethyl acetate and water, and then liquid was separated to obtain an organic layer. The organic layer was dried over anhydrous MgSO₄ and then dried under a reduced pressure. Intermediate 39-1 was obtained by purifying the resultant through column chromatography utilizing MC and n-hexane (yield: 42%).

### Synthesis of Intermediate 39-2

1-bromo-3-chlorobenzene (4 eq), Intermediate 39-1 (1 eq), tris(dibenzylideneacetone)dipalladium(0) (0.1 eq), tri-tert-butylphosphine (0.2 eq), and sodium tert-butoxide (3 eq) were dissolved in o-xylene, and then stirred at 160°C for 36 hours. After cooling, the reaction solution was washed three times with ethyl acetate and water, and then liquid was separated to obtain an organic layer. The organic layer was dried over anhydrous MgSO₄ and dried under a reduced pressure. Intermediate 39-2 was obtained by purifying the resultant through column chromatography utilizing MC and n-hexane (yield: 80%).

### Synthesis of Intermediate 39-3

Intermediate 39-2 (1 eq), 9H-carbazole-1,2,3,4,5,6,7,8-d8 (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at about 140°C for about 24 hours. After cooling, the reaction solution was washed three times with ethyl acetate and water, and then liquid was separated to obtain an organic layer. The organic layer was dried over anhydrous MgSO₄ and dried under a reduced pressure. Intermediate 39-3 was obtained by purifying the resultant through column chromatography utilizing MC and n-hexane (yield: 82%).

### Synthesis of Compound 39

Intermediate 39-3 (1 eq) was dissolved in ortho dichlorobenzene, then cooled at about 0°C, and under a nitrogen atmosphere, BBr₃ (3 eq) was slowly injected. After completion of dropping, the temperature was raised to about 180°C to stir for about 48 hours. After cooling, triethylamine was slowly dropped to a flask containing reactants to quench the reaction, then ethyl alcohol was added to the reactants to precipitate and filter, and a reaction product was obtained. The solid content (e.g., amount) thus obtained was purified through column chromatography utilizing MC and n-hexane to obtain Compound 39 (yield: 4%).

### (3) Synthesis of Compound 51

Polycyclic Compound 51 according to one or more embodiments may be synthesized by, for example, the steps of Reaction 3.

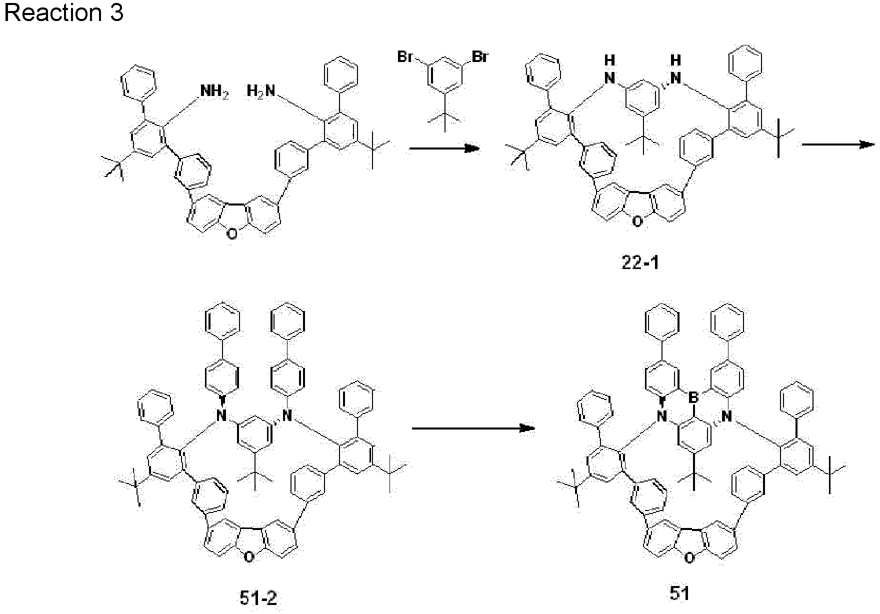

### Synthesis of Intermediate 51-2

4-bromo-1,1'-biphenyl (6 eq), Intermediate 22-1 (1 eq), tris(dibenzylideneacetone)dipalladium(0) (0.1 eq), tri-tert-butylphosphine (0.2 eq), and sodium tert-butoxide (3 eq) were dissolved in o-xylene, and then stirred at about 160°C for about 36 hours. After cooling, the reaction solution was washed three times with ethyl acetate and water, and then liquid was separated to obtain an organic layer. The organic layer was dried over anhydrous MgSO₄ and then dried under a reduced pressure. Intermediate 51-2 was obtained by purifying the resultant through column chromatography utilizing MC and n-hexane (yield: 76%).

### Synthesis of Compound 51

Intermediate 51-2 (1 eq) was dissolved in ortho dichlorobenzene, then cooled at about 0°C, and under a nitrogen atmosphere, BBr₃ (3 eq) was slowly injected. After completion of dropping, the temperature was raised to about 180°C to stir for about 48 hours. After cooling, triethylamine was slowly dropped to a flask containing reactants to quench the reaction, then ethyl alcohol was added to the reactants to precipitate and filter, and a reaction product was obtained. The solid content (e.g., amount) thus obtained was purified through column chromatography utilizing MC and n-hexane to obtain Compound 51 (yield: 4%).

### (4) Synthesis of Compound 65

Polycyclic Compound 65 according to one or more embodiments may be synthesized by, for example, the steps of Reaction 4.

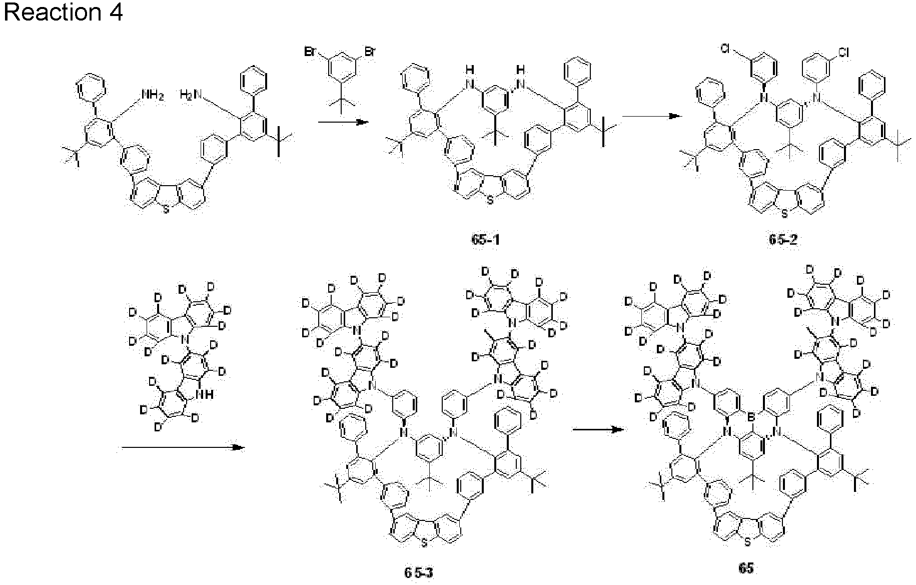

### Synthesis of Intermediate 65-1

3,3‴-(dibenzo[b,d]thiophene-2,8-diyl)bis(5'-(tert-butyl)-[1‴,1ʺʺ:3ʺʺ,1‴ʺ-terphenyl]-2'-amine) (1 eq), 1,3-dibromo-5-(tert-butyl)benzene (1 eq), tris(dibenzylideneacetone)dipalladium(0) (0.2 eq), 1,1'-bis(diphenylphosphino)ferrocene (0.4 eq), and sodium tert-butoxide (3 eq) were dissolved in o-xylene, and then stirred at about 140°C for about 10 hours. After cooling, the reaction solution was washed three times with ethyl acetate and water, and then liquid was separated to obtain an organic layer. The organic layer was dried over anhydrous MgSO₄ and then dried under a reduced pressure. Intermediate 65-1 was obtained by purifying the resultant through column chromatography over MC and n-hexane (yield: 36%).

### Synthesis of Intermediate 65-2

1-bromo-3-chlorobenzene (6 eq), Intermediate 65-1 (1 eq), tris(dibenzylideneacetone)dipalladium(0) (0.1 eq), tri-tert-butylphosphine (0.2 eq), and sodium tert-butoxide (3 eq) were dissolved in o-xylene, and then stirred at about 160°C for about 36 hours. After cooling, the reaction solution was washed three times with ethyl acetate and water, and then liquid was separated to obtain an organic layer. The organic layer was dried over anhydrous MgSO₄ and then dried under a reduced pressure. Intermediate 65-2 was obtained by purifying the resultant through column chromatography utilizing MC and n-hexane (yield: 79%).

### Synthesis of Intermediate 65-3

Intermediate 65-2 (1 eq), 9H-3,9'-bicarbazole-1,1',2,2',3',4,4',5,5',6,6',7,7',8,8'-d15 (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at about 140°C for about 24 hours. After cooling, the reaction solution was washed three times with ethyl acetate and water, and then liquid was separated to obtain an organic layer. The organic layer was dried over anhydrous MgSO₄ and then dried under a reduced pressure. Intermediate 65-3 was obtained by purifying the resultant through column chromatography utilizing MC and n-hexane (yield: 82%).

### Synthesis of Compound 65

Intermediate 65-3 (1 eq) was dissolved in ortho dichlorobenzene, then cooled at about 0°C, and under a nitrogen atmosphere, BBr₃ (3 eq) was slowly injected. After completion of dropping, the temperature was raised to about 180°C to stir for about 48 hours. After cooling, triethylamine was slowly dropped to a flask containing reactants to quench the reaction, then ethyl alcohol was added to the reactants to precipitate and filter, and a reaction product was obtained. The solid content (e.g., amount) thus obtained was purified through column chromatography utilizing MC and n-hexane to obtain Compound 65 (yield: 4%).

### (5) Synthesis of Compound 108

Polycyclic Compound 108 according to one or more embodiments may be synthesized by, for example, the steps of Reaction 5.

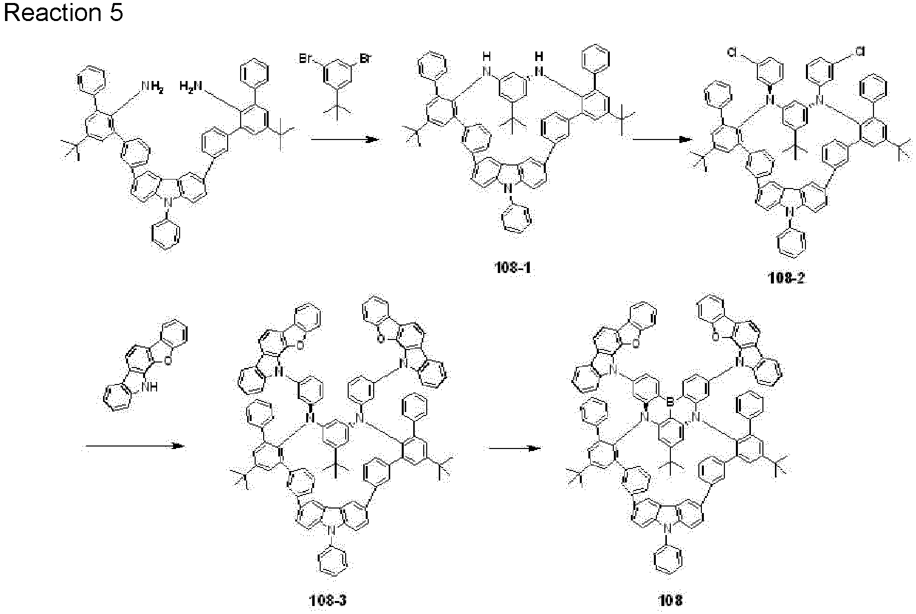

### Synthesis of Intermediate 108-1

3,3‴-(9-phenyl-9H-carbazole-3,6-diyl)bis(5'-(tert-butyl)-[1‴,1ʺʺ-3ʺʺ,1‴ʺ-terphenyl]-2'-amine) (1 eq), 1,3-dibromo-5-(tert-butyl)benzene (1 eq), tris(dibenzylideneacetone)dipalladium(0) (0.2 eq), 1,1'-bis(diphenylphosphino)ferrocene (0.4 eq), and sodium tert-butoxide (3 eq) were dissolved in o-xylene, and then stirred at about 140°C for about 10 hours. After cooling, the reaction solution was washed three times with ethyl acetate and water, and then liquid was separated to obtain an organic layer. The organic layer was dried over anhydrous MgSO₄ and then dried under a reduced pressure. Intermediate 108-1 was obtained by purifying the resultant through column chromatography utilizing MC and n-hexane (yield: 39%).

### Synthesis of Intermediate 108-2

1-bromo-3-chlorobenzene (6 eq), Intermediate 108-1 (1 eq), tris(dibenzylideneacetone)dipalladium(0) (0.1 eq), tri-tert-butylphosphine (0.2 eq), and sodium tert-butoxide (3 eq) were dissolved in o-xylene, and then stirred at about 160°C for about 36 hours. After cooling, the reaction solution was washed three times with ethyl acetate and water, and then liquid was separated to obtain an organic layer. The organic layer was dried over anhydrous MgSO₄ and then dried under a reduced pressure. Intermediate 108-2 was obtained by purifying the resultant through column chromatography utilizing MC and n-hexane (yield: 80%).

### Synthesis of Intermediate 108-3

Intermediate 108-2 (1 eq), 12H-benzofuro[2,3-a]carbazole (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at about 140°C for about 24 hours. After cooling, the reaction solution was washed three times with ethyl acetate and water, and then liquid was separated to obtain an organic layer. The organic was dried over anhydrous MgSO₄ and then dried under a reduced pressure. Intermediate 108-3 was obtained by purifying the resultant through column chromatography utilizing MC and n-hexane (yield: 82%).

### Synthesis of Compound 108

Intermediate 108-3 (1 eq) was dissolved in ortho dichlorobenzene, then cooled at about 0°C, and under a nitrogen atmosphere, BBr₃ (3 eq) was slowly injected. After completion of dropping, the temperature was raised to about 180°C to stir for about 48 hours. After cooling, triethylamine was slowly dropped to a flask containing reactants to quench the reaction, then ethyl alcohol was added to the reactants to precipitate and filter, and a reaction product was obtained. The solid content (e.g., amount) thus obtained was purified through column chromatography utilizing MC and n-hexane to obtain Compound 108 (yield: 4%).

### (6) Synthesis of Compound 118

Polycyclic Compound 118 according to one or more embodiments may be synthesized by, for example, the steps of Reaction 6.

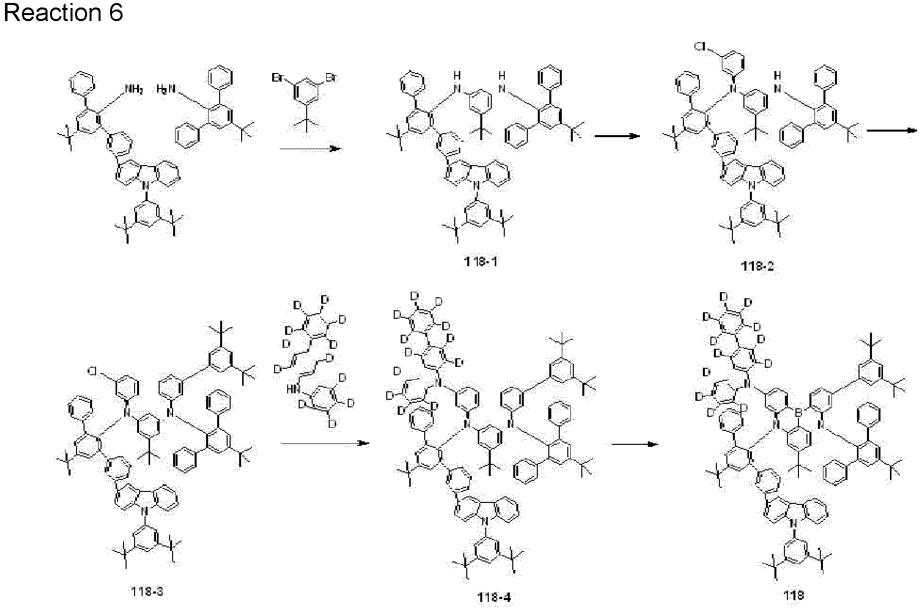

### Synthesis of Intermediate 118-1

3,3"'-(9-(3,5-di-tert-butylphenyl)-9H-carbazole-3,6-diyl)bis(5'-(tert-butyl)-[1‴,1ʺʺ:3ʺʺ,1‴ʺ-terphenyl]-2'-amine) (1 eq), 1,3-dibromo-5-(tert-butyl)benzene (1 eq), tris(dibenzylideneacetone)dipalladium(0) (0.2 eq), 1,1'-bis(diphenylphosphino)ferrocene (0.4 eq), and sodium tert-butoxide (3 eq) were dissolved in o-xylene, and then stirred at about 140°C for about 10 hours. After cooling, the reaction solution was washed three times with ethyl acetate and water, and then liquid was separated to obtain an organic layer. The organic layer was dried over anhydrous MgSO₄ and then dried under a reduced pressure. Intermediate 118-1 was obtained by purifying the resultant through column chromatography utilizing MC and n-hexane (yield: 38%).

### Synthesis of Intermediate 118-2

1-bromo-3-chlorobenzene (2 eq), Intermediate 118-1 (1 eq), tris(dibenzylideneacetone)dipalladium(0) (0.1 eq), BINAP (0.2 eq), and sodium tert-butoxide (3 eq) were dissolved in o-xylene, and then stirred at about 160°C for about 36 hours. After cooling, the reaction solution was washed three times with ethyl acetate and water, and then liquid was separated to obtain an organic layer. The organic layer was dried over anhydrous MgSO₄ and then dried under a reduced pressure. Intermediate 118-2 was obtained by purifying the resultant through column chromatography utilizing MC and n-hexane (yield: 77%).

### Synthesis of Intermediate 118-3

3'-bromo-3,5-di-tert-butyl-1,1'-biphenyl (2 eq), Intermediate 118-2 (1 eq), tris(dibenzylideneacetone)dipalladium(0) (0.1 eq), tri-tert-butylphosphine (0.2 eq), and sodium tert-butoxide (3 eq) were dissolved in o-xylene, and then stirred at about 160°C for about 36 hours. After cooling, the reaction solution was washed three times with ethyl acetate and water, and then liquid was separated to obtain an organic layer. The organic layer was dried over anhydrous MgSO₄ and then dried under a reduced pressure. Intermediate 118-3 was obtained by purifying the resultant through column chromatography utilizing MC and n-hexane (yield: 79%).

### Synthesis of Intermediate 118-4

Intermediate 118-3 (1 eq), 3-(phenyl-d5)-9H-carbazole-1,2,4,5,6,7,8-d7 (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at about 140°C for about 24 hours. After cooling, the reaction solution was washed three times with ethyl acetate and water, and then liquid was separated to obtain an organic layer. The organic layer was dried over anhydrous MgSO₄ and then dried under a reduced pressure. Intermediate 118-4 was obtained by purifying the resultant through column chromatography utilizing MC and n-hexane (yield: 81%).

### Synthesis of Compound 118

Intermediate 118-4 (1 eq) was dissolved in ortho dichlorobenzene, then cooled at about 0°C, and under a nitrogen atmosphere, BBr₃ (3 eq) was slowly injected. After completion of dropping, the temperature was raised to about 180°C to stir for about 48 hours. After cooling, triethylamine was slowly dropped to a flask containing reactants to quench the reaction, then ethyl alcohol was added to the reactants to precipitate and filter, and a reaction product was obtained. The solid content (e.g., amount) thus obtained was purified through column chromatography utilizing MC and n-hexane to obtain Compound 118 (yield: 5%).

### (7) Synthesis of Compound 152

Polycyclic Compound 152 according to one or more embodiments may be synthesized by, for example, the steps of Reaction 7.

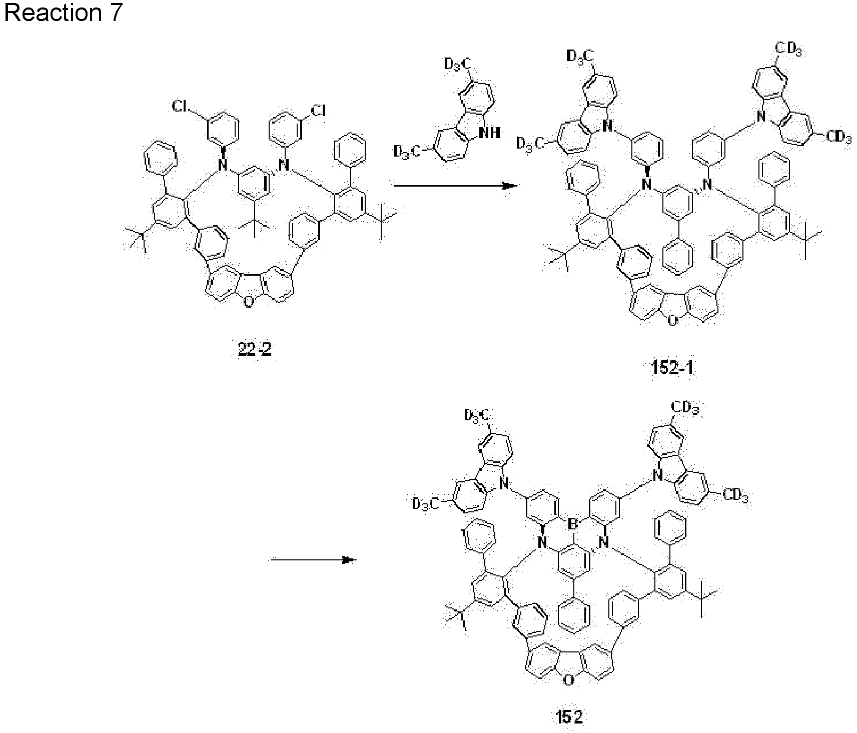

### Synthesis of Intermediate 152-1

Intermediate 22-2 (1 eq), 3,6-bis(methyl-d3)-9H-carbazole (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at about 140°C for about 24 hours. After cooling, the reaction solution was washed three times with ethyl acetate and water, and then liquid was separated to obtain an organic layer. The organic layer was dried over anhydrous MgSO₄ and then dried under a reduced pressure. Intermediate 152-1 was obtained by purifying the resultant through column chromatography utilizing MC and n-hexane (yield: 79%).

### Synthesis of Compound 152

Intermediate 152-1 (1 eq) was dissolved in ortho dichlorobenzene, then cooled at about 0°C, and under a nitrogen atmosphere, BBr₃ (3 eq) was slowly injected. After completion of dropping, the temperature was raised to about 180°C to stir for about 48 hours. After cooling, triethylamine was slowly dropped to a flask containing reactants to quench the reaction, then ethyl alcohol was added to the reactants to precipitate and filter, and a reaction product was obtained. The solid content (e.g., amount) thus obtained was purified through column chromatography utilizing MC and n-hexane to obtain Compound 152 (yield: 4%).

### 2. Manufacture and evaluation of light-emitting element

### (1) Manufacture of light-emitting element

A light-emitting element including a polycyclic compound according to one or more embodiments, or a compound of Comparative Example, in an emission layer was manufactured by a method. The light-emitting elements according to Examples 1-1 to 1-7 and Examples 2-1 to 2-7 were manufactured utilizing the polycyclic compounds according to one or more embodiments as dopant materials of emission layers, respectively. The light-emitting elements according to Comparative Examples 1-1 to 1-3 were manufactured utilizing Comparative Example Compounds C-1 to C-3 as dopant materials of emission layers, respectively, and the light-emitting elements according to Comparative Examples 2-1 to 2-3 were manufactured utilizing Comparative Example Compounds C-1 to C-3 as dopant materials of emission layers, respectively.

A glass substrate on which an ITO electrode of 15 Ω/cm² (1200 angstrom (Å)) was formed as a first electrode (product of Corning Co.) was cut into a size of 50 mm x 50 mm x 0.7 mm, and ultrasonically cleansed utilizing isopropyl alcohol and pure water, for about 5 minutes each, then cleansed by irradiation with UV light for about 30 minutes and exposure to ozone, and then mounted on a vacuum deposition apparatus.

NPD was deposited to form a hole injection layer having a thickness of about 300 Å on the first electrode, and Compound H-1-1 was deposited to form a hole transport layer having a thickness of about 200 Å on the hole injection layer. Then, CzSi was deposited to form an emission-auxiliary layer having a thickness of about 100 Å on the hole transport layer.

A host mixture, a phosphorescent sensitizer, and a dopant were co-deposited in a weight ratio of about 85:14:1 to form an emission layer having a thickness of about 200 Å on the emission-auxiliary layer. The host mixture was provided with Compound HT3 which is a hole-transporting host (HT host) and Compound ETH66 or ETH86 which is an electron transporting host (ET host) in a weight ratio of about 5:5. Compound AD-37 or Compound AD-38 was utilized as a material of the phosphorescent sensitizer. Example Compound or Comparative Example Compound was utilized as a dopant material.

TSPO1 was deposited on the emission layer to form a hole-blocking layer having a thickness of about 200 Å, and TPBi was deposited on the hole-blocking layer to form an electron transport layer having a thickness of about 300 Å. LiF was deposited to form an electron injection layer having a thickness of about 10 Å on the electron transport layer, and Al was deposited to form a second electrode having a thickness of about 3000 Å on the electron injection layer, and thus the light-emitting element was manufactured.

The compounds utilized for the manufacture of the light-emitting element are shown as follows.

### Common materials utilized in the manufacturing of the light-emitting element

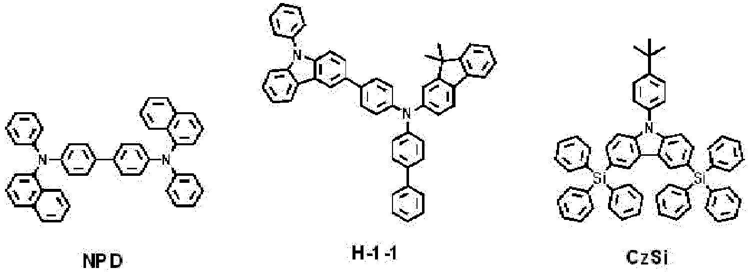

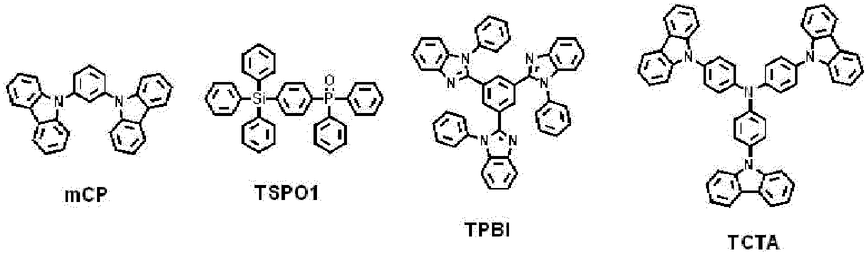

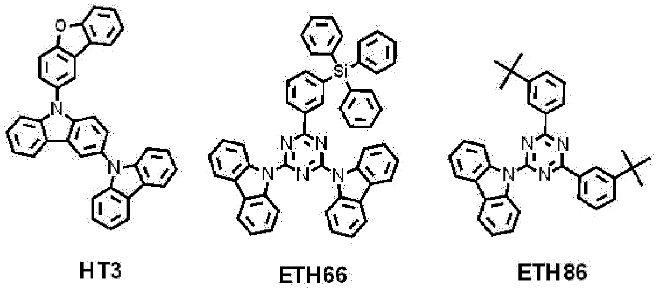

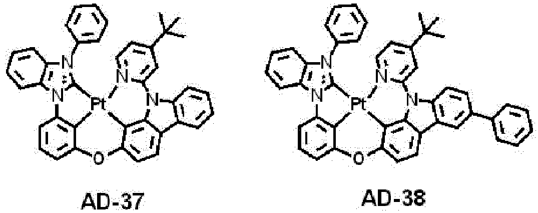

### Dopant materials of Examples and Comparative Examples utilized in the manufacturing of the light-emitting element

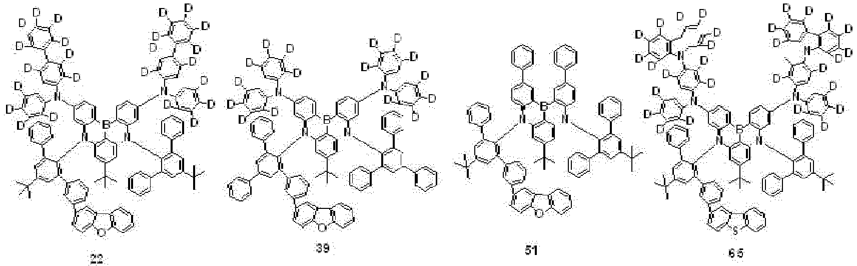

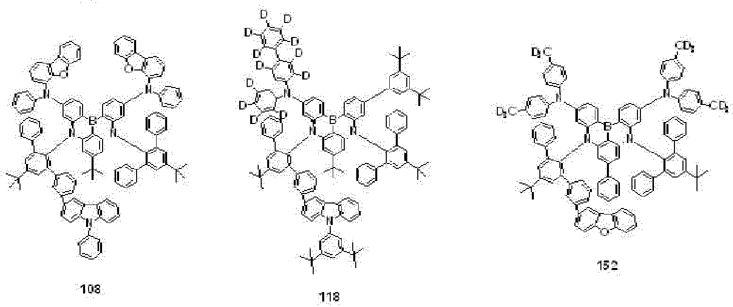

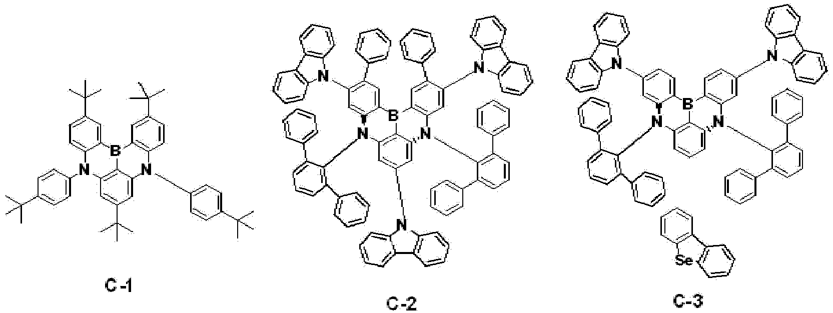

Table 1 shows combinations of materials utilized in the emission layers of Examples and Comparative Examples.

**Table 1**

| Classification | HT host | ET host | Phosphorescent sensitizer | Dopant |
|---|---|---|---|---|
| Example 1-1 | HT3 | ETH66 | AD-38 | 22 |
| Example 1-2 | HT3 | ETH66 | AD-38 | 39 |
| Example 1-3 | HT3 | ETH66 | AD-38 | 51 |
| Example 1-4 | HT3 | ETH66 | AD-38 | 65 |
| Example 1-5 | HT3 | ETH66 | AD-38 | 108 |
| Example 1-6 | HT3 | ETH66 | AD-38 | 118 |
| Example 1-7 | HT3 | ETH66 | AD-38 | 152 |
| Comparative Example 1-1 | HT3 | ETH66 | AD-38 | C-1 |
| Comparative Example 1-2 | HT3 | ETH66 | AD-38 | C-2 |
| Comparative Example 1-3 | HT3 | ETH66 | AD-38 | C-3 |
| Example 2-1 | HT3 | ETH86 | AD-37 | 22 |
| Example 2-2 | HT3 | ETH86 | AD-37 | 39 |
| Example 2-3 | HT3 | ETH86 | AD-37 | 51 |
| Example 2-4 | HT3 | ETH86 | AD-37 | 65 |
| Example 2-5 | HT3 | ETH86 | AD-37 | 108 |
| Example 2-6 | HT3 | ETH86 | AD-37 | 118 |
| Example 2-7 | HT3 | ETH86 | AD-37 | 152 |
| Comparative Example 2-1 | HT3 | ETH86 | AD-37 | C-1 |
| Comparative Example 2-2 | HT3 | ETH86 | AD-37 | C-2 |
| Comparative Example 2-3 | HT3 | ETH86 | AD-37 | C-3 |

### (2) Evaluation of light-emitting element

The light-emitting elements of Examples and Comparative Examples were evaluated, and the results were shown in Table 2. In the light-emitting elements according to Examples and Comparative Examples, driving voltages (V), luminous efficiency (cd/A), and emission wavelengths (nm) at a current density of about 10 mA/cm² were measured utilizing Keithley MU 236 and the luminance meter PR650. The time taken for luminance to decrease to 95% of an initial luminance was measured, and relative values were calculated by comparing to the value of Comparative Example 2-1, and the results were listed as the lifespan(T95) of the elements.

**Table 2**

| Classification | Driving voltage (V) | Efficiency (cd/A) | Emission wavelength (nm) | Lifespan ratio (T95) |
|---|---|---|---|---|
| Example 1-1 | 4.4 | 25.3 | 457 | 4.7 |
| Example 1-2 | 4.4 | 24.6 | 458 | 4.6 |
| Example 1-3 | 4.5 | 25.0 | 459 | 4.6 |
| Example 1-4 | 4.5 | 24.3 | 458 | 4.7 |
| Example 1-5 | 4.3 | 24.8 | 458 | 4.5 |
| Example 1-6 | 4.4 | 25.1 | 458 | 5.1 |
| Example 1-7 | 4.5 | 24.9 | 459 | 4.9 |
| Comparative Example 1-1 | 5.5 | 15.8 | 463 | 0.9 |
| Comparative Example 1-2 | 5.0 | 16.8 | 458 | 2.4 |
| Comparative Example 1-3 | 5.2 | 17.0 | 464 | 2.6 |
| Example 2-1 | 4.4 | 25.0 | 458 | 4.8 |
| Example 2-2 | 4.5 | 24.8 | 458 | 4.8 |
| Example 2-3 | 4.4 | 24.9 | 459 | 4.9 |
| Example 2-4 | 4.5 | 24.3 | 459 | 5.0 |
| Example 2-5 | 4.4 | 24.9 | 458 | 4.7 |
| Example 2-6 | 4.4 | 25.0 | 458 | 4.9 |
| Example 2-7 | 4.5 | 24.7 | 459 | 4.8 |
| Comparative Example 2-1 | 5.5 | 16.5 | 462 | 1.0 |
| Comparative Example 2-2 | 5.1 | 17.5 | 458 | 2.6 |
| Comparative Example 2-3 | 5.1 | 17.9 | 464 | 2.9 |

Referring to the results in Table 2, it can be seen that the light-emitting elements according to Examples show lower driving voltage characteristics than the light-emitting elements according to Comparative Examples. In some embodiments, the light-emitting elements according to Examples show similar emission wavelength characteristics with the light-emitting elements according to Comparative Examples including Comparative Example Compounds having similar core structures with Example Compounds.

In some embodiments, Examples show higher luminous efficiency and more excellent or suitable lifespan characteristics than Comparative Examples. For example, in the case of Examples, it is seen that because the polycyclic compound, according to one or more embodiments, with improved material stability is included in the emission layer, deterioration of the polycyclic compound in the emission layer is reduced, so that the luminous efficiency of the emission layer and the lifespan characteristics of the element are improved.

In the light-emitting element according to one or more embodiments, the emission layer may include the polycyclic compound according to one or more embodiments. The polycyclic compound according to one or more embodiments includes a pentacyclic fused ring, containing two nitrogen atoms and one boron atom as ring-forming atoms, as a core structure, and includes two terphenyl derivatives bonded to the pentacyclic fused ring core and a polycyclic ring connecting the two terphenyl derivatives. In some embodiments, the polycyclic compound according to one or more embodiments may have a structure in which the pentacyclic fused ring core is protected by the terphenyl derivatives, the polycyclic ring, and in addition thereto, substituents and/or the like. Accordingly, in the polycyclic compound according to one or more embodiments, a multi-resonance core part, in which luminescence-related transitions occur, may be protected, so that inter-molecular interactions that might cause side reactions, other than the luminescence, may be suppressed or reduced, thereby increasing material stability. In some embodiments, as including such polycyclic compound according to one or more embodiments in the emission layer, the light-emitting element according to one or more embodiments may have high luminous efficiency and long lifespan characteristics.

In some embodiments, the polycyclic compound according to one or more embodiments may be utilized as a thermally activated delayed fluorescent material. Therefore, the light-emitting element including the polycyclic compound according to one or more embodiments may have high luminous efficiency and long lifespan characteristics.

A light-emitting element according to one or more embodiments may include a polycyclic compound, according to one or more embodiments, in an emission layer, and thus have high efficiency and long lifespan characteristics.

The polycyclic compound according to one or more embodiments may contribute to improvements in luminous efficiency and long lifespan of the light-emitting element.

A display device according to one or more embodiments may provide excellent or suitable display quality.

## Claims

1. A polycyclic compound represented by Formula 1, 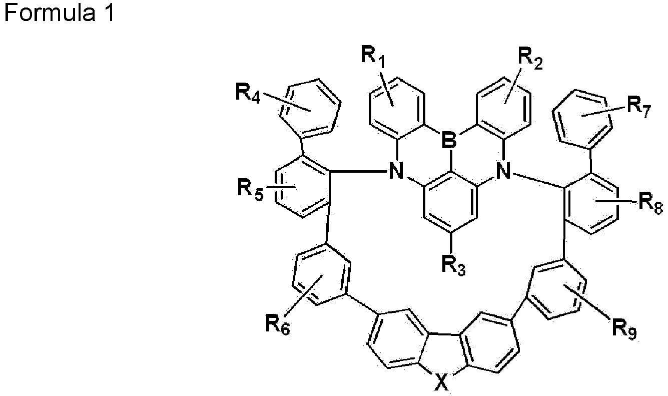
wherein, in Formula 1,
X is O, S, Se, NRₐ, or CR_{b}R_{c},
R₁ to R₉ are each independently a hydrogen atom, a deuterium atom, a halogen atom, a cyano group, a substituted or unsubstituted alkyl group having 1 to 10 carbon atoms, a substituted or unsubstituted alkenyl group having 2 to 10 carbon atoms, a substituted or unsubstituted oxy group, a substituted or unsubstituted thio group, a substituted or unsubstituted aryl group having 6 to 30 ring-forming carbon atoms, or a substituted or unsubstituted heteroaryl group having 3 to 30 ring-forming carbon atoms, and/or bonded to an adjacent group to form a ring, and
Rₐ to R_{c} are each independently a hydrogen atom, a deuterium atom, a halogen atom, a substituted or unsubstituted alkyl group having 1 to 10 carbon atoms, a substituted or unsubstituted alkenyl group having 2 to 10 carbon atoms, a substituted or unsubstituted oxy group, a substituted or unsubstituted thio group, a substituted or unsubstituted aryl group having 6 to 30 ring-forming carbon atoms, or a substituted or unsubstituted heteroaryl group having 3 to 30 ring-forming carbon atoms.

2. The polycyclic compound of claim 1, wherein at least one selected from among R₁ or R₂ in Formula 1 is a substituted or unsubstituted aryl group having 6 to 30 ring-forming carbon atoms, or a substituted or unsubstituted heteroaryl group having 3 to 30 ring-forming carbon atoms.

3. The polycyclic compound of claim 1, wherein R₁ and R₂ in Formula 1 are each independently a substituted or unsubstituted aryl group having 6 to 20 ring-forming carbon atoms, or a substituted or unsubstituted heteroaryl group having 6 to 30 ring-forming carbon atoms.

4. The polycyclic compound of any one of claims 1 to 3, wherein at least one among the hydrogen atoms of the compound is substituted with a deuterium atom.

5. The polycyclic compound of any one of claims 1 to 4, wherein R₃ in Formula 1 is a hydrogen atom, a substituted or unsubstituted alkyl group having 1 to 10 carbon atoms, a substituted or unsubstituted aryl group having 6 to 20 ring-forming carbon atoms, or a substituted or unsubstituted heteroaryl group having 6 to 30 ring-forming carbon atoms.

6. The polycyclic compound of any one of claims 1 to 5, wherein Formula 1 is represented by any one selected from among Formula 1-1 to Formula 1-4, 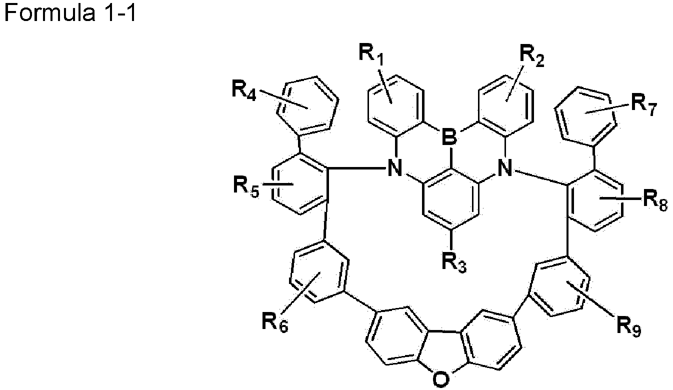 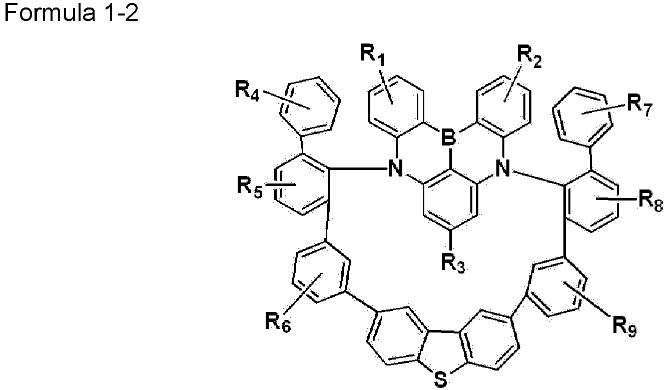 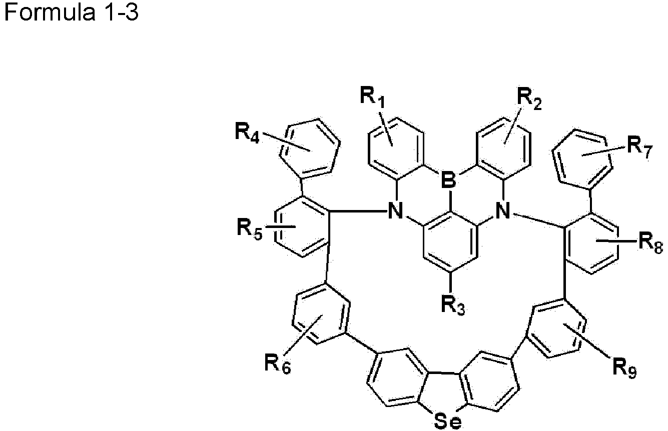 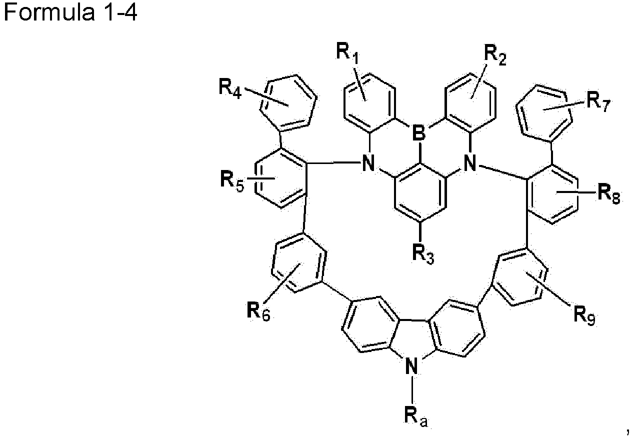 and
wherein, in Formula 1-1 to Formula 1-4, R₁ to R₉, and Rₐ are as defined in Formula 1.

7. The polycyclic compound of claim 1, wherein Formula 1 is represented by any one selected from among compounds of Compound Group 1, 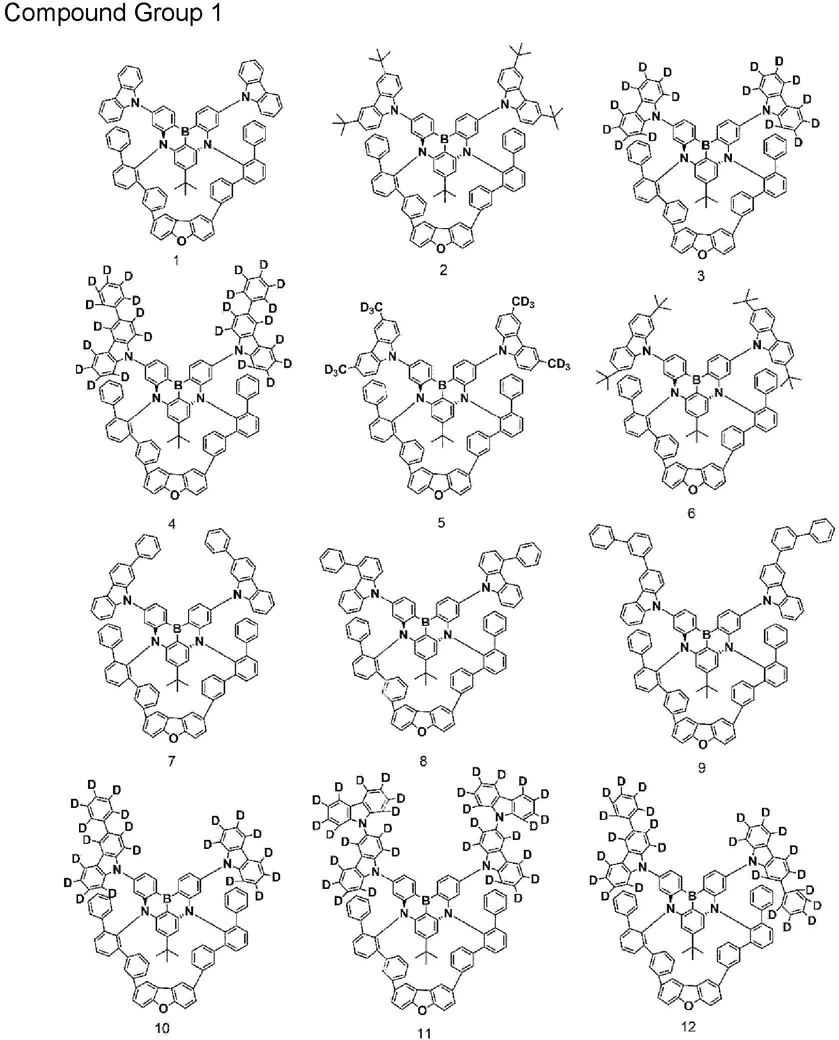 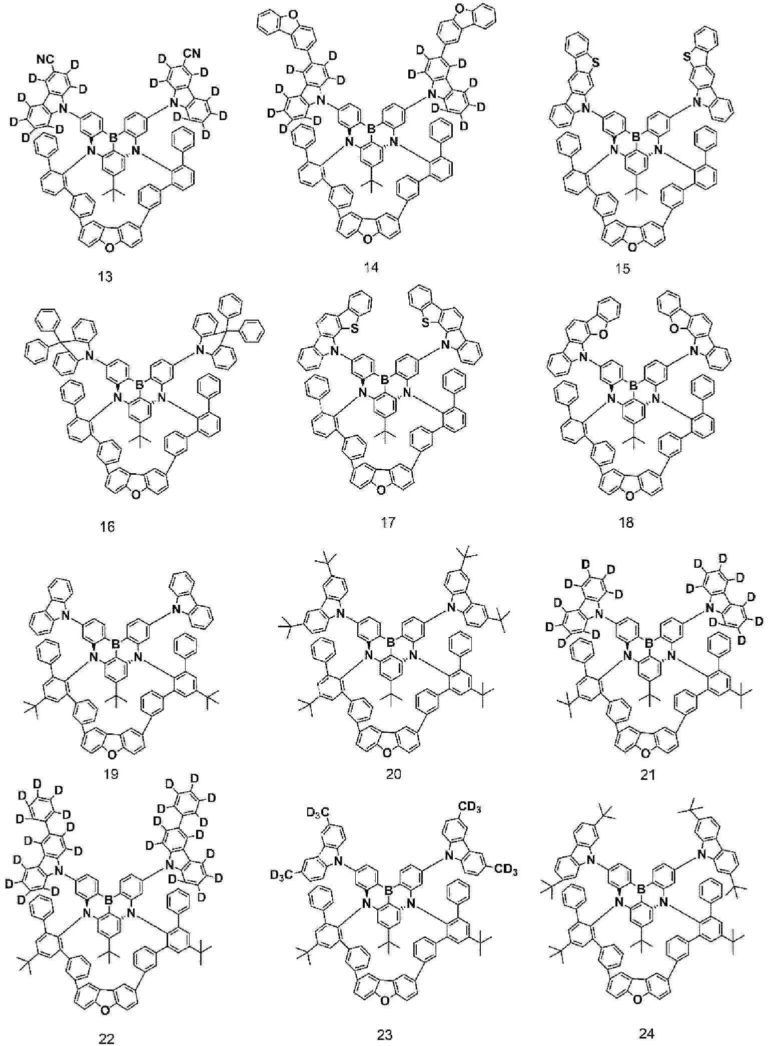 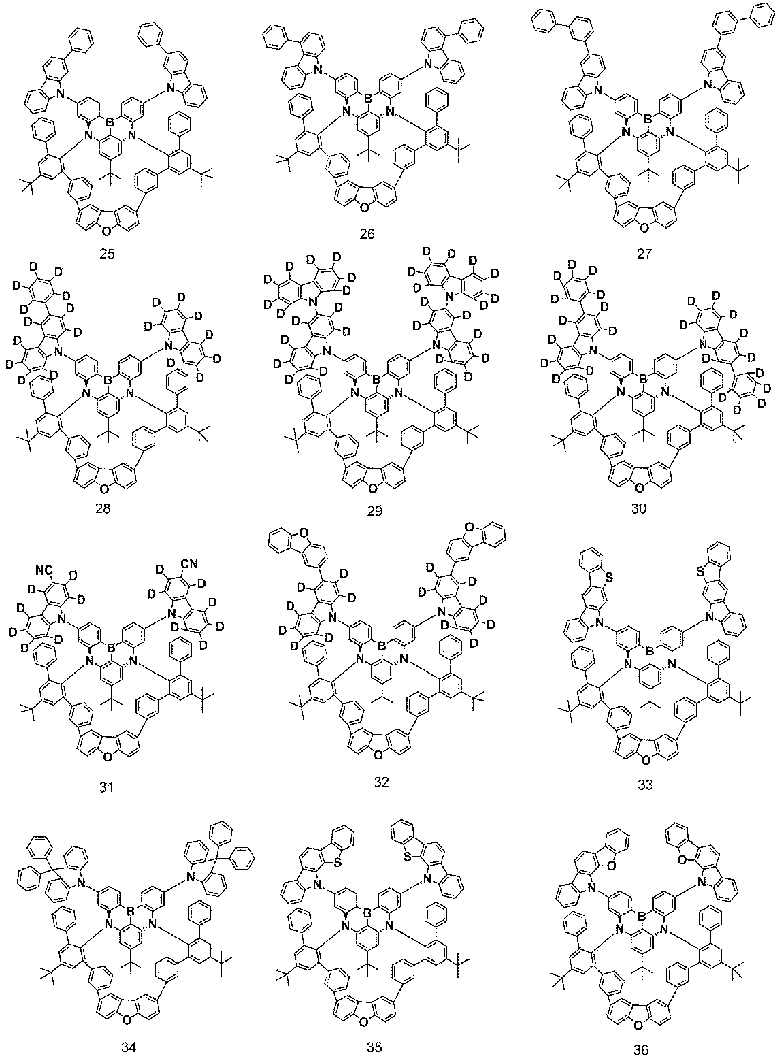 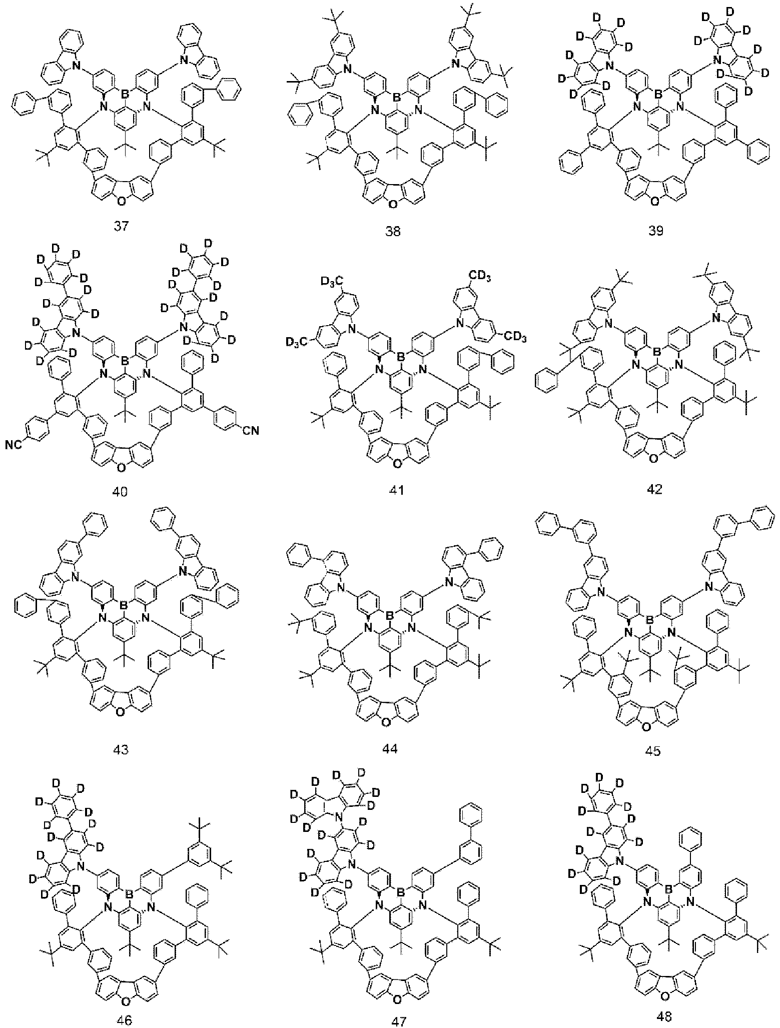 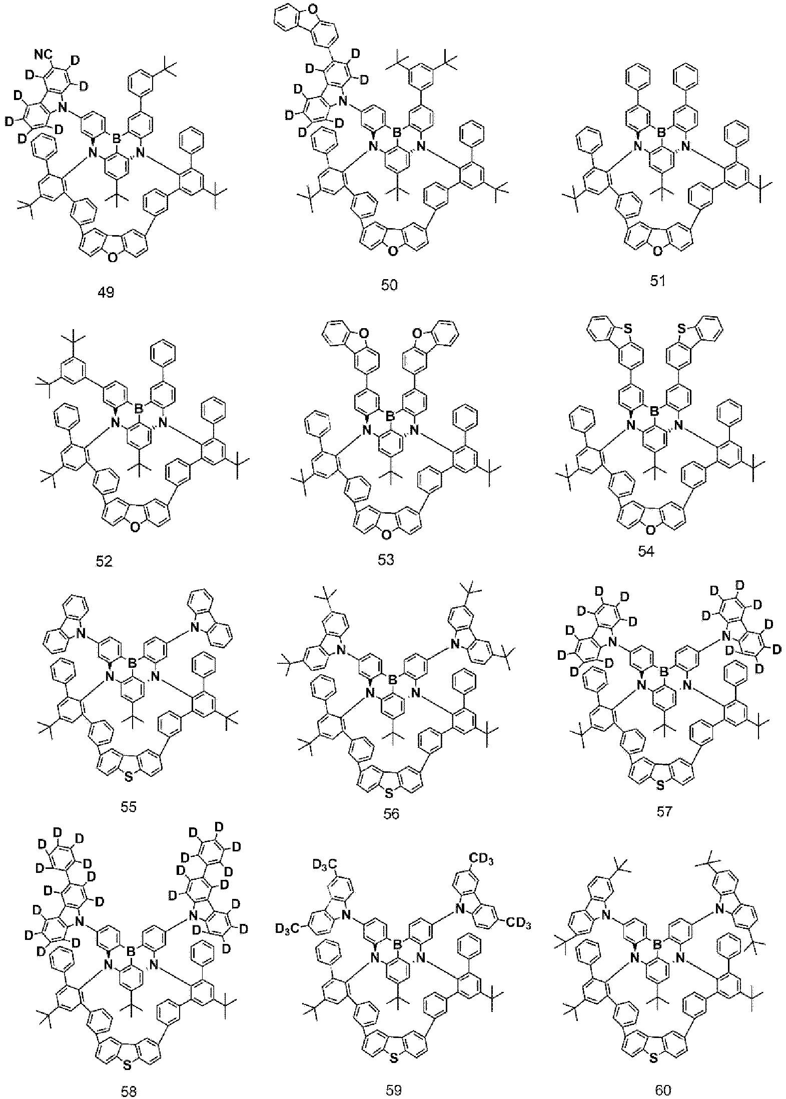 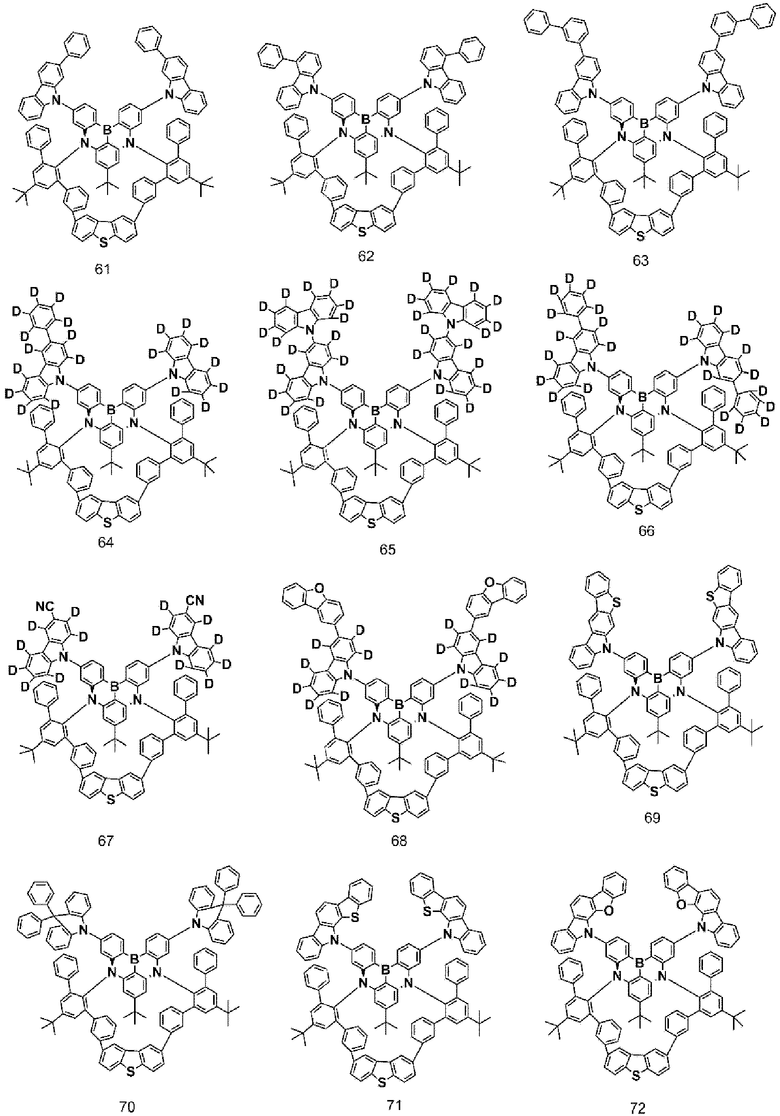 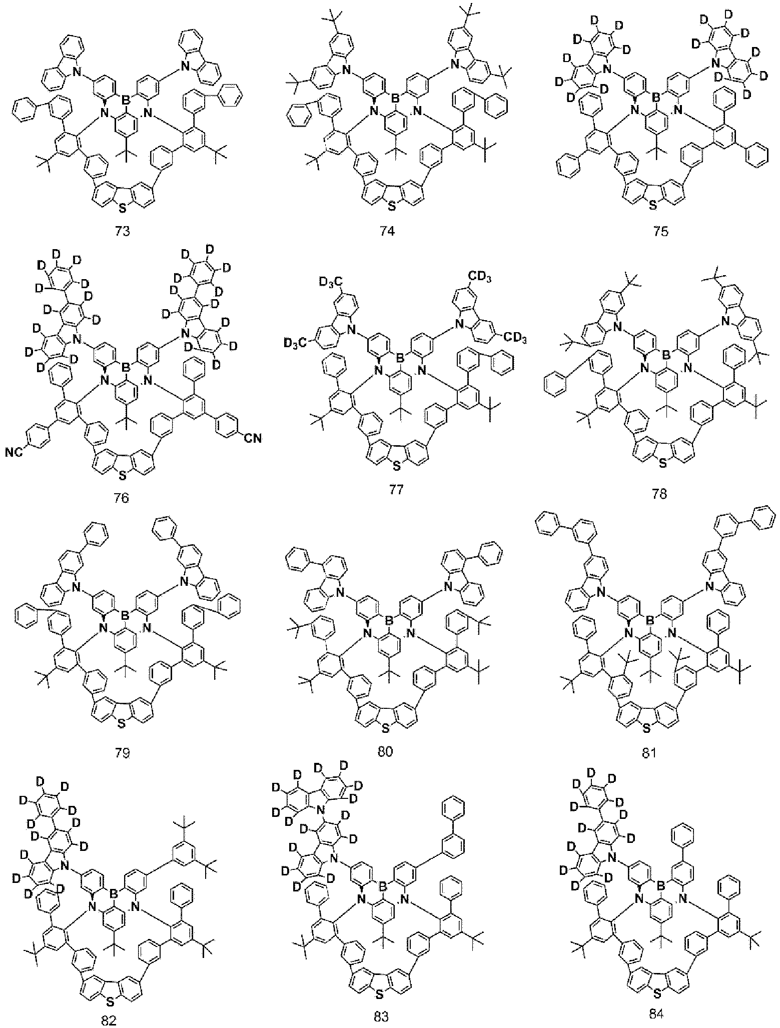 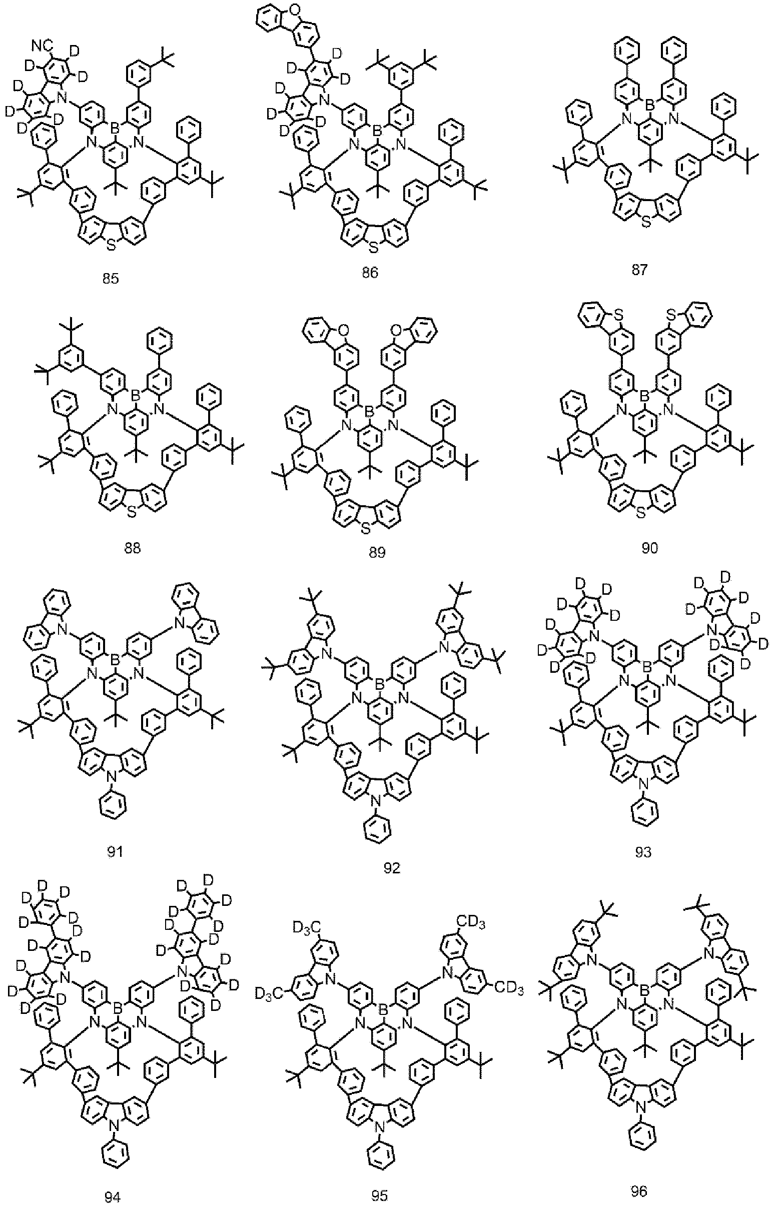 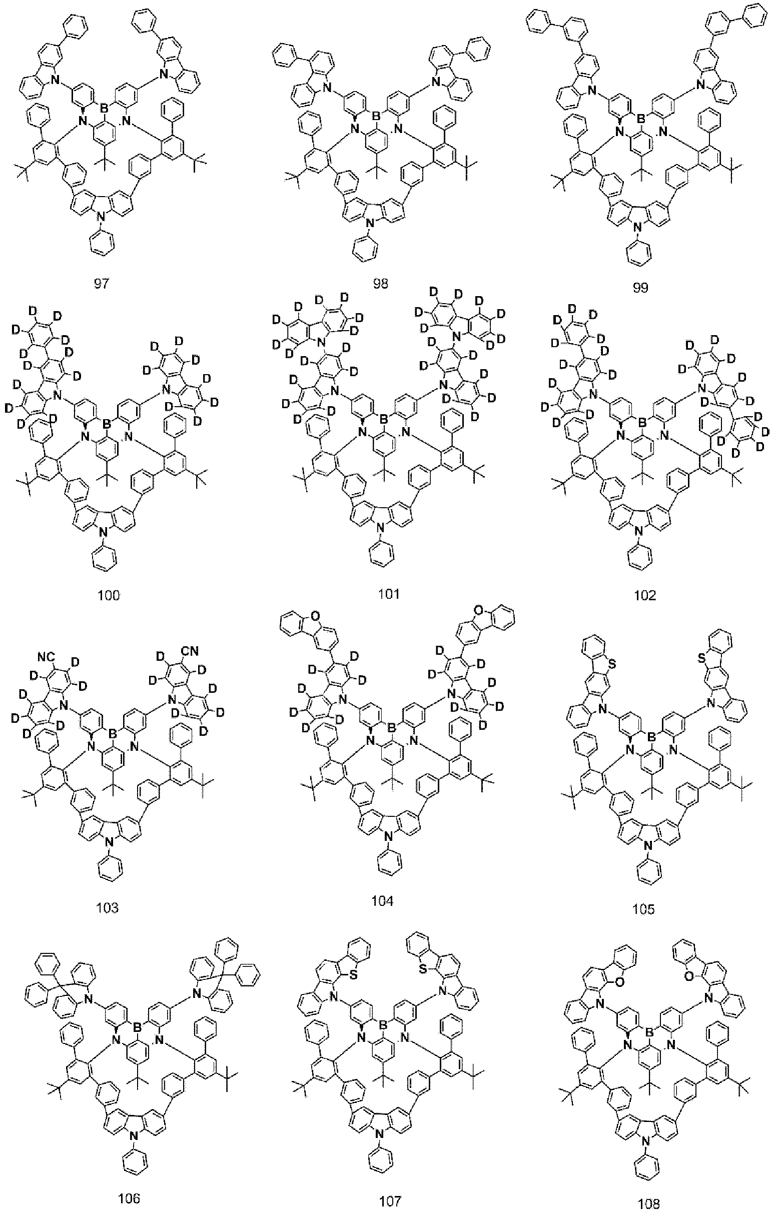 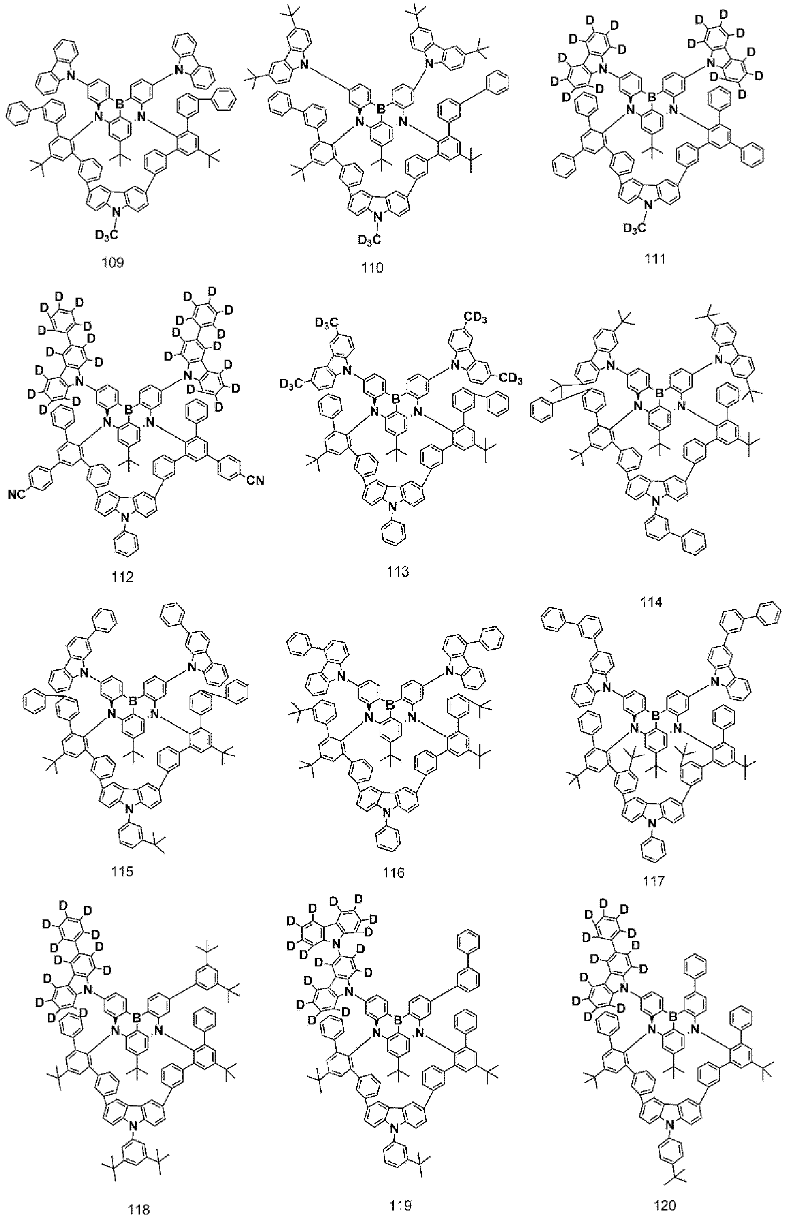 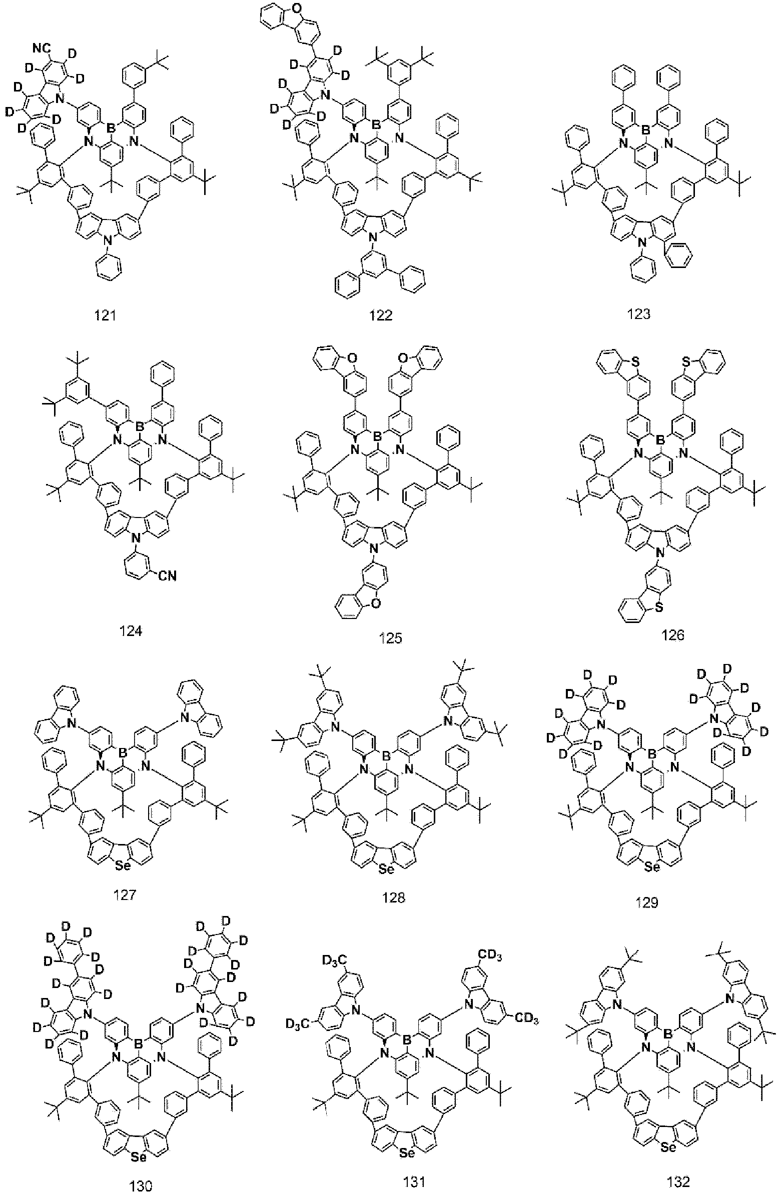 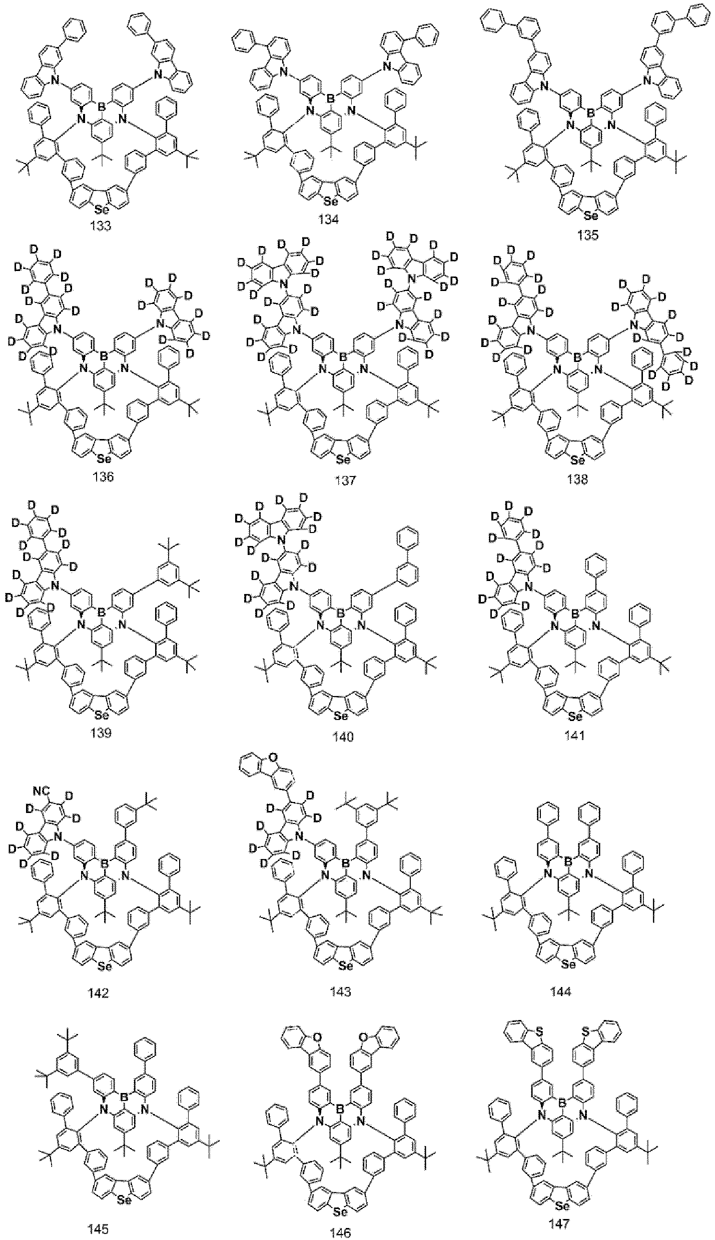 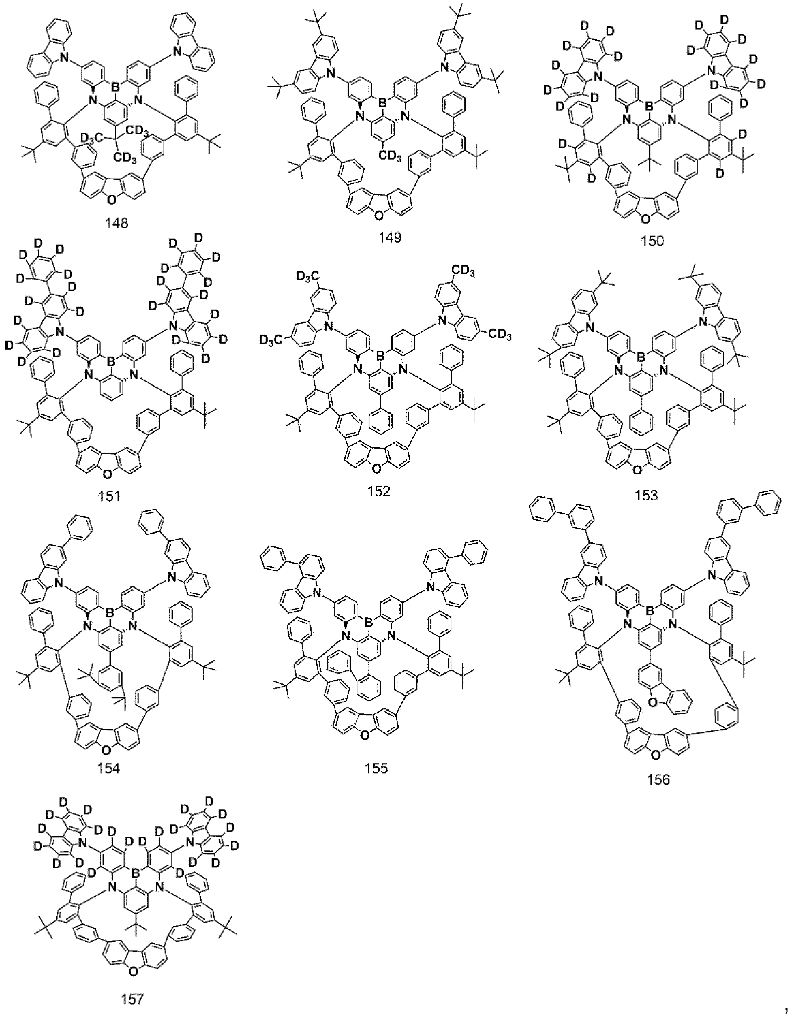 and
wherein, in Compound Group 1, D represents a deuterium atom.

8. Use of a polycyclic compound of any one of claims 1 to 7 as a delayed fluorescent dopant.

9. A light-emitting element comprising:
a first electrode;
a second electrode on the first electrode; and
an emission layer between the first electrode and the second electrode, and comprising a first compound according to any one of claims 1 to 7.

10. The light-emitting element of claim 9, wherein the emission layer further comprises at least one selected from among a second compound represented by Formula HT-1 or a third compound represented by Formula ET-1, 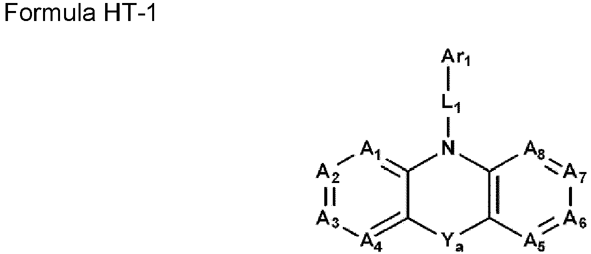
wherein, in Formula HT-1,
A₁ to A₈ are each independently N or CR₅₁,
L₁ is a direct linkage, a substituted or unsubstituted arylene group having 6 to 30 ring-forming carbon atoms, or a substituted or unsubstituted heteroarylene group having 2 to 30 ring-forming carbon atoms,
Yₐ is a direct linkage, CR₅₂R₅₃, or SiR₅₄R₅₅,
Ar₁ is a substituted or unsubstituted aryl group having 6 to 30 ring-forming carbon atoms, or a substituted or unsubstituted heteroaryl group having 2 to 30 ring-forming carbon atoms, and
R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, and/or are bonded to an adjacent group to form a ring, and
Formula ET-1 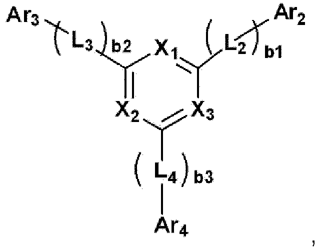 and
wherein, in Formula ET-1,
X₁ to X₃ are each N or CR₅₆ and at least one selected from among X₁ to X₃ is N, R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
b1 to b3 are each independently an integer of 0 to 10,
Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and
L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms.

11. The light-emitting element of claim 10, wherein the emission layer further comprises a fourth compound represented by Formula D-1, 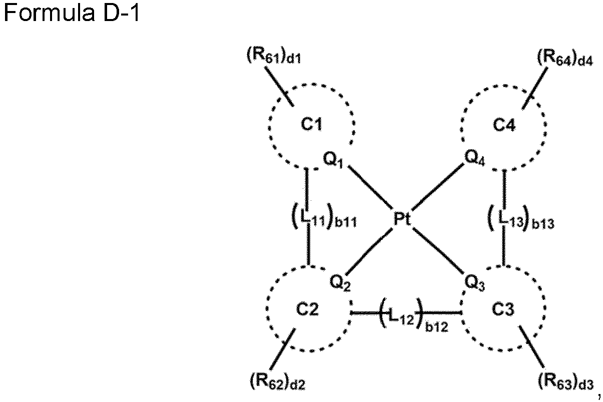 and
wherein, in Formula D-1,
Q₁ to Q₄ are each independently C or N,
C1 to C4 are each independently a substituted or unsubstituted hydrocarbon ring having 5 to 30 ring-forming carbon atoms, or a substituted or unsubstituted hetero ring having 2 to 30 ring-forming carbon atoms,
L₁₁ to L₁₃ are each independently a direct linkage, *-o-*, *-s-*, 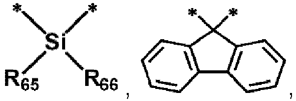 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
b11 to b13 are each independently 0 or 1,
R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, and
d1 to d4 are each independently an integer of 0 to 4.

12. The light-emitting element of claim 11, wherein the emission layer comprises the first compound, the second compound, the third compound, and the fourth compound.

13. The light-emitting element of any one of claims 9 to 12, wherein:
(i) the emission layer is configured to emit delayed fluorescence; and/or
(ii) the emission layer is configured to emit blue color light.

14. A display device comprising:
a base layer;
a circuit layer on the base layer; and
a display element layer on the circuit layer and comprising a light-emitting element,
wherein the light-emitting element comprises a first electrode, a second electrode facing the first electrode, and an emission layer between the first electrode and the second electrode and comprising a polycyclic compound according to any one of claims 1 to 8.

15. The display device of claim 14, wherein:
(i) the light-emitting element is configured to emit blue color light; and/or
(ii) the display device further comprises a light control layer comprising a quantum dot.

## Patentansprüche

1. Polyzyklische Verbindung, dargestellt durch Formel 1, 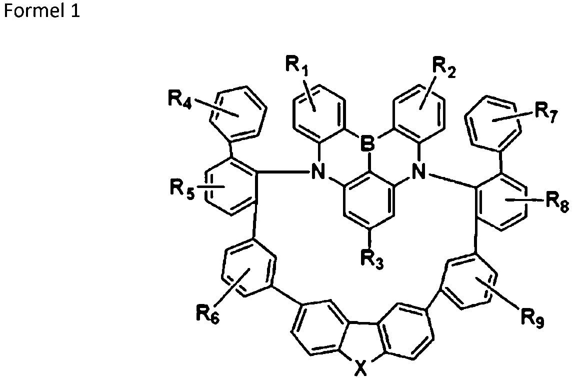
wobei in Formel 1
X O, S, Se, NRₐ oder CR_{b}R_{c} ist,
R₁ bis R₉ jeweils unabhängig voneinander ein Wasserstoffatom, ein Deuteriumatom, ein Halogenatom, eine Cyanogruppe, eine substituierte oder unsubstituierte Alkylgruppe mit 1 bis 10 Kohlenstoffatomen, eine substituierte oder unsubstituierte Alkenylgruppe mit 2 bis 10 Kohlenstoffatomen, eine substituierte oder unsubstituierte Oxygruppe, eine substituierte oder unsubstituierte Thiogruppe, eine substituierte oder unsubstituierte Arylgruppe mit 6 bis 30 ringbildenden Kohlenstoffatomen oder eine substituierte oder unsubstituierte Heteroarylgruppe mit 3 bis 30 ringbildenden Kohlenstoffatomen und/oder an eine benachbarte Gruppe gebunden sind, um einen Ring zu bilden, und
Rₐ bis R_{c} jeweils unabhängig voneinander ein Wasserstoffatom, ein Deuteriumatom, ein Halogenatom, eine substituierte oder unsubstituierte Alkylgruppe mit 1 bis 10 Kohlenstoffatomen, eine substituierte oder unsubstituierte Alkenylgruppe mit 2 bis 10 Kohlenstoffatomen, eine substituierte oder unsubstituierte Oxygruppe, eine substituierte oder unsubstituierte Thiogruppe, eine substituierte oder unsubstituierte Arylgruppe mit 6 bis 30 ringbildenden Kohlenstoffatomen oder eine substituierte oder unsubstituierte Heteroarylgruppe mit 3 bis 30 ringbildenden Kohlenstoffatomen sind.

2. Polycyclische Verbindung nach Anspruch 1, wobei mindestens eines von in Formel 1 ausgewähltem R₁ oder R₂ eine substituierte oder unsubstituierte Arylgruppe mit 6 bis 30 ringbildenden Kohlenstoffatomen oder eine substituierte oder unsubstituierte Heteroarylgruppe mit 3 bis 30 ringbildenden Kohlenstoffatomen ist.

3. Polycyclische Verbindung nach Anspruch 1, wobei R₁ und R₂ in Formel 1 jeweils unabhängig voneinander eine substituierte oder unsubstituierte Arylgruppe mit 6 bis 20 ringbildenden Kohlenstoffatomen oder eine substituierte oder unsubstituierte Heteroarylgruppe mit 6 bis 30 ringbildenden Kohlenstoffatomen sind.

4. Polycyclische Verbindung nach einem der Ansprüche 1 bis 3, wobei mindestens eines der Wasserstoffatome der Verbindung durch ein Deuteriumatom ersetzt ist.

5. Polycyclische Verbindung nach einem der Ansprüche 1 bis 4, wobei R₃ in Formel 1 ein Wasserstoffatom, eine substituierte oder unsubstituierte Alkylgruppe mit 1 bis 10 Kohlenstoffatomen, eine substituierte oder unsubstituierte Arylgruppe mit 6 bis 20 ringbildenden Kohlenstoffatomen oder eine substituierte oder unsubstituierte Heteroarylgruppe mit 6 bis 30 ringbildenden Kohlenstoffatomen ist.

6. Polycyclische Verbindung nach einem der Ansprüche 1 bis 5, wobei Formel 1 durch eine beliebige ausgewählt aus den Formeln 1-1 bis 1-4 dargestellt ist, 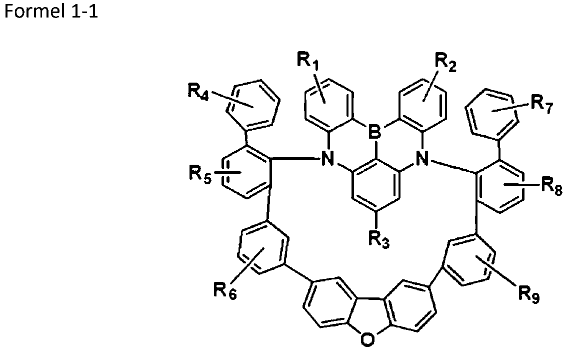 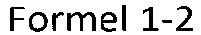 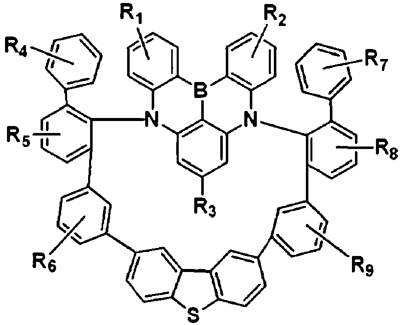 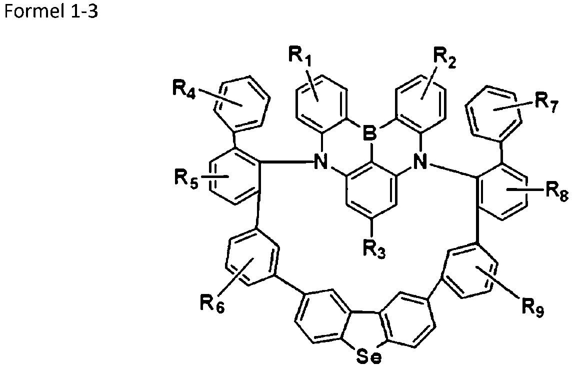 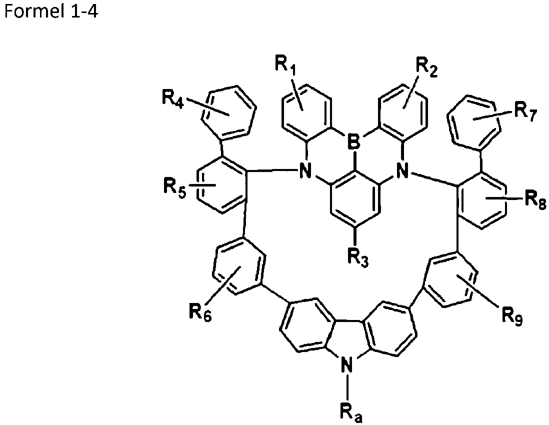 und
wobei in Formeln 1-1 bis 1-4 R₁ bis R₉und Rₐ wie in Formel 1 definiert sind.

7. Polycyclische Verbindung nach Anspruch 1, wobei die Formel 1 durch eine beliebige ausgewählt aus Verbindungen von Verbindungsgruppe 1 dargestellt ist, 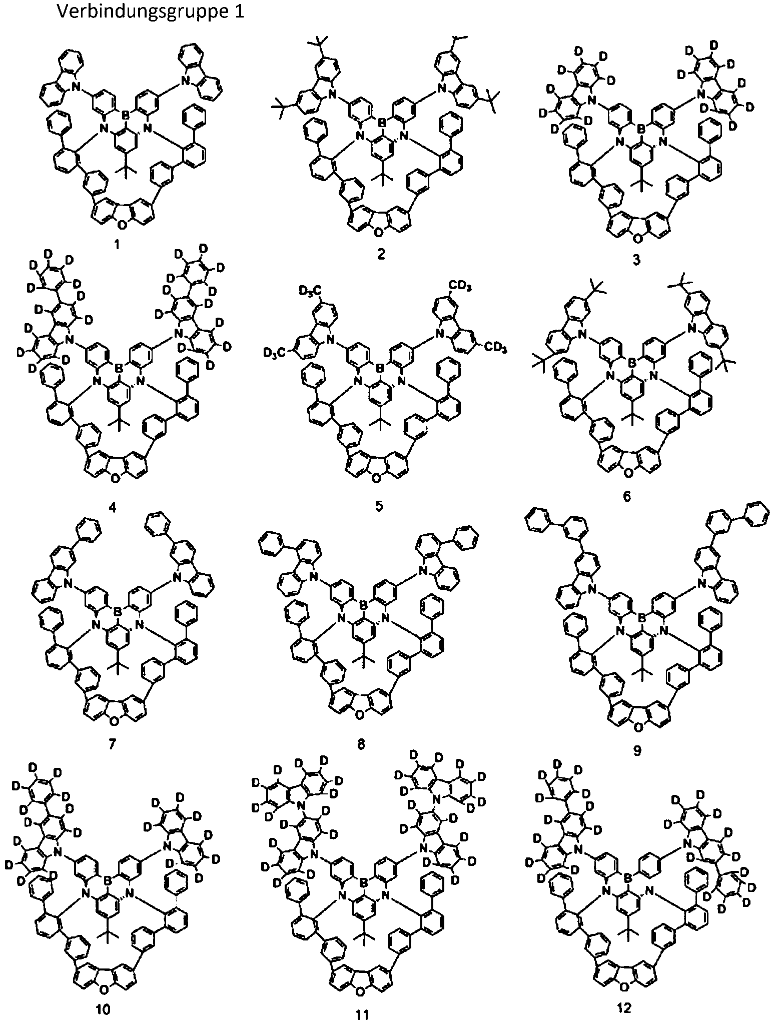 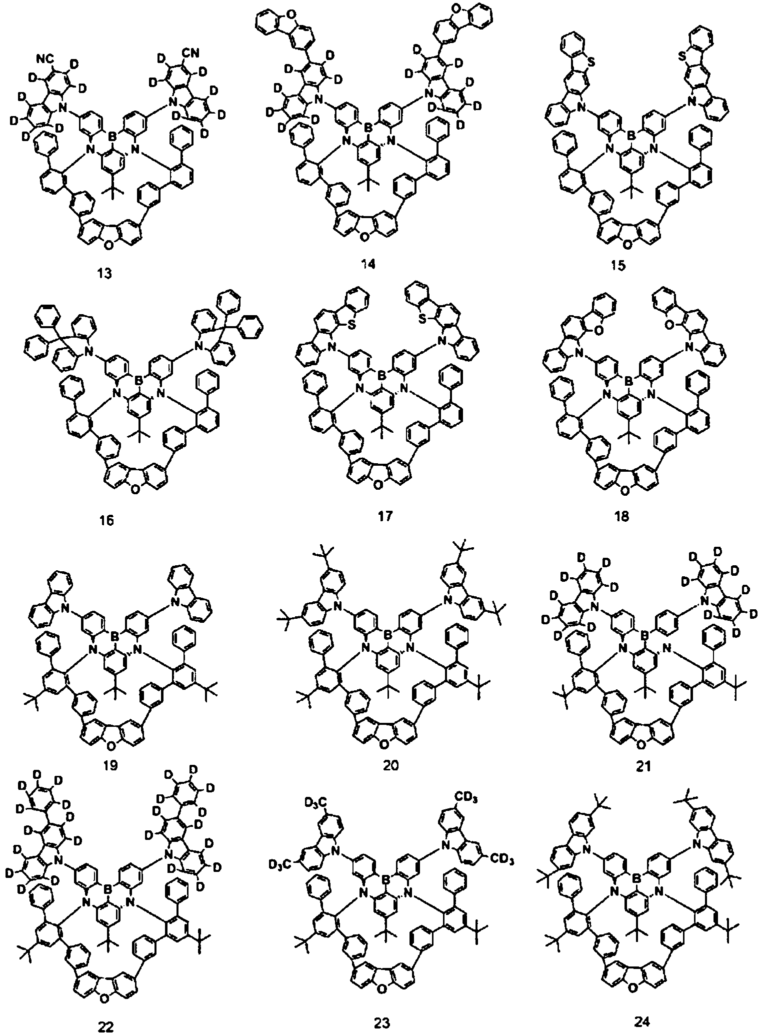 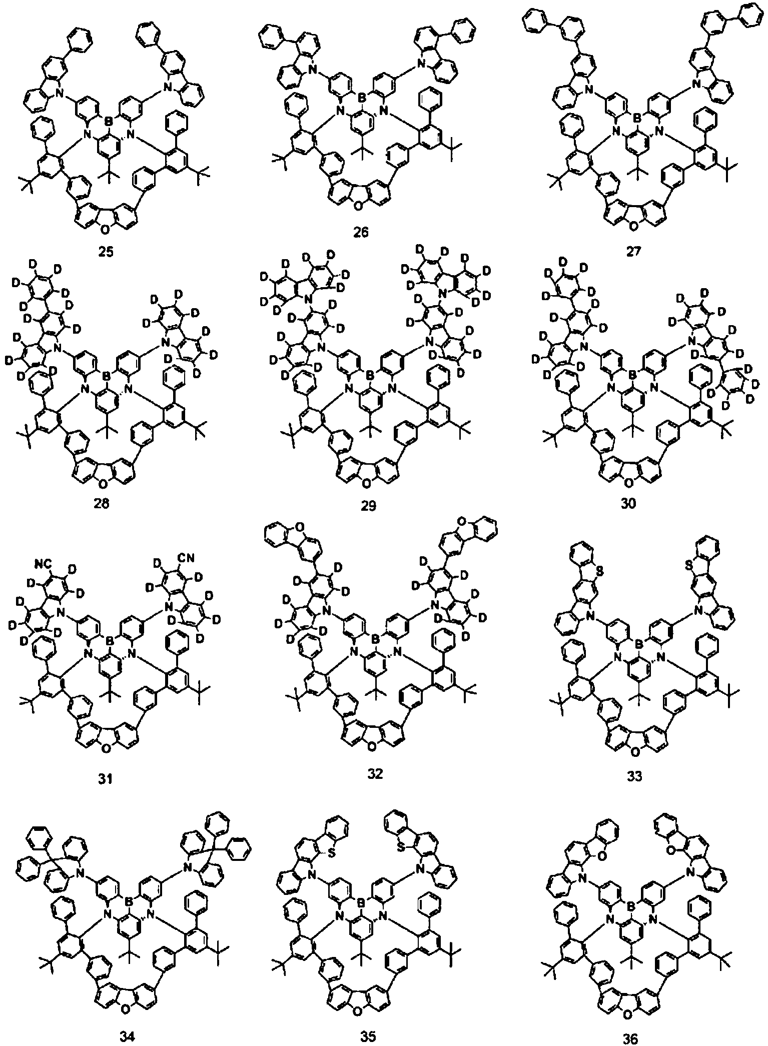 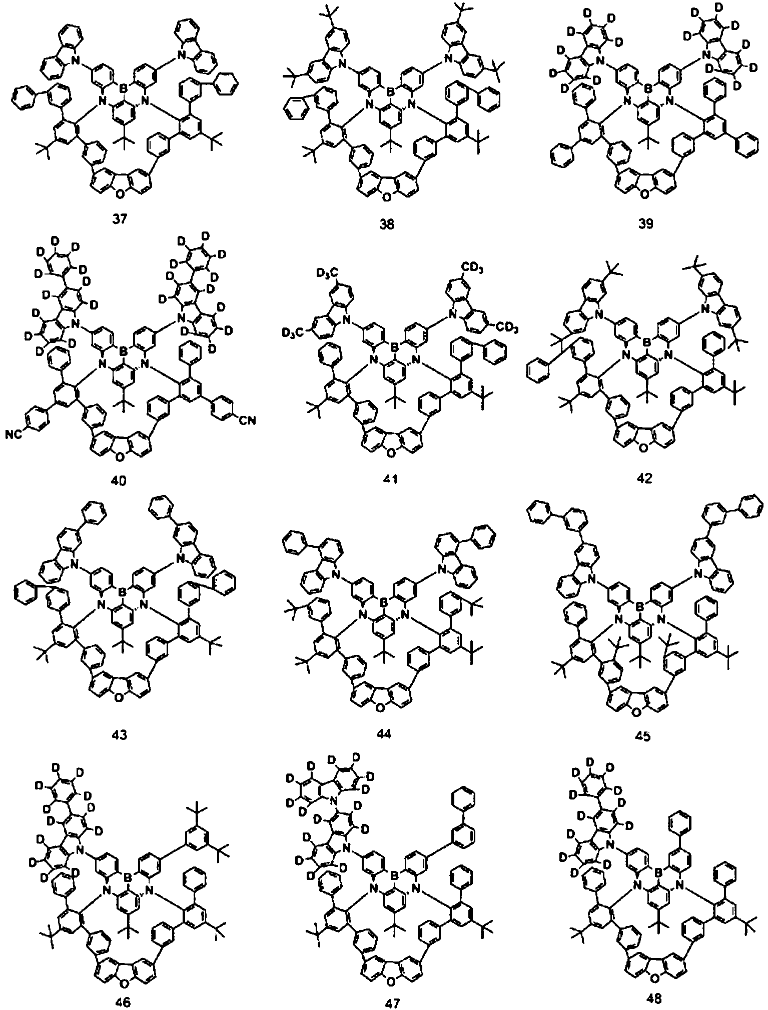 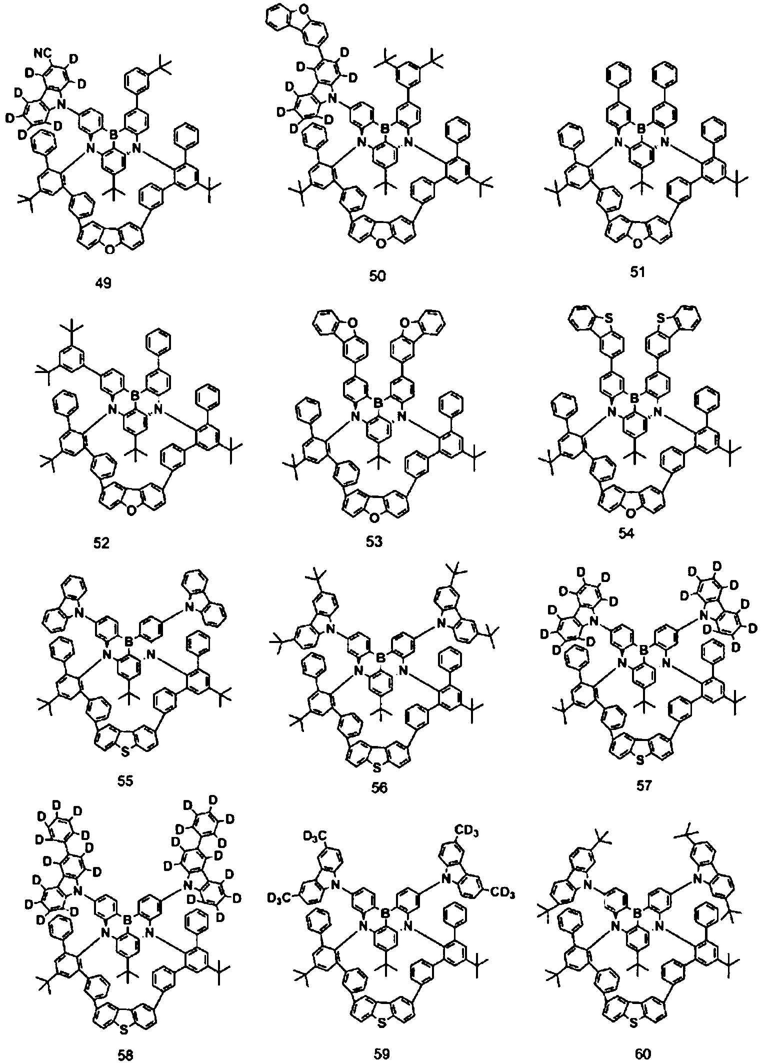 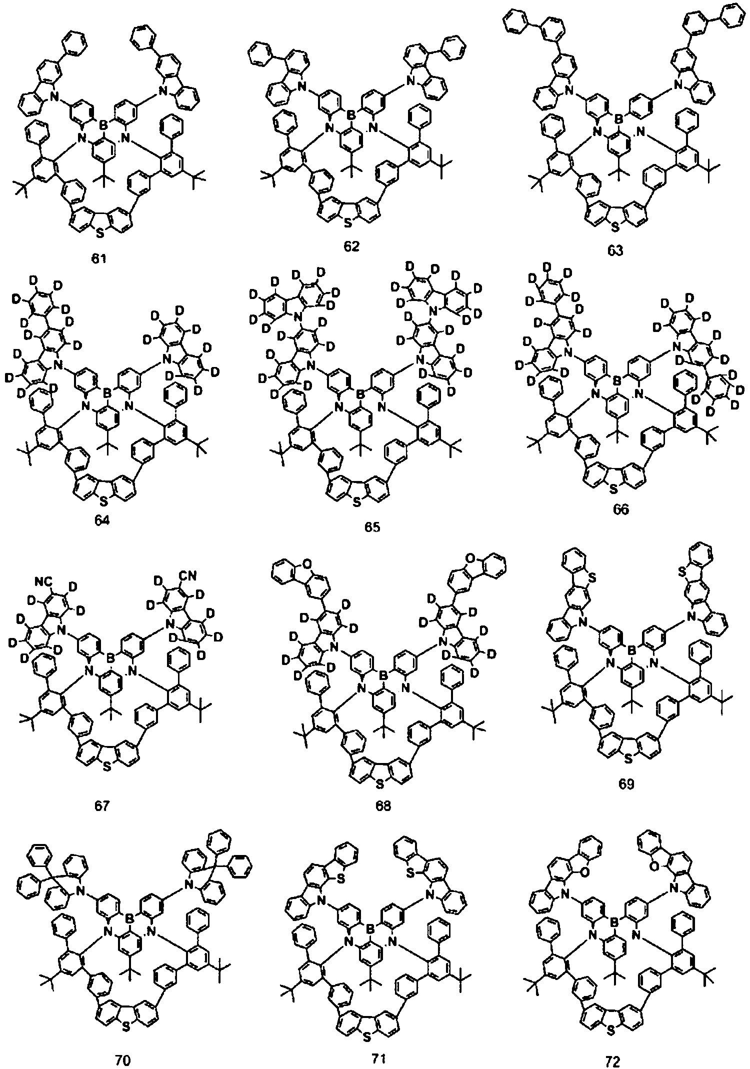 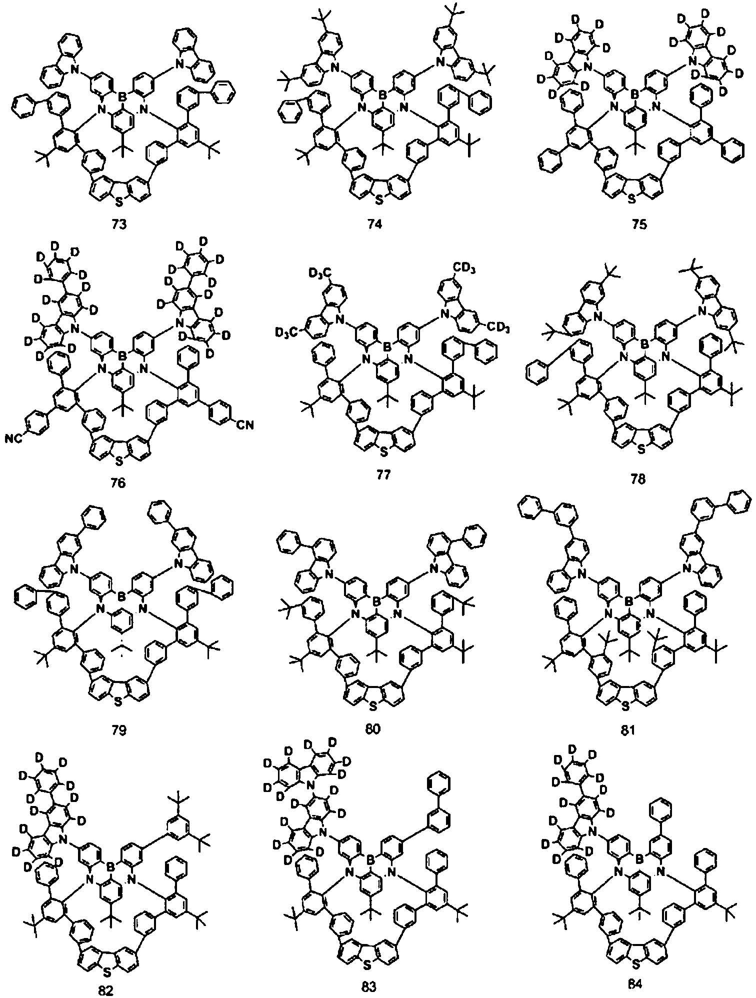 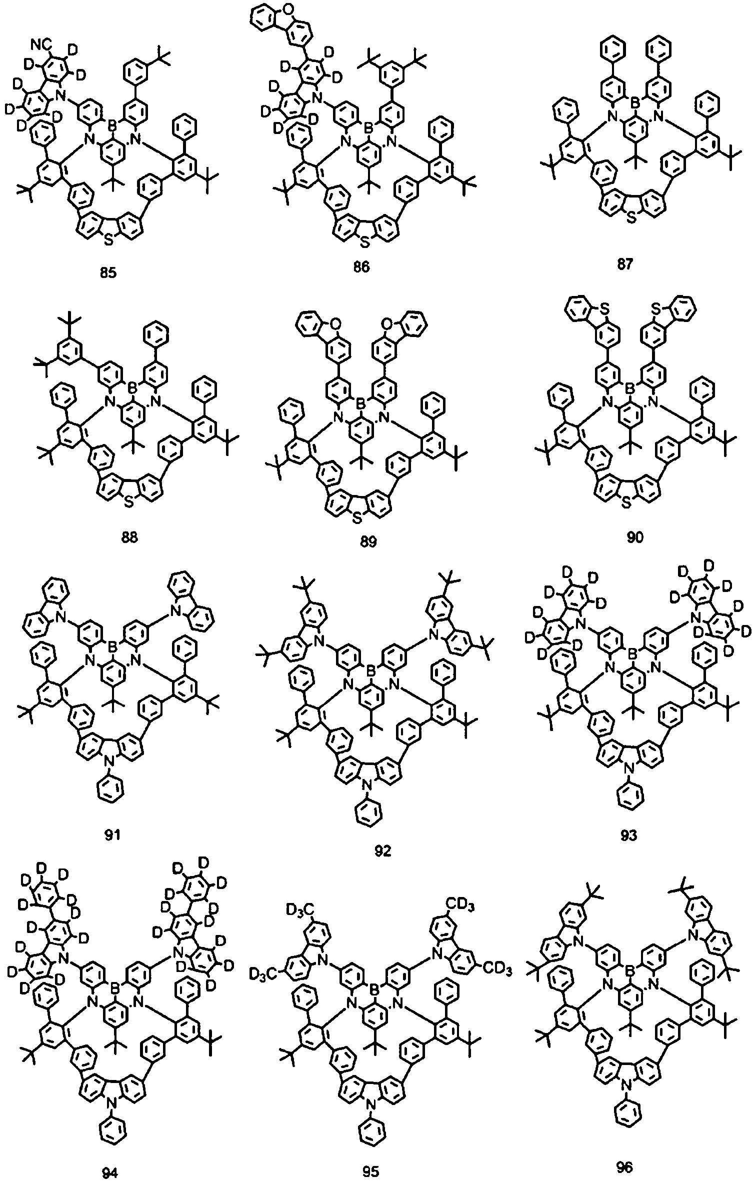 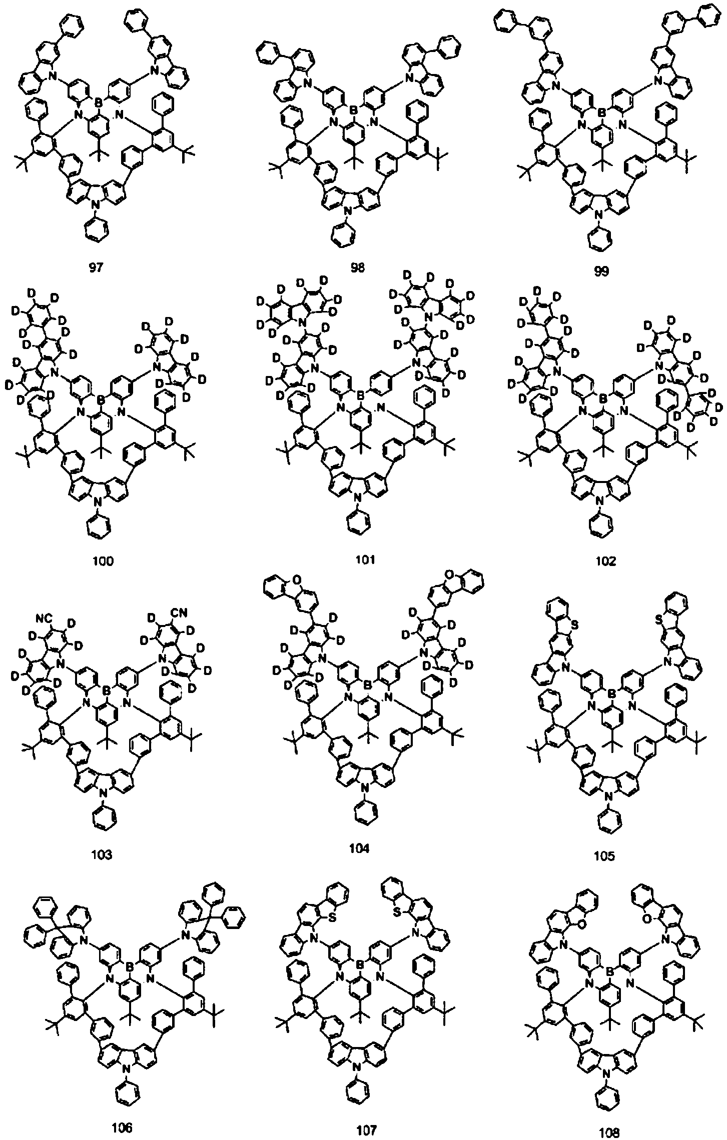 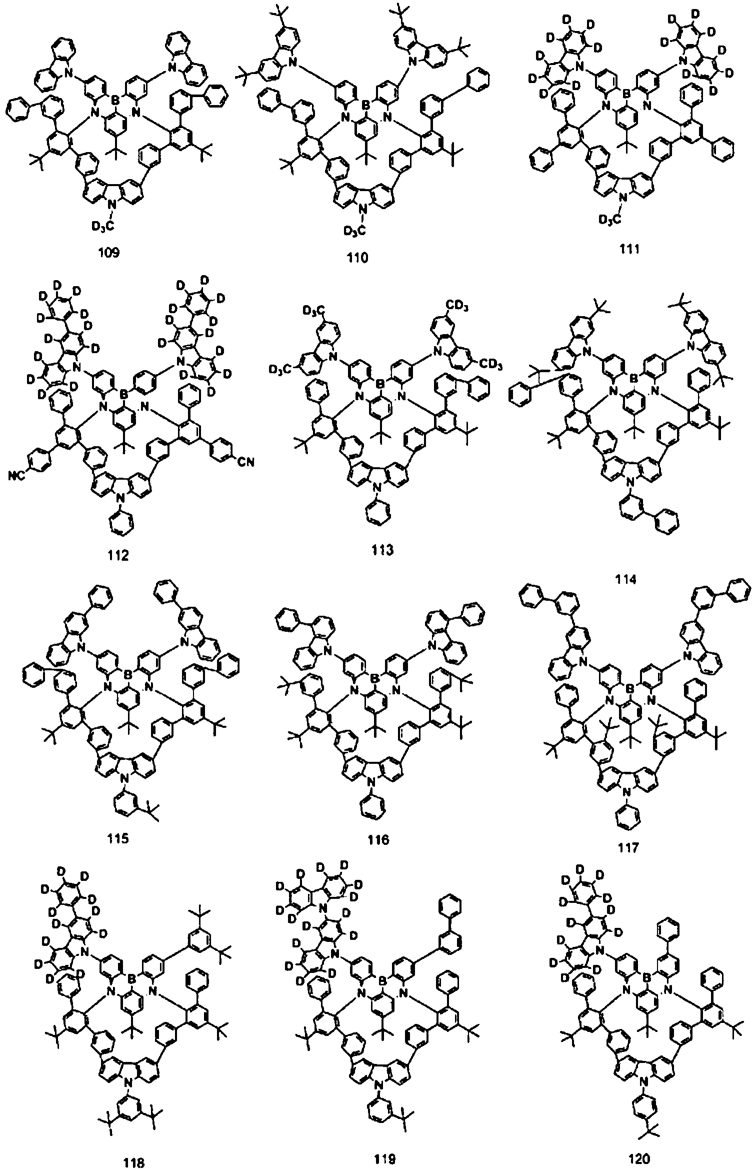 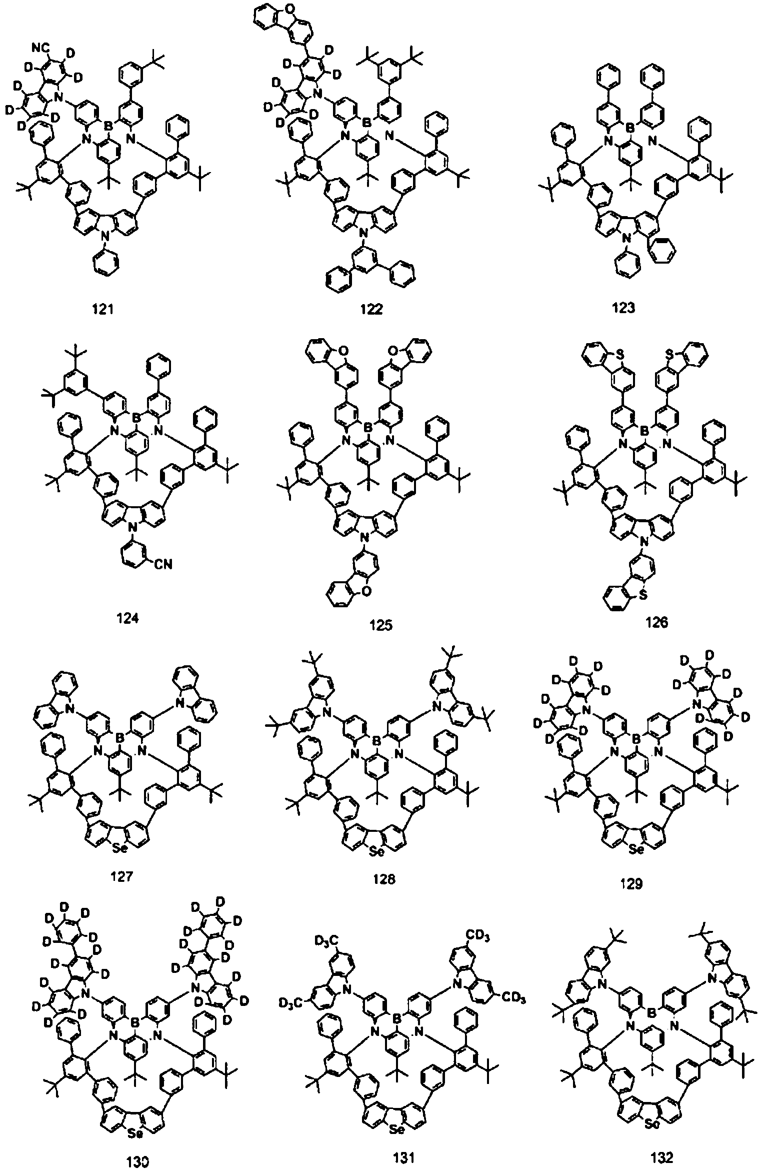 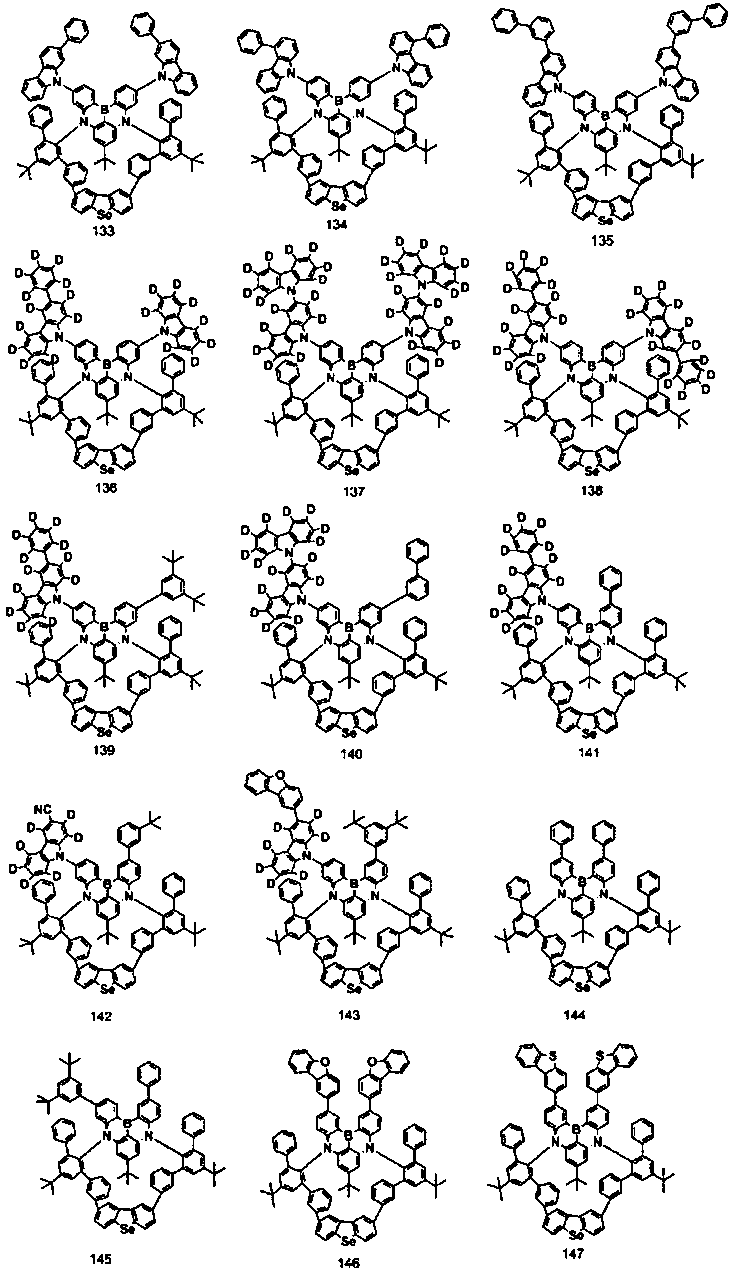 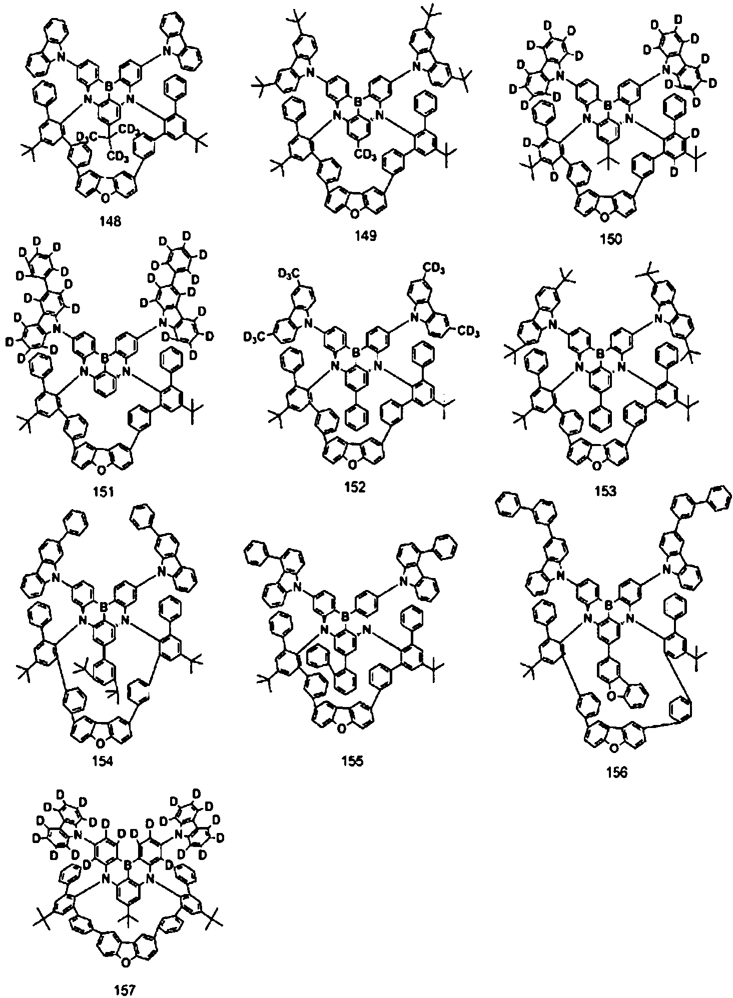 und
wobei in der Verbindungsgruppe 1 D ein Deuteriumatom darstellt.

8. Verwendung einer polyzyklischen Verbindung nach einem der Ansprüche 1 bis 7 als verzögert fluoreszierendes Dotierungsmittel.

9. Lichtemittierendes Element, umfassend:
eine erste Elektrode;
eine zweite Elektrode auf der ersten Elektrode; und
eine Emissionsschicht zwischen der ersten Elektrode und der zweiten Elektrode, die eine erste Verbindung nach einem der Ansprüche 1 bis 7 umfasst.

10. Lichtemittierendes Element nach Anspruch 9, wobei die Emissionsschicht ferner mindestens eine Verbindung ausgewählt aus einer zweiten Verbindung, dargestellt durch Formel HT-1, oder einer dritten Verbindung, dargestellt durch Formel ET-1, umfasst, 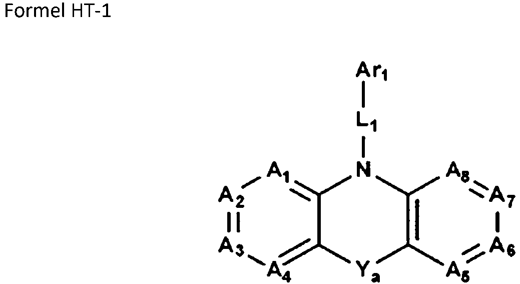
wobei in Formel HT-1,
A₁ bis A₈ jeweils unabhängig N oder CR₅₁ sind,
L₁ eine direkte Verknüpfung, eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen ist,
Yₐ eine direkte Verknüpfung, CR₅₂R₅₃ oder SiR₅₄R₅₅ ist,
Ar₁ eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen ist, und
R₅₁ bis R₅₅ jeweils unabhängig voneinander ein Wasserstoffatom, ein Deuteriumatom, ein Halogenatom, eine Cyanogruppe, eine substituierte oder unsubstituierte Silylgruppe, eine substituierte oder unsubstituierte Thiogruppe, eine substituierte oder unsubstituierte Oxygruppe, eine substituierte oder unsubstituierte Aminogruppe, eine substituierte oder unsubstituierte Borgruppe, eine substituierte oder unsubstituierte Alkylgruppe mit 1 bis 20 Kohlenstoffatomen, eine substituierte oder unsubstituierte Alkenylgruppe mit 2 bis 20 ringbildenden Kohlenstoffatomen, eine substituierte oder unsubstituierte Arylgruppe mit 6 bis 60 ringbildenden Kohlenstoffatomen oder eine substituierte oder unsubstituierte Heteroarylgruppe mit 2 bis 60 ringbildenden Kohlenstoffatomen und/oder mit einer benachbarten Gruppe zu einem Ring verbunden sind, und 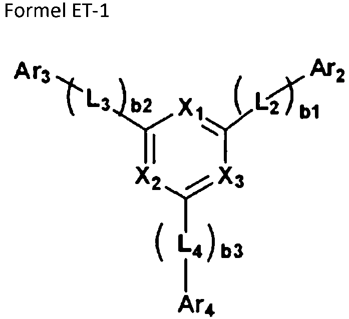 und
wobei in Formel ET-1,
X₁ bis X₃ jeweils N oder CR₅₆ sind und mindestens eines ausgewählt aus den Elementen X₁ bis X₃ N ist,
R₅₆ ein Wasserstoffatom, ein Deuteriumatom, eine substituierte oder unsubstituierte Alkylgruppe mit 1 bis 20 Kohlenstoffatomen, eine substituierte oder unsubstituierte Arylgruppe mit 6 bis 60 ringbildenden Kohlenstoffatomen oder eine substituierte oder unsubstituierte Heteroarylgruppe mit 2 bis 60 ringbildenden Kohlenstoffatomen ist,
b1 bis b3 jeweils unabhängig voneinander ganze Zahlen von 0 bis 10 sind,
Ar₂ bis Ar₄ jeweils unabhängig voneinander ein Wasserstoffatom, ein Deuteriumatom, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind, und
L₂ bis L₄ jeweils unabhängig voneinander eine direkte Verknüpfung, eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen sind.

11. Lichtemittierendes Element nach Anspruch 10, wobei die Emissionsschicht ferner eine vierte Verbindung, dargestellt durch Formel D-1, umfasst, 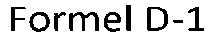 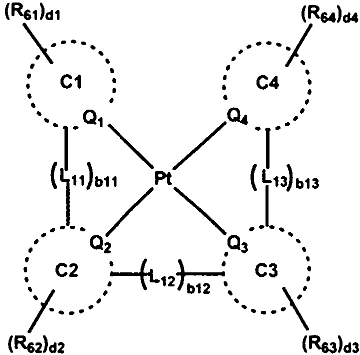 und
wobei in Formel D-1,
Q₁ bis Q₄ jeweils unabhängig voneinander C oder N sind,
C1 bis C4 jeweils unabhängig voneinander ein substituierter oder unsubstituierter Kohlenwasserstoffring mit 5 bis 30 ringbildenden Kohlenstoffatomen oder ein substituierter oder unsubstituierter Heteroring mit 2 bis 30 ringbildenden Kohlenstoffatomen sind,
L₁₁ bis L₁₃ jeweils unabhängig voneinander eine direkte Verknüpfung, *-o-*, *-s-*, 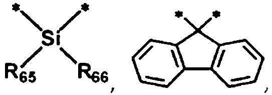
eine substituierte oder unsubstituierte zweiwertige Alkylgruppe mit 1 bis 20 Kohlenstoffatomen, eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen sind,
b11 bis b13 jeweils unabhängig voneinander 0 oder 1 sind,
R₆₁ bis R₆₆ jeweils unabhängig voneinander ein Wasserstoffatom, ein Deuteriumatom, ein Halogenatom, eine Cyanogruppe, eine substituierte oder unsubstituierte Silylgruppe, eine substituierte oder unsubstituierte Thiogruppe, eine substituierte oder unsubstituierte Oxygruppe, eine substituierte oder unsubstituierte Aminogruppe, eine substituierte oder unsubstituierte Borgruppe, eine substituierte oder unsubstituierte Alkylgruppe mit 1 bis 20 Kohlenstoffatomen, eine substituierte oder unsubstituierte Alkenylgruppe mit 2 bis 20 ringbildenden Kohlenstoffatomen, eine substituierte oder unsubstituierte Arylgruppe mit 6 bis 60 ringbildenden Kohlenstoffatomen oder eine substituierte oder unsubstituierte Heteroarylgruppe mit 2 bis 60 ringbildenden Kohlenstoffatomen sind, und
d1 bis d4 jeweils unabhängig voneinander ganze Zahlen von 0 bis 4 sind.

12. Lichtemittierendes Element nach Anspruch 11, wobei die Emissionsschicht die erste Verbindung, die zweite Verbindung, die dritte Verbindung und die vierte Verbindung umfasst.

13. Lichtemittierendes Element nach einem der Ansprüche 9 bis 12, wobei:
(i) die Emissionsschicht so konfiguriert ist, dass sie verzögerte Fluoreszenz emittiert; und/oder
(ii) die Emissionsschicht so konfiguriert ist, dass sie blaues Licht emittiert.

14. Anzeigevorrichtung, umfassend:
eine Basisschicht;
eine Schaltungsschicht auf der Basisschicht; und
eine Anzeigeelementschicht auf der Schaltungsschicht und ein lichtemittierendes Element umfassend,
wobei das lichtemittierende Element eine erste Elektrode, eine zweite Elektrode, die der ersten Elektrode zugewandt ist, und eine Emissionsschicht zwischen der ersten Elektrode und der zweiten Elektrode umfasst, die eine polyzyklische Verbindung nach einem der Ansprüche 1 bis 8 umfasst.

15. Anzeigevorrichtung nach Anspruch 14, wobei:
(i) das lichtemittierende Element so konfiguriert ist, dass es blaues Licht emittiert; und/oder
(ii) die Anzeigevorrichtung ferner eine Lichtsteuerungsschicht mit einem Quantenpunkt umfasst.

## Revendications

1. Composé polycyclique représenté par la formule 1, 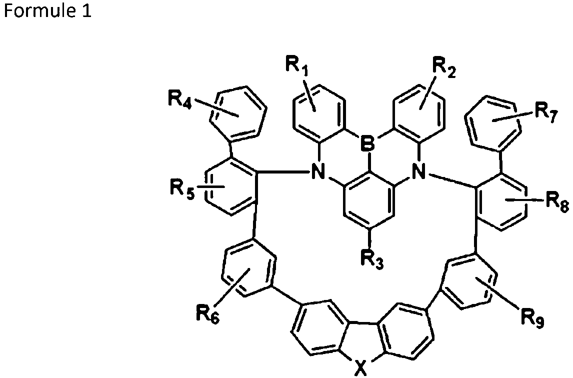
dans lequel, dans la formule 1,
X est O, S, Se, NRₐ, ou CR_{b}R_{c},
R₁ à R₉ représentent chacun indépendamment un atome d'hydrogène, un atome de deutérium, un atome d'halogène, un groupe cyano, un groupe alkyle substitué ou non substitué présentant de 1 à 10 atomes de carbone, un groupe alcényle substitué ou non substitué présentant de 2 à 10 atomes de carbone, un groupe oxy substitué ou non substitué, un groupe thio substitué ou non substitué, un groupe aryle substitué ou non substitué présentant de 6 à 30 atomes de carbone formant un cycle, ou un groupe hétéroaryle substitué ou non substitué présentant de 3 à 30 atomes de carbone formant un cycle et/ou lié à un groupe adjacent pour former un cycle, et
Rₐ à R_{c} représentent chacun indépendamment un atome d'hydrogène, un atome de deutérium, un atome d'halogène, un groupe alkyle substitué ou non substitué présentant de 1 à 10 atomes de carbone, un groupe alcényle substitué ou non substitué présentant de 2 à 10 atomes de carbone, un groupe oxy substitué ou non substitué, un groupe thio substitué ou non substitué, un groupe aryle substitué ou non substitué présentant de 6 à 30 atomes de carbone formant un cycle, ou un groupe hétéroaryle substitué ou non substitué présentant de 3 à 30 atomes de carbone formant un cycle.

2. Composé polycyclique selon la revendication 1, dans lequel au moins un groupe choisi parmi R₁ ou R₂ de la formule 1 représente un groupe aryle substitué ou non substitué présentant de 6 à 30 atomes de carbone formant **un** cycle, ou **un** groupe hétéroaryle substitué ou non substitué présentant de 3 à 30 atomes de carbone formant **un** cycle.

3. Composé polycyclique selon la revendication 1, dans lequel R₁ et R₂ de la formule 1 représentent chacun indépendamment **un** groupe aryle substitué ou non substitué présentant de 6 à 20 atomes de carbone formant **un** cycle, ou **un** groupe hétéroaryle substitué ou non substitué présentant de 6 à 30 atomes de carbone formant **un** cycle.

4. Composé polycyclique selon l'une quelconque des revendications 1 à 3, dans lequel au moins **un** des atomes d'hydrogène du composé est substitué par **un** atome de deutérium.

5. Composé polycyclique selon l'une quelconque des revendications 1 à 4, dans lequel R₃ de la formule 1 représente **un** atome d'hydrogène, **un** groupe alkyle substitué ou non substitué présentant de 1 à 10 atomes de carbone, **un** groupe aryle substitué ou non substitué présentant de 6 à 20 atomes de carbone formant **un** cycle, ou **un** groupe hétéroaryle substitué ou non substitué présentant de 6 à 30 atomes de carbone formant **un** cycle.

6. Composé polycyclique selon l'une quelconque des revendications 1 à 5, dans lequel la formule 1 est représentée par l'une quelconque des formules choisies parmi les formules 1-1 à 1-4, 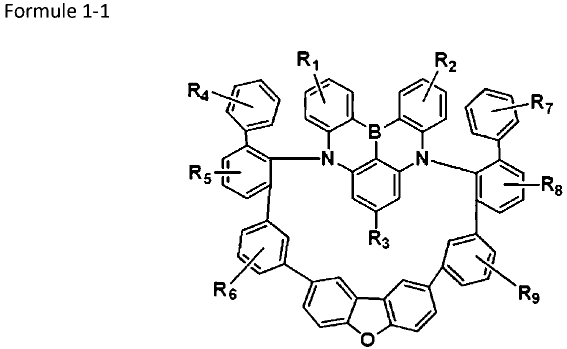 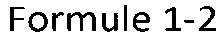 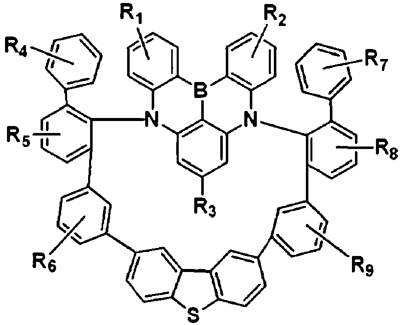 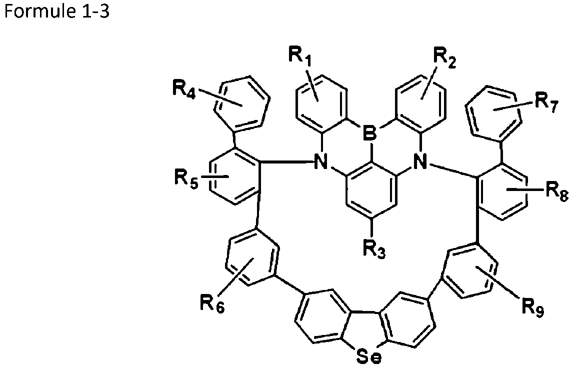 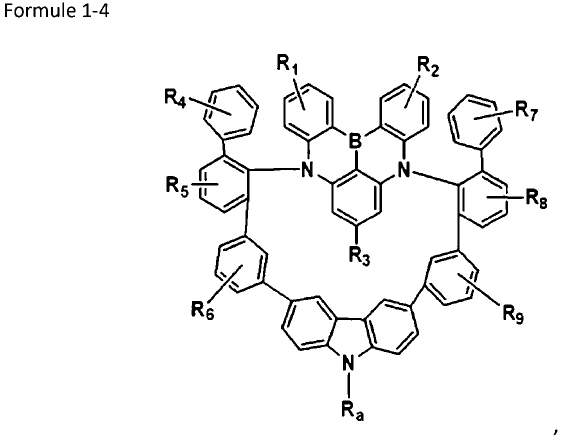 et
dans lequel, dans la formule 1-1 à la formule 1-4, R₁ à R₉et Rₐ sont tels que définis dans la formule 1.

7. Composé polycyclique selon la revendication 1, dans lequel la formule 1 est représentée par l'un quelconque des composés du groupe de composés 1, 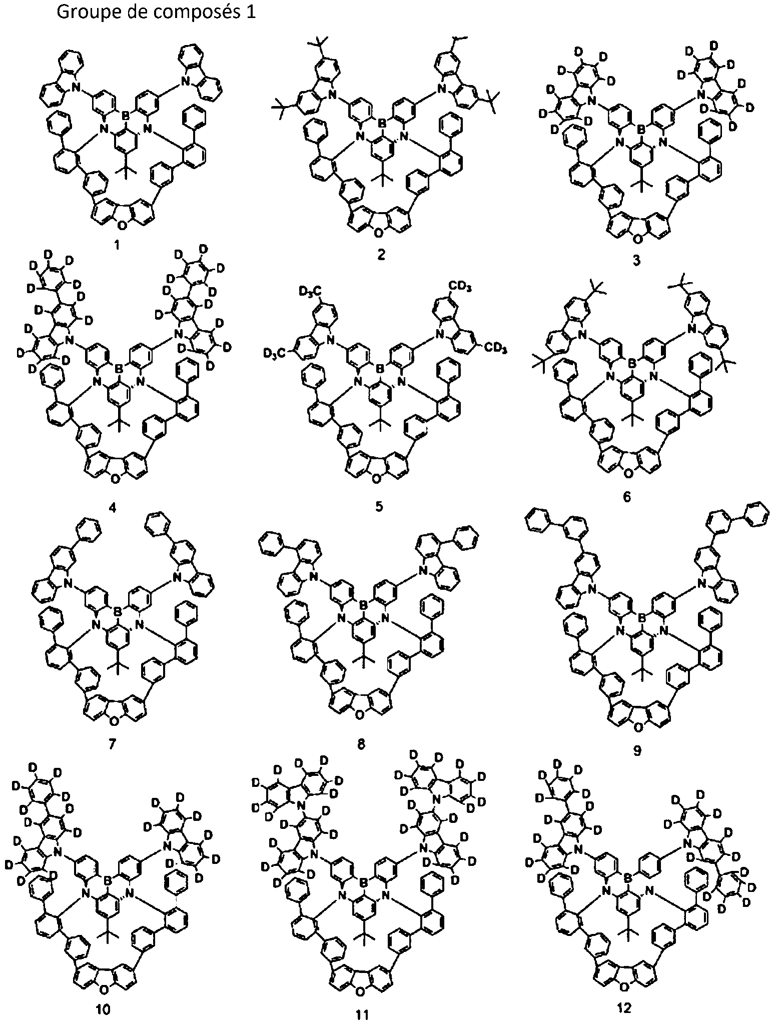 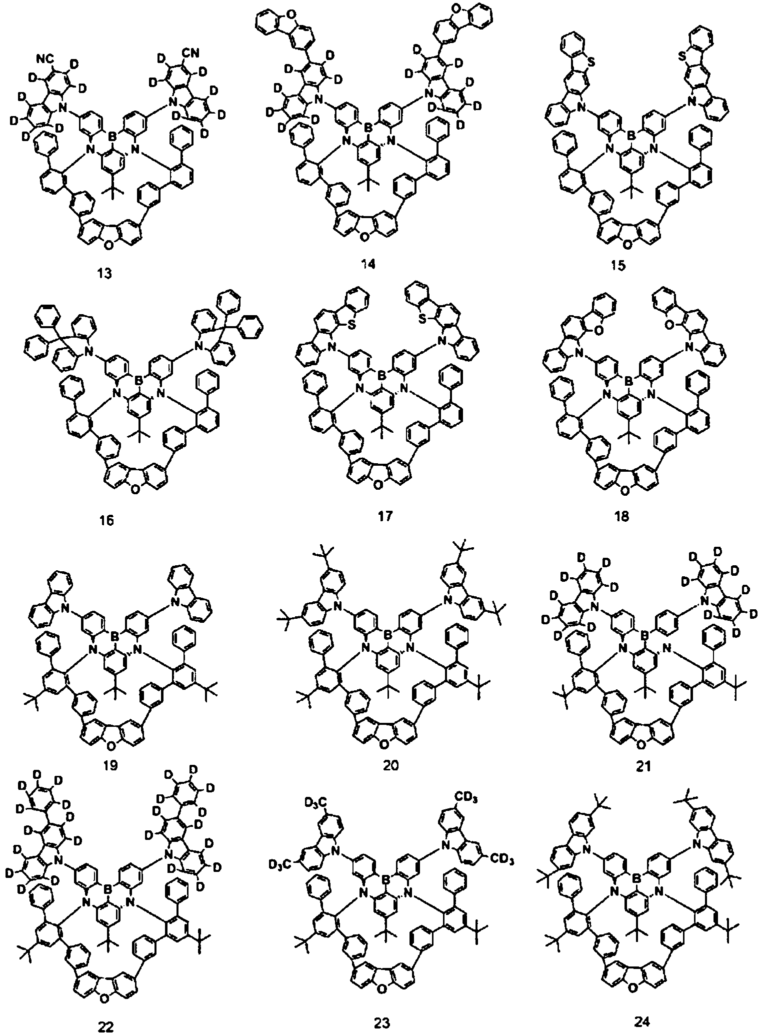 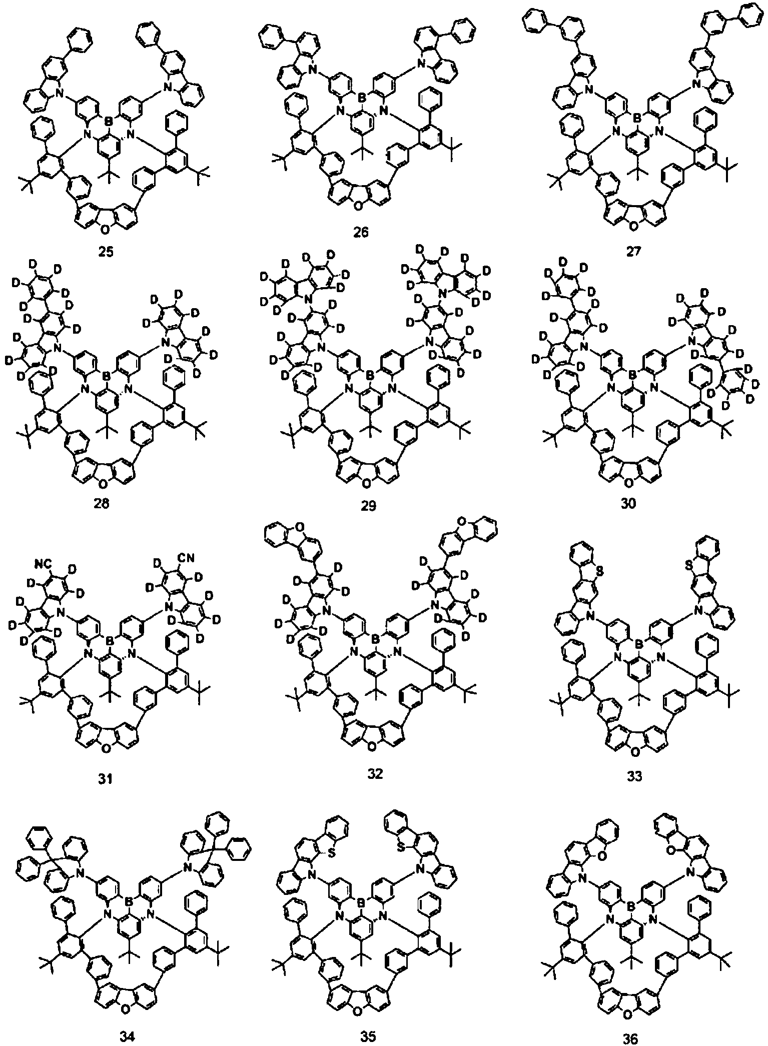 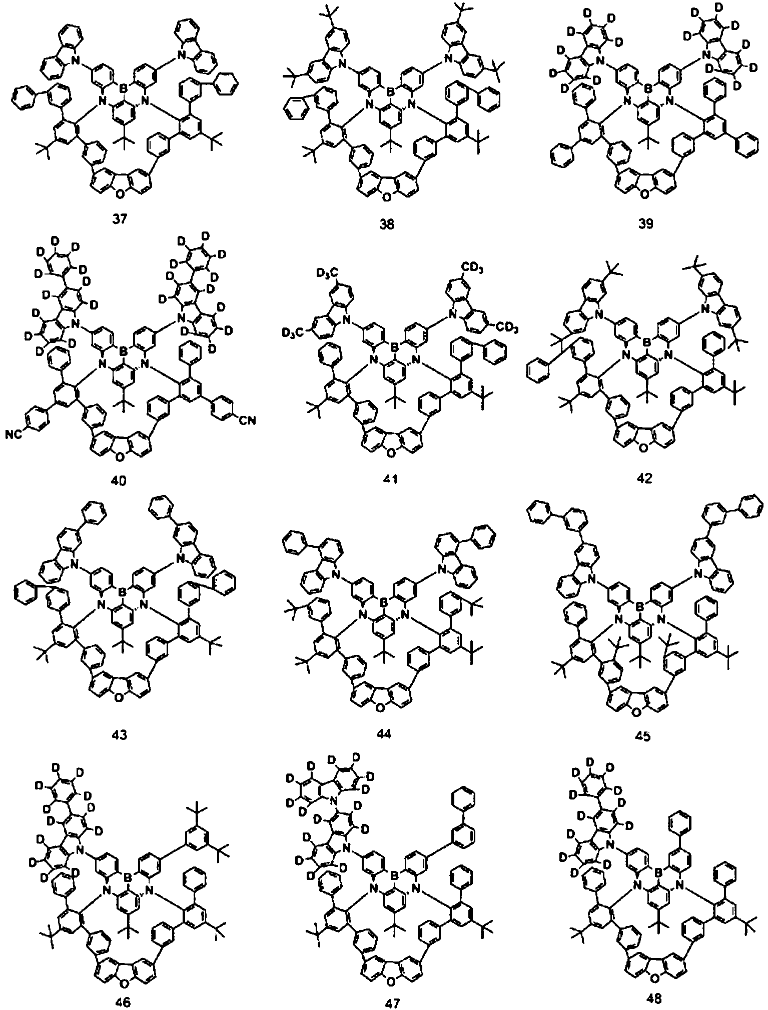 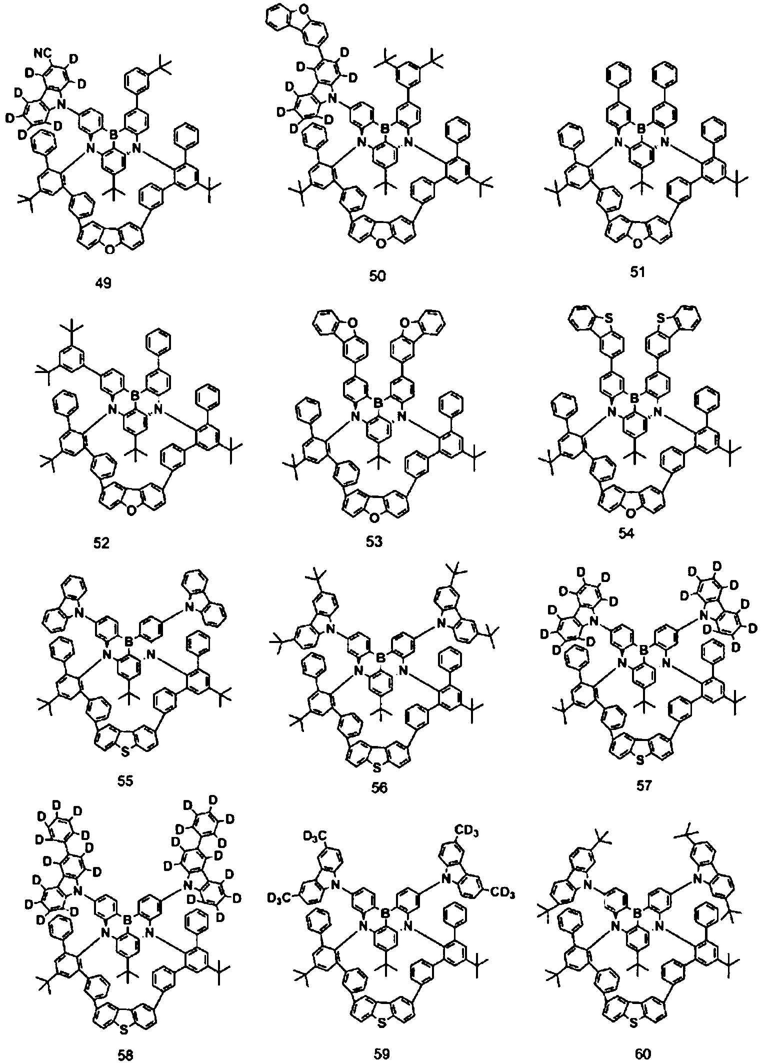 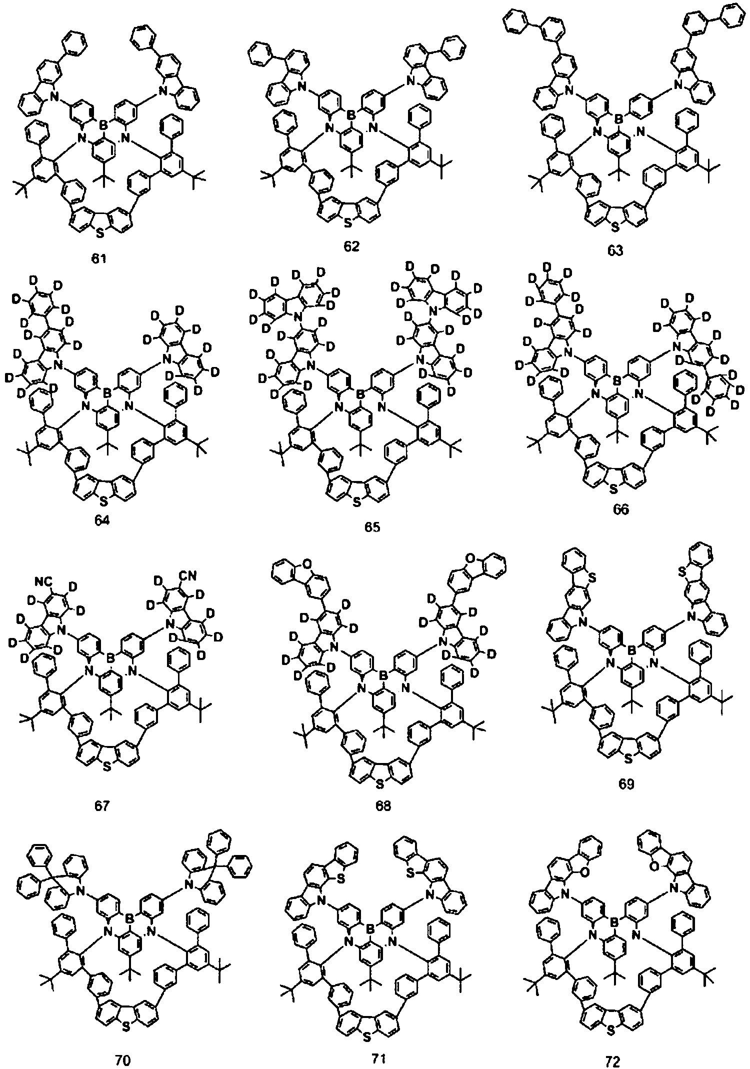 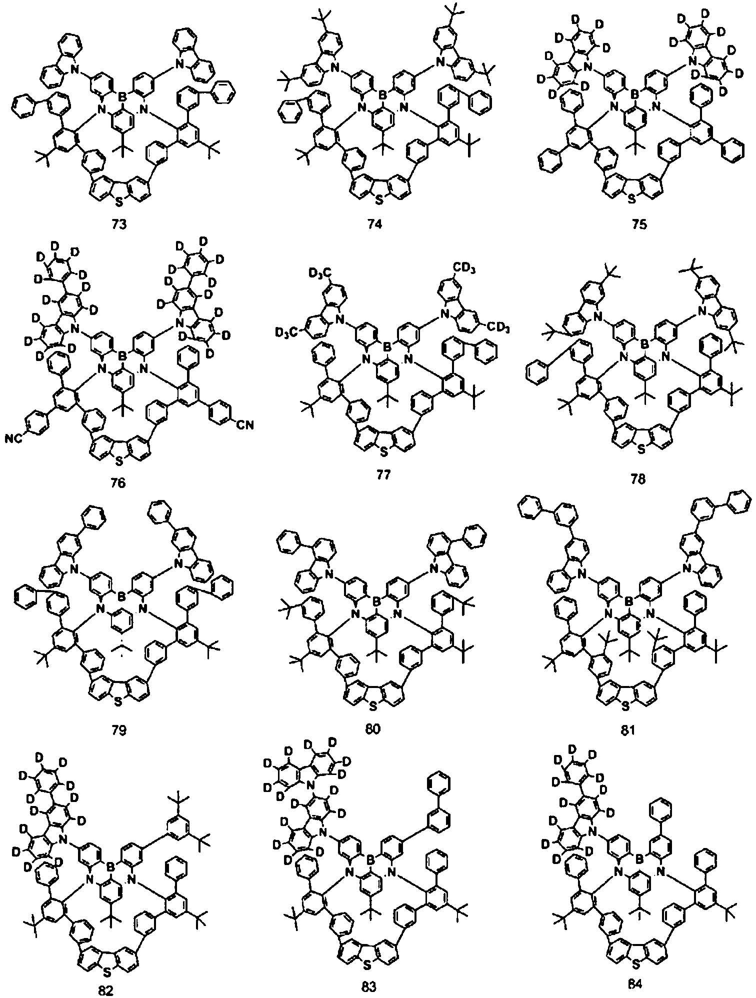 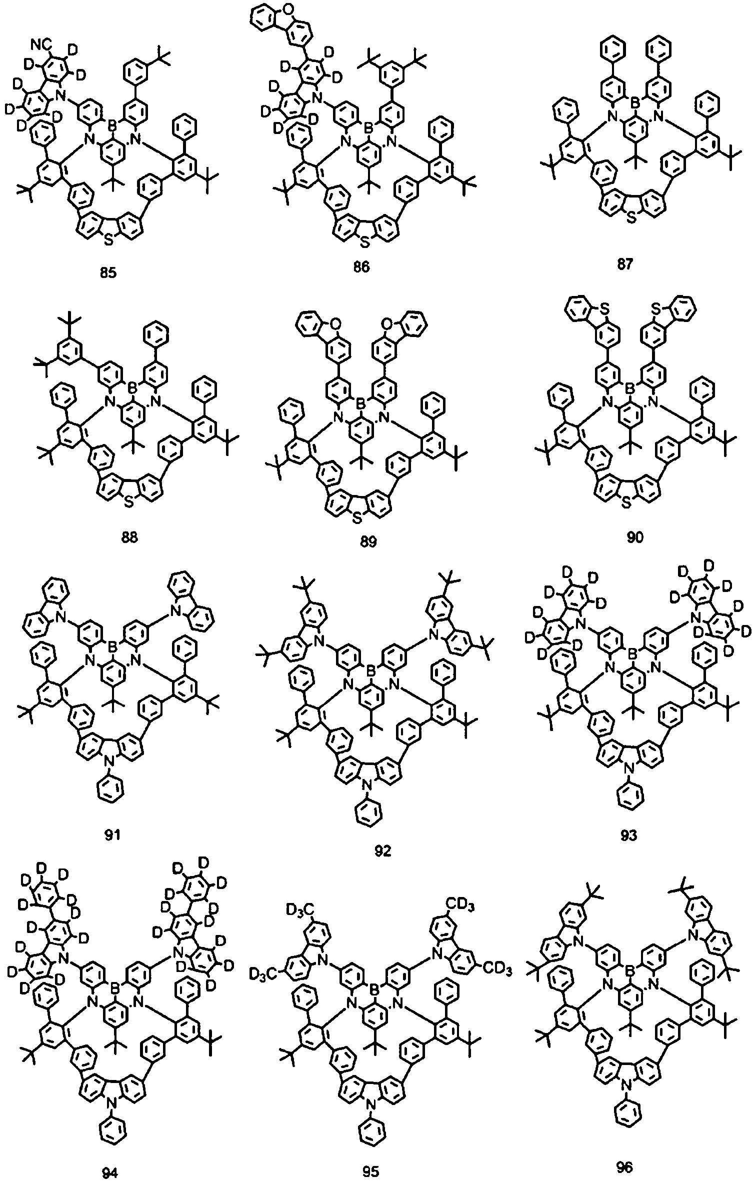 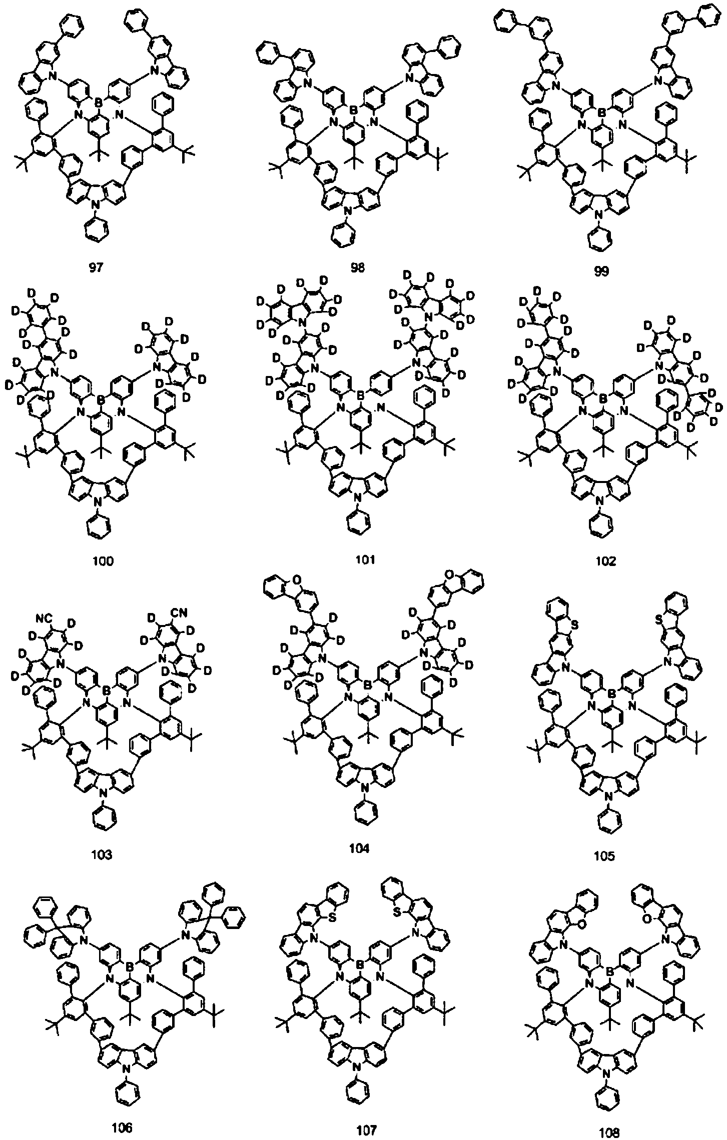 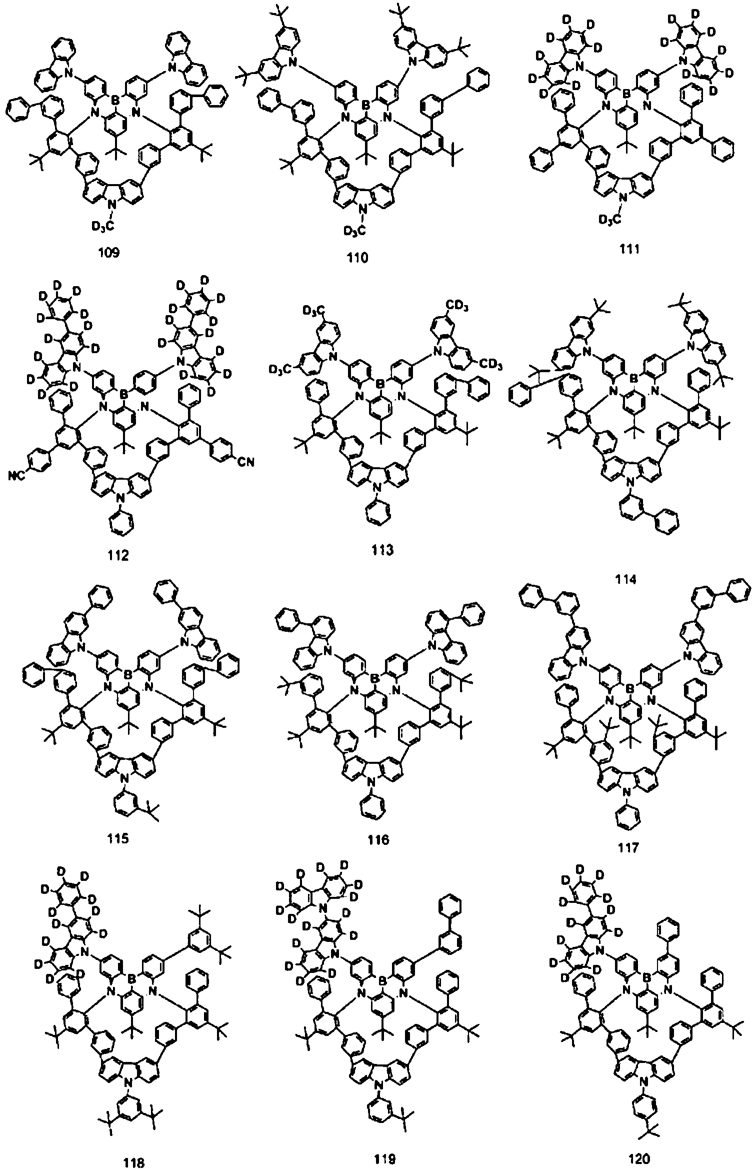 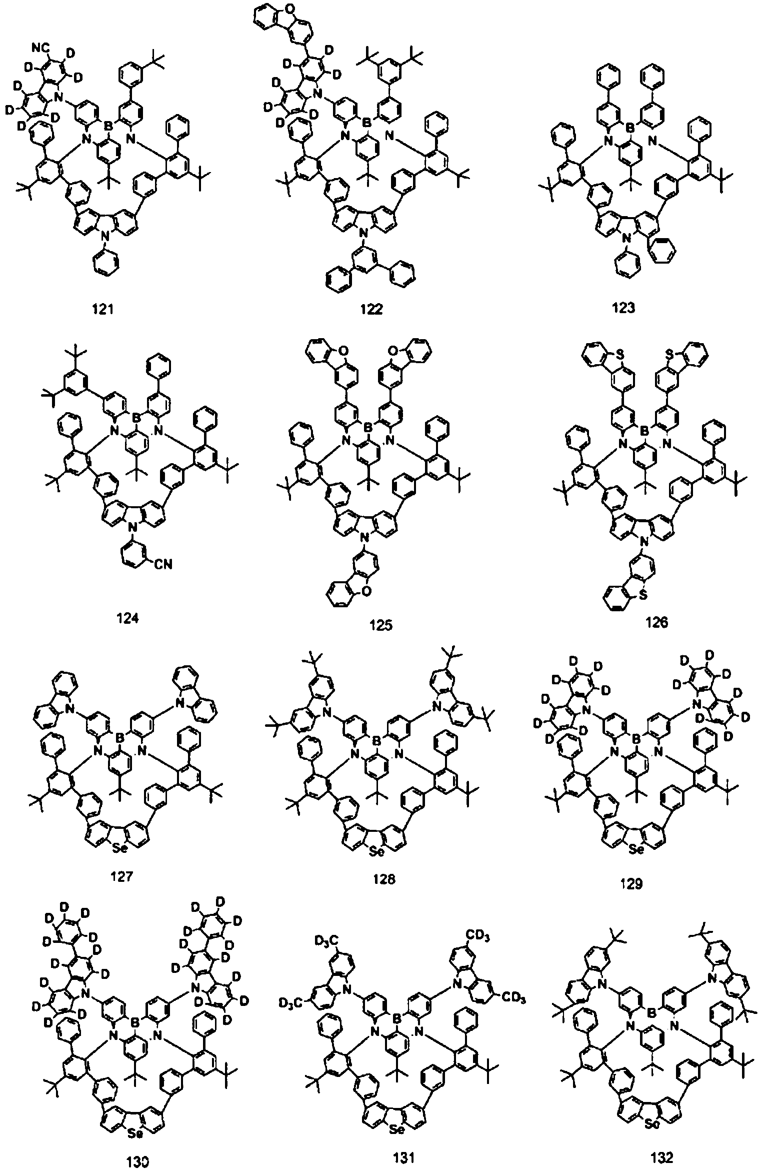 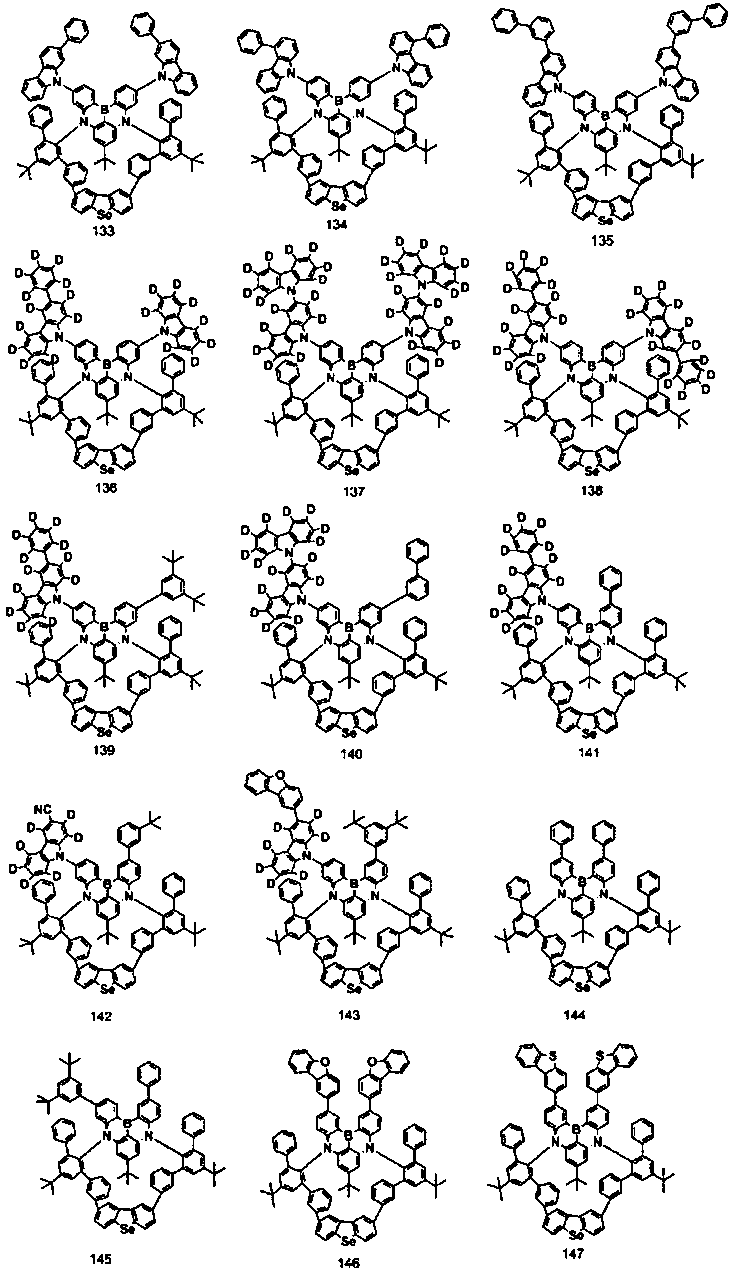 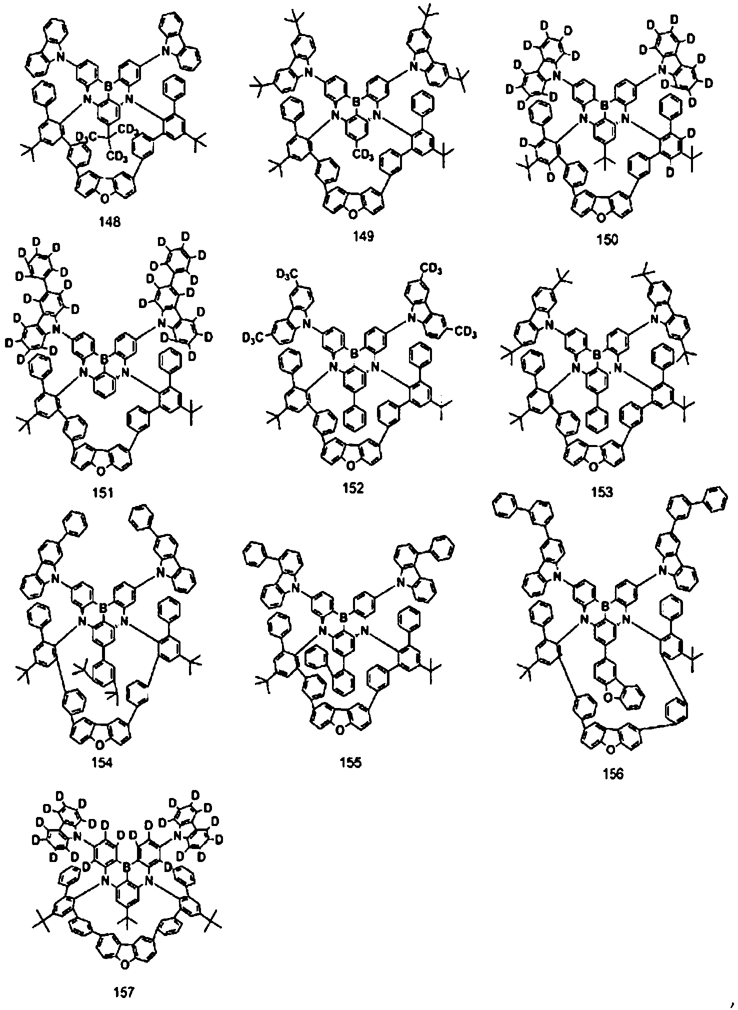 et
dans lequel, dans le groupe de composés 1, D représente un atome de deutérium.

8. Utilisation d'un composé polycyclique selon l'une quelconque des revendications 1 à 7 comme dopant fluorescent retardé.

9. Élément électroluminescent comprenant :
une première électrode ;
une seconde électrode sur la première électrode ; et
une couche d'émission entre la première électrode et la seconde électrode, et comprenant un premier composé selon l'une quelconque des revendications 1 à 7.

10. Élément électroluminescent selon la revendication 9, dans lequel la couche d'émission comprend en outre au moins un composé choisi parmi un deuxième composé représenté par la formule HT-1 ou un troisième composé représenté par la formule ET-1, 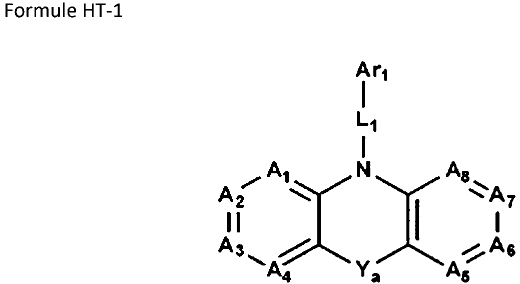
dans lequel, dans la formule HT-1,
A₁ à A₈ représentent chacun indépendamment N ou CR₅₁,
L₁ est une liaison directe, un groupe arylène substitué ou non substitué présentant de 6 à 30 atomes de carbone formant un cycle, ou un groupe hétéroarylène substitué ou non substitué présentant de 2 à 30 atomes de carbone formant un cycle.
Yₐ est une liaison directe, CR₅₂R₅₃, ou SiR₅₄R₅₅,
Ar₁ représente un groupe aryle substitué ou non substitué présentant de 6 à 30 atomes de carbone formant un cycle, ou un groupe hétéroaryle substitué ou non substitué présentant de 2 à 30 atomes de carbone formant un cycle, et
R₅₁ à R₅₅ représentent chacun indépendamment un atome d'hydrogène, un atome de deutérium, un atome d'halogène, un groupe cyano, un groupe silyle substitué ou non substitué, un groupe thio substitué ou non substitué, un groupe oxy substitué ou non substitué, un groupe amine substitué ou non substitué, un groupe bore substitué ou non substitué, un groupe alkyle substitué ou non substitué présentant de 1 à 20 atomes de carbone, un groupe alcényle substitué ou non substitué présentant de 2 à 20 atomes de carbone formant un cycle, un groupe aryle substitué ou non substitué présentant de 6 à 60 atomes de carbone formant un cycle, ou un groupe hétéroaryle substitué ou non substitué présentant de 2 à 60 atomes de carbone formant un cycle et/ou sont liés à un groupe adjacent pour former un cycle, et 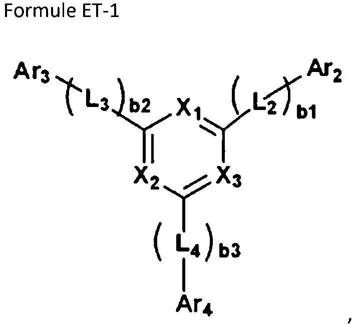 et
dans lequel, dans la Formule ET-1,
X₁ à X₃ représentent chacun N ou CR₅₆ et au moins un choisi parmi X₁ à X₃ est N, R₅₆ représente un atome d'hydrogène, un atome de deutérium, un groupe alkyle substitué ou non substitué présentant de 1 à 20 atomes de carbone, un groupe aryle substitué ou non substitué présentant de 6 à 60 atomes de carbone formant un cycle, ou un groupe hétéroaryle substitué ou non substitué présentant de 2 à 60 atomes de carbone formant un cycle,
b1 à b3 représentent chacun indépendamment un entier de 0 à 10,
Ar₂ à Ar₄ représentent chacun indépendamment un atome d'hydrogène, un atome de deutérium, un groupe alkyle substitué ou non substitué présentant de 1 à 20 atomes de carbone, un groupe aryle substitué ou non substitué présentant de 6 à 30 atomes de carbone formant un cycle, ou un groupe hétéroaryle substitué ou non substitué présentant de 2 à 30 atomes de carbone formant un cycle, et
L₂ à L₄ représentent chacun indépendamment une liaison directe, un groupe arylène substitué ou non substitué présentant de 6 à 30 atomes de carbone formant un cycle, ou un groupe hétéroarylène substitué ou non substitué présentant de 2 à 30 atomes de carbone formant un cycle.

11. Élément électroluminescent selon la revendication 10, dans lequel la couche d'émission comprend en outre un quatrième composé représenté par la formule D-1, 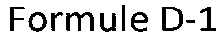 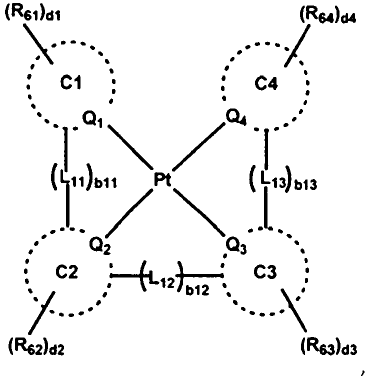 et
dans lequel, dans la formule D-1,
Q₁ à Q₄ représentent chacune indépendamment C ou N,
C1 à C4 représentent chacun indépendamment un cycle hydrocarboné substitué ou non substitué présentant de 5 à 30 atomes de carbone formant un cycle, ou un hétérocycle substitué ou non substitué présentant de 2 à 30 atomes de carbone formant un cycle,
L₁₁ à L₁₃ représentent chacun indépendamment une liaison directe, *-o-*, *-s-* 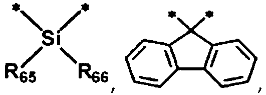
un groupe alkyle divalent substitué ou non substitué présentant de 1 à 20 atomes de carbone, un groupe arylène substitué ou non substitué présentant de 6 à 30 atomes de carbone formant un cycle, ou un groupe hétéroarylène substitué ou non substitué présentant de 2 à 30 atomes de carbone formant un cycle,
b11 à b13 représentent chacun indépendamment 0 ou 1,
R₆₁ à R₆₆ représentent chacun indépendamment un atome d'hydrogène, un atome de deutérium, un atome d'halogène, un groupe cyano, un groupe silyle substitué ou non substitué, un groupe thio substitué ou non substitué, un groupe oxy substitué ou non substitué, un groupe amine substitué ou non substitué, un groupe bore substitué ou non substitué, un groupe alkyle substitué ou non substitué présentant de 1 à 20 atomes de carbone, un groupe alcényle substitué ou non substitué présentant de 2 à 20 atomes de carbone formant un cycle, un groupe aryle substitué ou non substitué présentant de 6 à 60 atomes de carbone formant un cycle, ou un groupe hétéroaryle substitué ou non substitué présentant de 2 à 60 atomes de carbone formant un cycle, et
d1 à d4 représentent chacun indépendamment un entier de 0 à 4.

12. Élément électroluminescent selon la revendication 11, dans lequel la couche d'émission comprend le premier composé, le deuxième composé, le troisième composé et le quatrième composé.

13. Élément électroluminescent selon l'une quelconque des revendications 9 à 12, dans lequel :
(i) la couche d'émission est configurée pour émettre une fluorescence retardée ; et/ou
(ii) la couche d'émission est configurée pour émettre de la lumière de couleur bleue.

14. Dispositif d'affichage, comprenant :
une couche de base ;
une couche de circuit sur la couche de base ; et
une couche d'élément d'affichage sur la couche de circuit et comprenant un élément électroluminescent,
dans lequel l'élément électroluminescent comprend une première électrode, une seconde électrode faisant face à la première électrode et une couche d'émission entre la première électrode et la seconde électrode et comprenant un composé polycyclique selon l'une quelconque des revendications 1 à 8.

15. Dispositif d'affichage selon la revendication 14, dans lequel :
(i) l'élément électroluminescent est configuré pour émettre une lumière de couleur bleue ; et/ou
(ii) le dispositif d'affichage comprend en outre une couche de commande de la lumière comprenant un point quantique.
